(19) Europäisches Patentamt
European Patent Office
Office européen des brevets

(11) EP 3 346 515 A1

(12) **EUROPEAN PATENT APPLICATION**
published in accordance with Art. 153(4) EPC

(43) Date of publication:
**11.07.2018 Bulletin 2018/28**

(21) Application number: **16841973.7**

(22) Date of filing: **01.09.2016**

(51) Int Cl.:
***H01L 51/30*** *(2006.01)* ***H01L 21/336*** *(2006.01)*
***H01L 29/786*** *(2006.01)* ***H01L 51/05*** *(2006.01)*
***H01L 51/40*** *(2006.01)*

(86) International application number:
**PCT/JP2016/075700**

(87) International publication number:
**WO 2017/038944 (09.03.2017 Gazette 2017/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.09.2015 JP 2015173260**
**16.03.2016 JP 2016052511**

(71) Applicant: **FUJI-FILM Corporation**
**Minato-ku**
**Tokyo 106-8620 (JP)**

(72) Inventors:
- **YAMAMOTO Yosuke**
**Ashigara-kami-gun**
**Kanagawa 258-8577 (JP)**
- **TAKIZAWA Hiroo**
**Ashigara-kami-gun**
**Kanagawa 258-8577 (JP)**
- **SHIGENOI Yuta**
**Ashigara-kami-gun**
**Kanagawa 258-8577 (JP)**
- **TAMAKUNI Fumiko**
**Ashigara-kami-gun**
**Kanagawa 258-8577 (JP)**
- **GOTO Takashi**
**Ashigara-kami-gun**
**Kanagawa 258-8577 (JP)**
- **WATANABE Tetsuya**
**Ashigara-kami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(54) **ORGANIC THIN-FILM TRANSISTOR, ORGANIC THIN-FILM TRANSISTOR MANUFACTURING METHOD, ORGANIC SEMICONDUCTOR COMPOSITION, ORGANIC SEMICONDUCTOR FILM, AND ORGANIC SEMICONDUCTOR FILM MANUFACTURING METHOD**

(57) An object of the present invention is to provide an organic thin film transistor exhibiting high carrier mobility and a low threshold voltage and having excellent heat resistance, a method of manufacturing an organic thin film transistor, an organic semiconductor composition, an organic semiconductor film, and a method of manufacturing an organic semiconductor film. The organic thin film transistor according to the present invention includes, on a substrate, a gate electrode; an organic semiconductor layer containing an organic semiconductor compound; a gate insulating layer provided between the gate electrode and the organic semiconductor layer; and a source electrode and a drain electrode which are provided to be in contact with the organic semiconductor layer and are connected to each other via the organic semiconductor layer, in which the organic semiconductor layer is in contact with a block copolymer layer containing a block copolymer or further contains the block copolymer, and in which the organic semiconductor compound has a molecular weight of 2,000 or greater and has a repeating unit represented by Formula (1).

$$-\!\!(D\text{-}A)\!\!- \quad (1)$$

EP 3 346 515 A1

## Description

## BACKGROUND OF THE INVENTION

1. Field of the Invention

The present invention relates to an organic thin film transistor, a method of manufacturing an organic thin film transistor, an organic semiconductor composition, an organic semiconductor film, and a method of manufacturing an organic semiconductor film.

2. Description of the Related Art

Since light weight, low cost, and flexibility can be obtained, an organic thin film transistor (organic TFT) having an organic semiconductor film (organic semiconductor layer) is used in a device using a logic circuit such as a field effect transistor (FET), a radio frequency identifier (RFID: RF tag), and a memory used in a liquid crystal display or an organic electro luminescence (EL) display.

As a compound for forming such an organic semiconductor film, it is known that a polymer (so-called a "D-A-type polymer") obtained by combining an electron donating (donor) unit and an electron accepting (acceptor) unit is useful.

As specific examples of the D-A-type polymer, JP2014-237733A discloses a compound obtained by introducing an aryl group to a side chain of a repeating unit (see Example 14 of JP2014-237733A).

## SUMMARY OF THE INVENTION

Recently, in view of improving the performance of the organic thin film transistor, further improvement of the carrier mobility and further reduction of threshold voltage of the organic thin film transistor are required.

In a case where the organic thin film transistor is manufactured, an organic semiconductor layer included in an organic thin film transistor is disposed at a high temperature, and thus it is required that the heat resistance of the organic thin film transistor is excellent. Here, the expression "the heat resistance of the organic thin film transistor is excellent" means that changes of the carrier mobility and the threshold voltage of the organic thin film transistor are small before and after the heating of the organic thin film transistor.

An object of the present invention is to provide an organic thin film transistor exhibiting high carrier mobility and a low threshold voltage and having excellent heat resistance, a method of manufacturing an organic thin film transistor, an organic semiconductor composition, an organic semiconductor film, and a method of manufacturing an organic semiconductor film.

As a result of intensive studies on the above problems, the present inventors have found that a desired effect can be obtained by using an organic thin film transistor having an organic semiconductor layer including an organic semiconductor compound represented by Formula (1) and a block copolymer layer including a block copolymer or an organic thin film transistor having an organic semiconductor layer including an organic semiconductor compound represented by Formula (1) and a block copolymer, so as to conceive the present invention.

That is, the present inventors have found that the aforementioned objects can be achieved with the following configurations.

[1] An organic thin film transistor comprising, on a substrate: a gate electrode; an organic semiconductor layer containing an organic semiconductor compound; a gate insulating layer provided between the gate electrode and the organic semiconductor layer; and a source electrode and a drain electrode which are provided to be in contact with the organic semiconductor layer and are connected to each other via the organic semiconductor,
in which the organic semiconductor layer is in contact with a block copolymer layer containing a block copolymer or further contains the block copolymer, and
in which the organic semiconductor compound has a molecular weight of 2,000 or greater and has a repeating unit represented by Formula (1),
[2] The organic thin film transistor according to [1], in which the organic thin film transistor has a bottom gate structure, and the block copolymer layer is provided between the gate insulating layer and the organic semiconductor layer.
[3] The organic thin film transistor according to [1], in which the organic thin film transistor has a bottom gate structure, and the gate insulating layer includes the block copolymer layer.
[4] The organic thin film transistor according to [2], in which the organic thin film transistor has a bottom gate structure, and the gate insulating layer includes a random polymer having the same monomer component as the monomer component forming the block copolymer, as a structural component.
[5] The organic thin film transistor according to [4], in which the random polymer in the gate insulating layer has a

crosslinking structure.

[6] The organic thin film transistor according to [1], in which the organic thin film transistor has a top gate structure, and the block copolymer layer is provided on the substrate.

[7] The organic thin film transistor according to [1], [2], or [6], in which a base material layer is provided on an opposite side to a side of the block copolymer layer on which the organic semiconductor layer is provided.

[8] The organic thin film transistor according to [7], in which the base material layer includes a random polymer having the same monomer component as the monomer component forming the block copolymer, as a structural component.

[9] The organic thin film transistor according to [8], in which the random polymer in the base material layer has a crosslinking structure.

[10] The organic thin film transistor according to any one of [1] to [9], in which the block copolymer is at least one block copolymer selected from a styrene-(meth)acrylic acid ester block copolymer, a styrene-(meth)acrylic acid block copolymer, a styrene-dialkylsiloxane block copolymer, a styrene-alkylarylsiloxane block copolymer, a styrene-diarylsiloxane block copolymer, a (meth)acrylic acid ester-cage silsesquioxane-substituted alkyl (meth)acrylate block copolymer, a styrene-vinyl pyridine block copolymer, a styrene-hydroxystyrene block copolymer, a styrene-ethylene oxide block copolymer, and a vinyl naphthalene-(meth)acrylic acid ester block copolymer.

[11] The organic thin film transistor according to any one of [1] to [10], in which a surface energy of the block polymer is 30 $mNm^{-1}$ or less.

[12] The organic thin film transistor according to anyone of [1] to [11], in which the block copolymer has a block including a repeating unit represented by Formula (I) and a block including a repeating unit represented by Formula (II) or has a block including a repeating unit represented by Formula (I) and a block including a repeating unit represented by Formula (III).

[13] The organic thin film transistor according to [12], in which an absolute value of a difference between a solubility parameter of the repeating unit represented by Formula (I) and a solubility parameter of the repeating unit represented by Formula (II) or an absolute value of a difference between a solubility parameter of the repeating unit represented by Formula (I) and a solubility parameter of the repeating unit represented by Formula (III) is 0.5 to 4.0 $MPa^{1/2}$.

[14] The organic thin film transistor according to any one of [1] to [13], in which the block copolymer includes a crosslinkable group-containing monomer component, and the block copolymer in the block copolymer layer forms a crosslinking structure.

[15] The organic thin film transistor according to any one of [1] to [14], in which A in Formula (1) has at least one structure selected from the group consisting of structures represented by Formulae (A-1) to (A-12), as a partial structure.

[16] The organic thin film transistor according to any one of [1] to [15], in which D in Formula (1) has a structure represented by Formula (D-1).

[17] The organic thin film transistor according to any one of [1] to [16], in which the repeating unit represented by Formula (1) is a repeating unit represented by any one of Formulae (2) to (5).

[18] A method of manufacturing the organic thin film transistor according to any one of [1] to [17], the method comprising:

a step of applying a mixed solution containing the organic semiconductor compound and the block copolymer.

[19] The method of manufacturing the organic thin film transistor according to [18], in which, in the step of applying the mixed solution, the mixed solution is applied to the gate insulating layer having a surface energy of 50 to 75 $mNm^{-1}$.

[20] An organic semiconductor composition, comprising: an organic semiconductor compound which has a molecular weight of 2,000 or greater and which is represented by Formula (1); and a block copolymer.

[21] An organic semiconductor film comprising: an organic semiconductor compound which has a molecular weight of 2,000 or greater and is represented by Formula (1); and a block copolymer.

[22] A method of manufacturing the organic semiconductor film according to [21], the method comprising:

a step of applying a mixture containing the organic semiconductor compound and the block copolymer to a gate insulating layer having a surface energy of 50 to 75 $mNm^{-1}$, so as to obtain an organic semiconductor film.

As described above, according to the present invention, it is possible to provide an organic thin film transistor exhibiting high carrier mobility and a low threshold voltage and having excellent heat resistance, a method of manufacturing an organic thin film transistor, an organic semiconductor composition, an organic semiconductor film, and a method of manufacturing an organic semiconductor film.

## BRIEF DESCRIPTION OF THE DRAWINGS

Fig. 1A is a diagram schematically illustrating a bottom gate-bottom contact-type organic thin film transistor according to one embodiment of an organic thin film transistor of the present invention.

Fig. 1B is a diagram schematically illustrating a bottom gate-top contact-type organic thin film transistor according to one embodiment of the organic thin film transistor of the present invention.

Fig. 1C is a diagram schematically illustrating a top gate-bottom contact-type organic thin film transistor according to one embodiment of the organic thin film transistor of the present invention.

Fig. ID is a diagram schematically illustrating a top gate-top contact-type organic thin film transistor according to one embodiment of the organic thin film transistor of the present invention.

Fig. 2E is a diagram schematically illustrating an example of a case where an organic semiconductor layer in the organic thin film transistor of the present invention contains a specific organic semiconductor compound and a block copolymer.

Fig. 2F is a diagram schematically illustrating an example of a case where an organic semiconductor layer in the organic thin film transistor of the present invention contains a specific organic semiconductor compound and a block copolymer.

## DESCRIPTION OF THE PREFERRED EMBODIMENTS

Hereinafter, the present invention is described below. The following description of configuration requirement is based on a representative embodiment according to the present invention, but the present invention is not limited to such an embodiment.

In the present specification, the definition of the compound is used in the meaning of including salts thereof and ions thereof, in addition to the compound itself.

In the present specification, in a case where a plurality of substituents, linking groups, or the like (hereinafter, referred to as "substituents or the like) represented by a specific reference numeral exist, or in a case where a plurality of substituents or the like are defined at the same time, the respective substituents or the like may be identical to or different from each other. The same is also applied to the definition of the number of substituents or the like.

Unless described otherwise, in a case where a plurality of substituents or the like are close to each other (particularly, adjacent to each other), this means that the substituents or the like are linked to each other or fused to each other to form a ring.

In the present specification, substituents or the like in which substitution and unsubstitution are not defined mean the substituents or the like may further have a substituent without deteriorating the desired effect. The same is applied to a compound in which substitution and unsubstitution are not defined.

In the present specification, the numerical range expressed by using "to" means a range including numerical values described before and after "to" as a lower limit value and an upper limit value.

[Organic thin film transistor and manufacturing method thereof]

The organic thin film transistor of the present invention is an organic thin film transistor having a gate electrode, an organic semiconductor layer containing an organic semiconductor compound, a gate insulating layer provided between the gate electrode and the organic semiconductor layer, and a source electrode and a drain electrode which are provided to be in contact with the organic semiconductor layer and are connected to each other via an organic semiconductor layer, on a substrate. The organic semiconductor layer is in contact with a block copolymer layer containing a block copolymer or further contains the block copolymer. The organic semiconductor compound has a molecular weight of 2,000 or greater and has a repeating unit represented by Formula (1).

The organic semiconductor layer including the organic semiconductor compound (hereinafter, simply referred to as a "specific organic semiconductor compound") which has a molecular weight of 2,000 or greater and a repeating unit represented by Formula (1) is in contact with the block copolymer layer or contains a block copolymer, and thus it is possible to obtain an organic thin film transistor exhibiting high carrier mobility and a low threshold voltage and having excellent heat resistance.

Details of the reason have not been still clarified, the following reasons are assumed.

The specific organic semiconductor compound has a main chain skeleton formed of an electron donor unit and an electron acceptor unit, a so-called D-A-type polymer. The D-A-type polymer exhibits excellent alignment properties in a case of being crystallized, and thus the organic thin film transistor including the organic semiconductor layer formed by using this has a tendency of exhibiting high carrier mobility and low threshold voltage.

In a case where the D-A-type polymer is used, even in a case where there is a defect in the organic semiconductor layer obtained by heating this, the organic semiconductor layer is hardly influenced by the defect, compared with a low-molecule type organic semiconductor compound. The organic thin film transistor having an organic semiconductor layer including a D-A-type polymer can suppress decrease of the carrier mobility and a change of the threshold voltage before

and after heating, and there is a tendency of exhibiting satisfactory heat resistance.

The present inventors have diligently conducted research so as to improve the performance of the organic thin film transistor and have found that, in a case where the block copolymer is used, the carrier mobility and the threshold voltage of the organic thin film transistor having an organic semiconductor layer including a specific organic semiconductor compound became more excellent. The present inventors have also found that, even after the heating test, the decrease of the carrier mobility and the change of the threshold voltage of the organic thin film transistor are further suppressed.

It is assumed that, this is because the block copolymer further improves alignment properties of the specific organic semiconductor compound.

Hereinafter, the organic thin film transistor of the present invention (hereinafter, simply referred to as the "OTFT of the present invention") is described.

The OTFT of the present invention has a gate electrode, an organic semiconductor layer, a gate insulating layer provided between the gate electrode and the organic semiconductor layer, and a source electrode and a drain electrode which are provided to be in contact with the organic semiconductor layer and are connected to each other via an organic semiconductor layer, on a substrate. In a case where the voltage is applied to the gate electrode, a current flow path (channel) is formed at the interface between the organic semiconductor layer between the source electrode and the drain electrode and an adjacent layer. The current flowing between the source electrode and the drain electrode is controlled according to the input voltage applied to the gate electrode.

A preferable structure of the OTFT of the present invention is described based on the drawings. The OTFT illustrated in the respective drawings are schematic views for easier understanding of the present invention, and sizes or relative size relationships of respective members may be changed for the convenience of the descriptions, and drawings do not illustrate the actual relationships. Other than matters defined in the present invention, the present invention is not limited to appearances or shape illustrated in these drawings. For example, in Figs. 1A and 1B, the gate electrode does not have to cover the entire substrate, and a form in which the gate electrode covers a central portion of the substrate is also preferable as a form of the OTFT of the present invention.

Each of Figs. 1A to ID is a longitudinal sectional view schematically illustrating a representative preferable structure of the OTFT of the present invention. In Figs. 1A to 1D, 1 denotes an organic semiconductor layer, 2 denotes a gate insulating layer, 3 denotes a source electrode, 4 denotes a drain electrode, 5 denotes a gate electrode, and 6 denotes a substrate.

Fig. 1A illustrates a bottom gate-bottom contact-type OTFT, Fig. 1B illustrates a bottom gate-top contact-type OTFT, Fig. 1C illustrates a top gate-bottom contact-type OTFT, and Fig. 1D illustrates a top gate-top contact-type OTFT.

The OTFT of the present invention includes all of the above four forms. Though not illustrated in the drawings, an overcoat layer may be formed on the uppermost portion of each drawing of the OTFT (on an opposite side to the substrate 6).

In the bottom gate structure, the gate electrode 5, the gate insulating layer 2 and the organic semiconductor layer 1 are arranged on the substrate 6, in this order. Meanwhile, in the top gate structure, the organic semiconductor layer 1, the gate insulating layer 2 and the gate electrode 5 are arranged on the substrate 6, in this order.

In the bottom contact structure, the source electrode 3 and the drain electrode 4 are arranged on the substrate 6 side (that is, the lower sides in Figs. 1A to 1D) to the organic semiconductor layer 1. In the top contact structure, the source electrode 3 and the drain electrode 4 are arranged on the opposite side of the substrate 6 with respect to the organic semiconductor layer 1.

In the OTFT of the present invention, the organic semiconductor layer 1 is provided to be in contact with a block copolymer layer including a block copolymer (not illustrated) or further contains a block copolymer.

In a case where the organic semiconductor layer 1 contains a specific organic semiconductor compound and a block copolymer.

Figs. 2E and 2F are schematic views illustrating structures of the OTFT in a case where the organic semiconductor layer contains a specific organic semiconductor compound and a block copolymer. In Figs. 2E and 2F, in the bottom gate-bottom contact-type OTFT which is the same as in Fig. 1A, the specific organic semiconductor compound and the block copolymer are included in the organic semiconductor layer 1.

In the examples of Figs. 2E and 2F, a case where the OTFT is a bottom gate-bottom contact type is illustrated, but the present invention is not limited thereto, and the OTFT may have any forms of a bottom gate-top contact type, a top gate-bottom contact type, and a top gate-top contact type.

In a case where the organic semiconductor layer contains a specific organic semiconductor compound and a block copolymer, it is preferable that the specific organic semiconductor compound and the block copolymer are unevenly distributed to each other in the thickness direction of the organic semiconductor layer. As an example of this uneven distribution state, schematic enlarged views in circles of Figs. 2E and 2F can be referred to. Specifically, in the circles of Figs. 2E and 2F, schematic enlarged views of the organic semiconductor layer 1 schematically illustrating an unevenly distributed state of the specific organic semiconductor compound and the block copolymer are illustrated. In this case, the organic semiconductor layer 1 has an area 1A having a large content of the block copolymer and an area 1B having

a high content of the specific organic semiconductor compound. Each of the area 1A and the area 1B may exist near the surface of at least of the organic semiconductor layer 1, and do not have to exist over the entire organic semiconductor layer 1. As illustrated with broken lines of Figs. 2E and 2F, an interface between the area 1A and the area 1B may not be clearly determined.

The OTFT of Fig. 2E and the OTFT of Fig. 2F have the same structure except that the lamination layer relationship of the area 1A and the area 1B is reversed.

Here, the expression "uneven distribution" refers to a state having a phase in which a component of any one of the specific organic semiconductor compound and the block copolymer is greater than an overall mass ratio, but the other component also exists.

In order to unevenly distribute the specific organic semiconductor compound and the block copolymer, for example, a method to be performed by using a mixed solution (described below) containing a specific organic semiconductor compound and a block copolymer is used.

Subsequently, a case where the organic semiconductor layer 1 is provided to be in contact with a block copolymer layer including a block copolymer (not illustrated) is described.

In a case where the organic semiconductor layer 1 is provided to be in contact with the block copolymer layer, a state in which the specific organic semiconductor compound and the block copolymer are phase-separated is also included.

The expression "phase separation" means a state of having a phase in which any one of the specific organic semiconductor compound and the block copolymer singly exists.

Here, the uneven distribution and the phase separation have a different degree of the mass ratios of the components, and in a case where the degree of the uneven distribution becomes higher, the state becomes phase separation. A boundary thereof is not particularly clearly defined academically, but in a case where a phase in which any one of the specific organic semiconductor compound and the block copolymer exist in a mass ratio of 99% or greater is formed, it is determined that the case is determined as a "phase separation" state according to the present invention.

In order to cause the organic semiconductor layer and the block copolymer layer to be in a phase separated state, examples thereof include a method of separately forming respective layers, and a method of using a mixed solution containing the specific organic semiconductor compound and the block copolymer, in the same manner as the uneven distribution.

In the organic semiconductor layer, whether the block copolymer is unevenly distributed or phase-separated can be checked by subjecting the organic semiconductor layer to element mapping measurement by time-of-flight secondary ion analysis (TOF-SIMS) together with the use of an etching ion beam.

The following surface energy is measured, whether the surface energy is closer to which one of the values of the specific organic semiconductor compound and the block copolymer is checked, so as to infer which one exists more on the surface of the organic semiconductor layer.

The surface energy can be obtained by a well-known method, by measuring a contact angle of a film consisting of a block copolymer in both water and an organic solvent (glycerin and diiodomethane are mainly used) and substituting the contact angle to the Owens's equation (the following refers to a case where glycerin (gly) is used in an organic solvent). The surface energy of each component of the block polymer can be estimated by measuring a surface energy of a film of a homopolymer of each component.

$$1+\cos\theta_{H2O}=2(\gamma_S{}^{d})^{1/2}(\gamma_{H2O}{}^{d})^{1/2}/\gamma_{H2O,V}+2(\gamma_S{}^{h})^{1/2}(\gamma_{H2O}{}^{h})^{1/2}/\gamma_{H2O,V}$$

$$1+\cos\theta_{gly}=2(\gamma_S{}^{d})^{1/2}(\gamma_{gly}{}^{d})^{1/2}/\gamma_{gly,V}+2(\gamma_S{}^{h})^{1/2}(\gamma_{gly}{}^{h})^{1/2}/\gamma_{gly,V}$$

Here, in a case where the document measurement values of $\gamma_{H2O}{}^{d}$=21.8, $\gamma_{gly}{}^{d}$=37.0, $\gamma_{H2O}{}^{h}$=51.0, $\gamma_{gly}{}^{h}$=26.4, $\gamma_{H2O,V}$=72.8, and $\gamma_{gly,V}$=63.4 are substituted, and a measured value of the contact angle of water at $\theta_{H2O}$, a measured value of the contact angle of glycerin at $\theta_{gly}$ are substituted, a dispersion force component $\gamma_S{}^{d}$ and a polar component $\gamma_S{}^{d}$ of a surface energy are respectively obtained, and thus the sum thereof $y_S{}^{Vh}=\gamma_S{}^{d}+\gamma_S{}^{h}$ can be obtained as a surface energy ($mNm^{-1}$).

Since it is easy to cause the block copolymer and the specific organic semiconductor compound to be unevenly distributed or to be phase-separated, the surface energy of the block copolymer is preferably 30 $mNm^{-1}$ or less, more preferably 1 to 30 $mNm^{-1}$, even more preferably 5 to 27 $mNm^{-1}$, and particularly preferably 10 to 25 $mNm^{-1}$.

As the surface energy of the block copolymer is smaller, the uneven distribution or the phase separation with the specific organic semiconductor compound is quickly performed. Meanwhile, since the coatability of the coating liquid (mixed solution) for forming the organic semiconductor layer and the film properties of the formed organic semiconductor layer are excellent, the lower limit of the surface energy of the block copolymer is preferably the following value.

In the organic semiconductor layer, a form in which the specific organic semiconductor compound is unevenly distributed is preferably a thickness direction of the organic semiconductor layer. Any one of the specific organic semiconductor compound or the block copolymer may be unevenly distributed in the thickness direction (depth direction, direction of the substrate 6) of the organic semiconductor layer.

It is preferable that, in the organic semiconductor layer, the specific organic semiconductor compound is unevenly distributed on the gate insulating layer side, and the block copolymer is unevenly distributed on an opposite side of the gate insulating layer. It is possible to secure a sufficient charge transfer channel on the interface between the gate insulating layer and the organic semiconductor layer, and high carrier mobility is exhibited.

At this point, the OTFT of the present invention can have a bottom gate structure in which an organic semiconductor layer is provided on the gate insulating layer and a top gate structure in which a gate insulating layer is provided on an organic semiconductor layer.

In a case of the bottom gate structure, a bottom contact structure in which the source electrode and the drain electrode are provided to be in contact with the lower surface of the organic semiconductor layer is preferable. In a case of the top gate structure, a top contact structure in which the source electrode and the drain electrode are provided to be in contact with the upper surface of the organic semiconductor layer is preferable. Accordingly, carriers are easily injected from the source electrode to the organic semiconductor layer, and the injected carriers easily flow to the drain electrode, so as to decrease the threshold voltage.

Particularly, the OTFT of the present invention has a bottom gate-bottom contact structure, a charge movement channel is secured in the organic semiconductor layer, an area of the organic semiconductor layer in which the specific organic semiconductor compound is unevenly distributed is protected by the block copolymer, such that carrier mobility and the effect of improving the maintenance rate (durability) of the carrier mobility can be further increased. The effect of decreasing the threshold voltage is more excellent.

It is preferable that the block copolymer included in the organic semiconductor layer or the block copolymer layer is phase-separated, that is, the block copolymer is phase-separated. The expression "the block copolymer is phase-separated" indicates the block copolymer autonomously makes an ordered structure by the self-assemblage of the block copolymer, and examples thereof include a block copolymer obtained by microphase separation. The microphase separation refers to a phenomenon in which a block copolymer forms a microscopic phase separation by several nm to hundreds nm, preferably several nm to several tens nm, due to difference of properties of respective blocks forming this. The structure of the block copolymer is described below.

In this manner, the crystallization of the specific organic semiconductor compound is promoted due to the phase separation of the block copolymer, and thus it is possible to obtain an excellent organic thin film transistor by the carrier mobility and the threshold voltage. The heat resistance of the organic thin film transistor also tends to increase.

In the present specification, a layer obtained by microphase-separating a block copolymer is called a "microphase separation layer" in some cases.

In the organic semiconductor layer, whether a block copolymer is phase-separated can be checked in the same manner as the method of checking uneven distribution in the thickness direction of the organic semiconductor layer.

In a case where the block copolymer is phase-separated in the organic semiconductor layer 1, the specific organic semiconductor compound is unevenly distributed easily according to a phase formed by each block of the block copolymer, and thus, the separation (unevenly distribution) between the block copolymer and the specific organic semiconductor compound is promoted and encouraged.

Accordingly, in a case where the block copolymer is phase-separated, the specific organic semiconductor compound preferably forms a different layer by being unevenly distributed in a phase (one phase obtained by microphase separation of the block copolymer) formed by a block having higher affinity among phases formed by respective blocks of the block copolymer or being unevenly distributed between this phase and the gate insulating layer, that is, by being phase-separated with the block copolymer. Examples of the different layer include a layer including a specific organic semiconductor compound that comes into contact with one phase obtained by microphase separation of the block copolymer. In this manner, it is preferable that the block copolymer is phase-separated and the specific organic semiconductor compound is unevenly distributed or layer-separated. The carrier mobility and the improvement of the durability are increased, and an excellent effect of decreasing the threshold voltage is exhibited.

In a case where the OTFT of the present invention has a bottom gate structure, examples of the OTFT of the present invention include a form (a) in which the block copolymer layer is provided on the gate insulating layer 2, and the organic semiconductor layer is directly on this block copolymer layer, or a form (b) in which the gate insulating layer 2 is formed of a block copolymer layer, and the organic semiconductor layer is directly provided on this block copolymer layer, and is more preferably the form (a).

Form (a) in which block copolymer layer is provided on gate insulating layer 2, and organic semiconductor layer is directly on this block copolymer layer:

In the case of (a) above, the block copolymer layer may be directly provided on the gate insulating layer 2, or the base material layer may be provided on the gate insulating layer 2, such that the block copolymer layer is provided to be in

contact with this base material layer.

The base material layer preferably includes a random polymer (hereinafter, referred to as a "random polymer A") having the same monomer component as the monomer component forming the block copolymer that forms the block copolymer layer thereon, as a structural component, and it is more preferable that the base material layer is formed of the random polymer A.

The molar ratio of each monomer component of the random polymer A may be identical to or different from the molar ratio of the monomer component in the corresponding block copolymer.

In a case where the block copolymer layer is provided directly on the gate insulating layer 2, the gate insulating layer 2 preferably includes a random polymer (hereinafter, referred to as a "random polymer B") including the same monomer component as the monomer component forming the block copolymer that forms the block copolymer layer thereon, as a structural component, and it is more preferable that the gate insulating layer 2 is formed of the random polymer B. The molar ratio of each monomer component of the random polymer B may be identical to or different from the molar ratio of the monomer component in the corresponding block copolymer.

In a case where the random polymers A and B have crosslinkable groups such as an epoxy group or an oxetane group as described below, it is preferable that a bridging structure is formed by heating the random polymers A and B in presence of an acid catalyst (for example, a thermal acid generator such as diphenyliodonium hexafluorophosphate) or a curing agent (a compound having two or more active hydrogens such as diamine, a dicarboxylic acid, and bisphenol). In a case where the random polymers A and B have crosslinking structures, the solvent resistance increases. Therefore, even in a case where the block copolymer layer is formed by dissolving the block copolymer in the solvent, applying this to a layer including the random polymer A or B and forming a film, the layer including the random polymer A or B hardly influenced by the solvent, the manufacturing efficiency or the performance stability of the OTFT is further improved.

In a case where the random polymers A and B have crosslinking structures, in the random polymers A and B, an amount of the crosslinkable group-containing monomer component is preferably 1 to 20 mol% and more preferably 1 to 10 mol% with respect to the molar amount of the entire monomer component.

Form (b) in which gate insulating layer 2 is formed of block copolymer layer, and organic semiconductor layer is directly provided on this block copolymer layer:

It is preferable that the layer thickness of the block copolymer layer is a thickness in which the microphase separation occurs, and specifically the layer thickness is preferably 10 to 250 nm, more preferably 20 to 200 nm, and even more preferably 20 to 100 nm. In a case where the base material layer is provided, the layer thickness of the base material layer is preferably 5 to 2,000 nm and more preferably 10 to 1,000 nm.

In a case where the block copolymer layer is microphase-separated and the microphase separation is lamellar phase separation, the pitch of the lamellar phase separation is preferably 5 nm to 100 nm, more preferably 10 to 50 nm, and even more preferably 10 to 20 nm. The smaller the pitch of the lamellar phase separation is, the higher the crystallinity of the specific organic semiconductor compound provided thereon becomes. Crystal alignment properties can also be enhanced.

In a case where the OTFT of the present invention has a top gate structure, a block copolymer layer (not illustrated) is provided on the substrate 6, and organic semiconductor layer is directly on this block copolymer layer. In this case, the block copolymer layer may be directly provided on the substrate 6, and a base material layer may be provided on the substrate 6 such that the block copolymer layer is provided to be in contact with this base material layer.

The base material layer preferably includes a random polymer (hereinafter, referred to as a "random polymer C") having the same monomer component as the monomer component forming the block copolymer that forms the block copolymer layer thereon, as a structural component, and it is more preferable that the base material layer is formed of the random polymer C.

The molar ratio of each monomer component of the random polymer C may be identical to or different from the molar ratio of the monomer component in the corresponding block copolymer.

As described above, it is preferable that the random polymer C has a crosslinkable group such as an epoxy group or an oxetane group. A preferable form of the method of forming the crosslinking structure is the same as described in the random polymers A and B.

The ranges of the weight-average molecular weight and the number-average molecular weight of the random polymer A, B and C are preferably 3,000 to 1,000,000, more preferably 10,000 to 800,000, and even more preferably 20,000 to 600,000.

The block copolymer layer is preferably a layer obtained by lamellar phase separation of the block copolymer. The lamellar phase separation is a form in which the block copolymer is linearly phase-separated along the plane of the layer. The linear shape may be a straight line shape or a curved line shape. In order to obtain a desired lamellar phase separation structure, it is possible to provide a guide pattern on a layer that becomes an underlayer of the block copolymer layer and form a block copolymer layer on a layer provided with the guide pattern. Examples of the method of forming the guide pattern include a rubbing treatment, a lithography method, a photopolymerization method or a photocrosslinking method by polarization or interference exposure, and a photoisomerization method, but the present invention is not

limited thereto. In view of the simplification of the step, it is preferable that the block copolymer layer according to the present invention is provided without providing a guide pattern.

<Block copolymer>

The block copolymer is described below.

Two or more kinds of blocks may form the block copolymer or three or more kinds may form the block copolymer. The plurality of kinds of blocks that form the block copolymer preferably have a combination in which lamellar phase separation occurs. Specifically, a combination between blocks incompatible to each other is preferable. For example, in a case where two kinds of blocks form the block copolymer, an absolute value of the difference of the solubility parameters (SP value) of the two kinds of blocks is preferably 0.5 to 4.0 $MPa^{1/2}$ and more preferably 0.5 to 3.0 $MPa^{1/2}$.

In the present specification, the "solubility parameter (SP value)" can be obtained by the Hansen's method. The Hansen's method is one of the well-known methods for calculating an SP value in the related art, and an SP value is expressed by a multidimensional vector including a dispersion element, a polarity element, and a hydrogen bond element. The Hansen's SP value can be predicted by the method disclosed in Int. J. Thermophys, 2008, 29, pages 568 to 585, and the SP value disclosed in the present specification is a value predicted by the method of this document.

In the present specification, the SP value of the specific block of the block copolymer is an SP value of the repeating unit forming this specific block (in other words, homopolymer only including a specific repeating unit. Here, a crosslinkable group described below may be introduced to a portion of the monomer component). For example, an SP value of a polystyrene repeating unit (styrene unit) is 20.8 $MPa^{1/2}$, an SP value of a repeating unit (methyl methacrylate unit) of polymethyl methacrylate is 20.5 $MPa^{1/2}$, and thus an absolute value of the difference in SP value between blocks of a copolymer obtained by combining two blocks of polystyrene and polymethyl methacrylate becomes 0.3 $MPa^{1/2}$.

In the calculation of the SP value of the specific block, in a case where the specific block has a monomer component having a crosslinkable group, it is considered that there is no monomer unit having this crosslinkable group. That is, in a case where the specific block has a monomer unit having a crosslinkable group, an SP value is calculated by using this specific block as a block including a repeating unit formed of a monomer unit except for a monomer unit having a crosslinkable group.

The mass ratio of each block including the block copolymer is not particularly limited. However, in the block copolymer including two kinds of blocks, a ratio of the number-average molecular weights of respective blocks is preferably 25:75 to 75:25, more preferably 40:60 to 60:40, and even more preferably 45:55 to 55:45. In this manner, it is possible to more securely and more efficiently form a lamellar phase separation structure which is a preferable phase separation form.

In the block copolymer used in the present invention, it is preferable that a crosslinkable group is introduced to a portion of the monomer component forming this block copolymer. The crosslinkable group is not particularly limited, as long as the crosslinking structure is introduced to this block copolymer, and, for example, a group selected from an epoxy group and an oxetane group can be suitably used. In this case, the block copolymer preferably forms a bridging structure by being heated in presence of an acid catalyst (for example, a thermal acid generator such as diphenyliodonium hexafluorophosphate) or a curing agent (a compound having two or more active hydrogens such as diamine, a dicarboxylic acid, and bisphenol). Accordingly, in a case of heating for microphase separation of the block copolymer layer, a crosslinking structure can be formed at the same time.

Since the solvent resistance is increased by causing the block copolymer that forms the block copolymer layer to have a crosslinking structure, in a case where the organic semiconductor layer is formed thereon by coating, the solvent forming the coating solution is hardly influenced, and thus the manufacturing efficiency or the performance stability of the OTFT is increased.

In a case where the block copolymer that forms the block copolymer layer has a crosslinking structure, an amount of the crosslinkable group-containing monomer component is preferably 1 to 20 mol% and more preferably 1 to 10 mol% with respect to a total molar amount of the entire monomer component that forms the block copolymer.

Examples of the block copolymer used in the present invention include a block copolymer obtained by combining a block including a repeating unit having styrene or a styrene derivative as a monomer component and a block including a repeating unit having (meth)acrylic acid ester as a monomer component; a block copolymer obtained by combining a block including a repeating unit having styrene or a styrene derivative as a monomer component and a block including polysiloxane or polysiloxane a derivative; and a block copolymer obtained by combining a block including polyalkylene oxide and a block including a repeating unit having a (meth)acrylic acid ester as a monomer component.

In the present specification, "(meth) acrylic acid" means both of "acrylic acid" and "methacrylic acid".

The (meth)acrylic acid ester which becomes a monomer component of a block copolymer used in the present invention is preferably (meth)acrylic acid alkyl ester. An alkyl group of the (meth)acrylic acid alkyl ester is preferably an alkyl group having 1 to 12 carbon atoms. This alkyl group may have any one of a linear shape, a branched shape, or a cyclic shape.

The alkyl group of (meth)acrylic acid alkyl ester may be substituted with a hydroxyl group, a POSS (cage-type silsesquioxane) group, a halogen atom (preferably a fluorine atom, a chlorine atom, or a bromine atom, and more preferably a fluorine atom), or the like.

Specific examples of the (meth) acrylic acid ester include methyl (meth)acrylate, ethyl (meth)acrylate, propyl (meth)acrylate, cyclohexyl (meth)acrylate, octyl (meth)acrylate, nonyl (meth)acrylate, hydroxyethyl (meth)acrylate, hydroxypropyl (meth)acrylate, benzyl (meth)acrylate, anthracenyl (meth)acrylate, glycidyl (meth)acrylate, 3,4-epoxycyclohexylmethyl (meth)acrylate, and 3-(trimethoxysilyl)propyl (meth)acrylate.

Examples of the substituent in the styrene derivative include a hydroxyl group, a nitro group, an alkyl group, an alkenyl group, an alkynyl group, a cycloalkyl group, an aryl group, aralkyl group, and a halogen atom (preferably a fluorine atom, a chlorine atom, or a bromine atom, and more preferably a fluorine atom). The substituent may be further substituted.

Specific examples of the styrene derivative include 2-methylstyrene, 3-methylstyrene, 4-methylstyrene, 4-t-butylstyrene, 4-n-octylstyrene, 2,4,6-trimethylstyrene, 4-methoxystyrene, 4-t-butoxystyrene, 4-hydroxystyrene, 4-nitrostyrene, 3-nitrostyrene, 4-chlorostyrene, 4-fluorostyrene, 4-acetoxyvinylstyrene, 4-vinylbenzyl chloride, 1-vinylnaphthalene, 4-vinylbiphenyl, 9-vinylanthracene, and $\alpha$-methylstyrene.

Examples of the substituent in the polysiloxane derivative include an alkyl group and an aryl group.

Examples of the polysiloxane derivative include dimethyl polysiloxane, diethyl polysiloxane, diphenyl polysiloxane, and methylphenyl polysiloxane.

Examples of the polyalkylene oxide include polyethylene oxide, polypropylene oxide, polyisopropylene oxide, and polybutylene oxide.

Preferable examples of the block copolymer used in the present invention include block copolymers described below.

A styrene-(meth)acrylic acid ester block copolymer (styrene-(meth)acrylic acid alkyl ester copolymer or a styrene-POSS substituted alkyl(meth)acrylate block copolymer is preferable. The number of carbon atoms of an alkyl group having (meth)acrylic acid alkyl ester and POSS substituted alkyl(meth)acrylate is preferably 1 to 12, more preferably 1 to 8, and even more preferably 1 to 4),
a styrene-(meth)acrylic acid block copolymer,
a styrene-dialkylsiloxane block copolymer (the number of carbon atoms of an alkyl group of dialkylsiloxane is preferably 1 to 12, more preferably 1 to 8, and even more preferably 1 to 4),
a styrene-alkylarylsiloxane block copolymer (the number of carbon atoms of an alkyl group of alkylarylsiloxane is preferably 1 to 12, more preferably 1 to 8, and even more preferably 1 to 4. The number of carbon atoms of an aryl group of polyalkylarylsiloxane is preferably 6 to 20, more preferably 6 to 15, even more preferably 6 to 12, and still even more preferably a phenyl group),
a styrene-diarylsiloxane block copolymer (the number of carbon atoms of an aryl group of diarylsiloxane is preferably 6 to 20, more preferably 6 to 15, even more preferably 6 to 12, and still even more preferably a phenyl group),
a (meth)acrylic acid ester-POSS substituted alkyl(meth)acrylate block copolymer ((meth)acrylic acid ester is preferably (meth)acrylic acid alkyl ester, and the number of carbon atoms of an alkyl group of (meth)acrylic acid alkyl ester and POSS substituted alkyl(meth)acrylate is preferably 1 to 12, more preferably 1 to 8, and even more preferably 1 to 4),
a styrene-vinyl pyridine block copolymer,
a styrene-hydroxystyrene block copolymer,
a styrene-ethylene oxide block copolymer, and
a vinyl naphthalene-(meth)acrylic acid ester copolymer (vinyl naphthalene-(meth)acrylic acid alkyl ester copolymer is preferable).

The "POSS" is an abbreviation for polyhedral-oligomeric-silsesquioxane and refers to a cage-type silsesquioxane. The cage-type silsesquioxane represents a compound having an organic functional group at each apex centering on a cubic structure of silica. That is, the block copolymer used in the present invention is preferably a copolymer having a silsesquioxane structure disclosed in JP2012-036078A.

Each of the block copolymers exemplified as preferable examples includes a form of having the above crosslinkable group (preferably an epoxy group or an oxetane group) in a portion of the monomer component that forms the block.

As the block copolymer, a commercially available product (a product of Polymer Source Inc.) may be used and the block copolymer may be synthesized in the well-known method due to radical or anion polymerization.

The weight-average molecular weight (Mw) of the block copolymer used in the present invention is preferably 3,000 to 300,000, more preferably 5,000 to 100,000, and even more preferably 8,000 to 70,000.

The number-average molecular weight (Mn) of the block copolymer used in the present invention is preferably 100,000 or less, more preferably 50,000 or less, even more preferably 25,000 or less, and even more preferably 20,000 or less. As Mn of the block copolymer is smaller, it is possible to cause the pitch of the lamellar phase separation layer to be smaller. As the pitch of the lamellar phase separation layer becomes smaller, crystallinity of the adjacent specific organic semiconductor compound can be increased, and crystal alignment properties are also increased. The carrier

mobility of OTFT can be improved. The Mn of the block copolymer used in the present invention is preferably 3,000 or greater, more preferably 5,000 or greater, and even more preferably 6,000 or greater.

The dispersion degree (Mw/Mn) of the block copolymer used in the present invention is preferably 1.0 to 1.5, more preferably 1.0 to 1.2, and even more preferably 1.0 to 1.15. Since the phase-separation structure is easily formed, the dispersion degree of the block copolymer used in the present invention is preferably 1.15 or less and more preferably 1.10 or less.

In the present specification, Mw and Mn of the block copolymer can be obtained, for example, by using HLC-8120 (manufactured by Tosoh Corporation), using TSK gel Multipore HXL-M (manufactured by Tosoh Corporation, 7.8 mmHD×30.0 cm) as a column, and using tetrahydrofuran (THF) or N-methyl-2-pyrrolidone (NMP) as an eluant. Mw and Mn are polystyrene conversion values.

In order to decrease (that is, monodisperse) the dispersion degree of the block copolymer, it is preferable to use well-known living anionic polymerization and well-known living radical polymerization. Among these, living radical polymerization is preferably used. As in the disclosure of JP2009-67999A, living anionic polymerization is also preferably performed by using a microreactor synthesizer (flow reaction system).

The block copolymer of the present invention preferably has a block including a repeating unit represented by Formula (I) and a block including a repeating unit represented by Formula (II) or has a block including a repeating unit represented by Formula (I) and a block including a repeating unit represented by Formula (III).

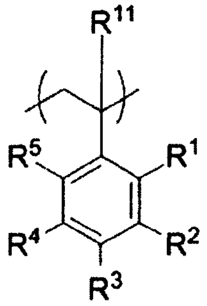

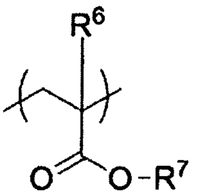

(II)

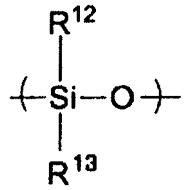

(III)

(I)

In Formula (I), $R^1$ to $R^5$ each independently represent a hydrogen atom, an alkyl group, an alkenyl group, an alkynyl group, a cycloalkyl group, an aryl group, an aralkyl group, or a fluorine atom. $R^1$ and $R^2$ or $R^2$ and $R^3$ are connected to each other to form a ring. $R^{11}$ represents a hydrogen atom or an alkyl group.

In Formula (II), $R^6$ represents a hydrogen atom, an alkyl group, or a cycloalkyl group. $R^7$ represents an alkyl group or a cycloalkyl group, and these substituents may be further substituted with a fluorine atom or a POSS group.

In Formula (III), $R^{12}$ and $R^{13}$ each independently represent an alkyl group or an aryl group.

An alkyl group, an alkenyl group, an alkynyl group, a cycloalkyl group, an aryl group, or an aralkyl group employed by $R^1$ to $R^5$ may further include a substituent. Examples of the substituent include an alkoxy group (preferably having 1 to 10 carbon atoms, more preferably an alkoxy group having 1 to 5 carbon atoms, and even more preferably an ethoxy group or a methoxy group), a hydroxyl group, a halogen atom (such as a fluorine atom and a chlorine atom), a nitro group, an acyl group (an acyl group preferably having 2 to 10 carbon atoms, more preferably having 2 to 5 carbon atoms, and even more preferably having 2 or 3 carbon atoms), an acyloxy group (an acyloxy group having preferably having 2 to 10 carbon atoms, more preferably having 2 to 5 carbon atoms, and more preferably 2 or 3 carbon atoms), an acylamino group (an acylamino group having preferably having 2 to 10 carbon atoms, more preferably having 2 to 5 carbon atoms, and even more preferably 2 or 3 carbon atoms), a sulfonylamino group, a dialkylamino group (a dialkylamino group having preferably having 2 to 20 carbon atoms, more preferably 2 to 10 carbon atoms, and even more preferably a diethylamino group or a dimethylamino group), an alkylthio group (an alkylthio group preferably having 1 to 10 carbon atoms, more preferably having 1 to 5 carbon atoms, and even more preferably an ethylthio group or a methylthio group), an arylthio group (preferably having 6 to 20 carbon atoms, more preferably an arylthio group having 6 to 15 carbon atoms, and even more preferably a phenylthio group or a naphthylthio group), an aralkylthio group (an aralkylthio group preferably having 7 to 20 carbon atoms and more preferably having 7 to 15 carbon atoms), a thienylcarbonyloxy group, a thienylmethylcarbonyloxy group, a heterocyclic residue such as a pyrrolidone residue. In the form in which $R^1$ to $R^5$ have the substituents, all of the forms in which a portion of the plurality of $R^1$'s to $R^5$'s in the repeating unit have the substituent and the form in which all of the plurality of $R^1$'s to $R^5$'s have the substituent are included. The plurality of $R^1$'s to $R^5$'s may have different substituents, respectively.

In a case where $R^1$ to $R^5$ are alkyl groups, the number of carbon atoms is preferably 1 to 12, more preferably 2 to 9, and even more preferably 4 to 6. In a case where $R^1$ is an alkyl group, a non-substituted alkyl group is preferable.

The alkyl group may have a linear shape or may have a branched structure.

In a case where $R^1$ to $R^5$ are alkenyl groups or alkynyl groups, the number of carbon atoms is preferably 2 to 12, more preferably 2 to 9, and even more preferably 4 to 6.

In a case where $R^1$ to $R^5$ are cycloalkyl groups, the number of carbon atoms thereof is preferably 3 to 12, more preferably 3 to 9, and even more preferably 3 to 6. In a case where $R^1$ is a cycloalkyl group, a non-substituted cycloalkyl group is preferable.

In a case where $R^1$ to $R^5$ are aryl groups, the number of carbon atoms is preferably 6 to 12 and more preferably 6 to 9. In a case where $R^1$ is an aryl group, the non-substituted aryl group is preferable.

In a case where $R^1$ to $R^5$ are aralkyl groups, the number of carbon atoms thereof is preferably 7 to 12 and more preferably 7 to 9.

In a case where the number of carbon atoms in R1 to R5 to be in the preferable range, hydrophobicity of the repeating unit represented by Formula (I) increases, and thus phase separation properties between the block including the repeating unit represented by Formula (I) and the block including the repeating unit represented by Formula (II) or (III) can be increased.

In a case where a ring formed by connecting $R^1$ and $R^2$ or $R^2$ and $R^3$ to each other, the ring is preferably a benzene ring (that is, it is preferable that a naphthalene ring is formed in the whole fused ring structure).

$R^{11}$ in Formula (1) represents a hydrogen atom or an alkyl group. $R^{11}$ preferably represents a hydrogen atom or a methyl group.

In a case where $R^{11}$ is a hydrogen atom, $R^1$ to $R^5$ each are preferably any one of a hydrogen atom, an alkyl group, an alkenyl group, an alkynyl group, a cycloalkyl group, an aryl group, an aralkyl group, or a benzene ring formed by connecting $R^2$ and $R^3$ to each other, more preferably an alkyl group or an aryl group, even more preferably an alkyl group, and particularly preferably a t-butyl group.

In a case where $R^{11}$ is an alkyl group, $R^1$ is preferably a hydrogen atom or an alkyl group and more preferably a hydrogen atom.

In Formula (II), $R^6$ represents a hydrogen atom, an alkyl group, or a cycloalkyl group.

An alkyl group and a cycloalkyl group employed as $R^6$ may further include a substituent. Specific examples of the substituent include an alkoxy group (an alkoxy group preferably having 1 to 10 carbon atoms, more preferably an alkoxy group having 1 to 5 carbon atoms, or more preferably ethoxy or methoxy), a hydroxyl group a halogen atom (such as a fluorine atom and a chlorine atom), a nitro group, an acyl group (an acyl group preferably having 2 to 10 carbon atoms, more preferably having 2 to 5 carbon atoms, and more preferably having 2 or 3 carbon atoms), an acyloxy group (an acyloxy group preferably having 2 to 10 carbon atoms, more preferably having 2 to 5 carbon atoms, and more preferably having 2 or 3 carbon atoms), an acylamino group (an acylamino group preferably having 2 to 10 carbon atoms, more preferably having 2 to 5 carbon atoms, and more preferably having 2 or 3 carbon atoms), a sulfonylamino group, a dialkylamino group (a dialkylamino group preferably having 2 to 20 carbon atoms, more preferably a dialkylamino group having 2 to 10 carbon atoms, and more preferably diethylamino or dimethylamino), an alkylthio group (an alkylthio group preferably having 1 to 10 carbon atoms, more preferably an alkylthio group having 1 to 5 carbon atoms, and more preferably ethylthio or methylthio), an arylthio group (an arylthio group preferably having 6 to 20 carbon atoms, more preferably an arylthio group having 6 to 15 carbon atoms, and more preferably phenylthio or naphthylthio), an aralkylthio group (an aralkylthio group preferably having 7 to 20 carbon atoms or more preferably having 7 to 15 carbon atoms), a thienylcarbonyloxy group, a thienylmethylcarbonyloxy group, and a heterocyclic residue such as a pyrrolidone residue. In the form in which $R^6$ has a substituent, all of the forms in which a portion of the plurality of $R^6$'s in the repeating unit have the substituent and the form in which all of the plurality of $R^6$'s have in the substituent are included. The plurality of $R^6$'s may have substituents which are different from each other.

An alkyl group and a cycloalkyl group employed as $R^6$ are preferably non-substituted.

In view of stably maintaining the phase separation structure of the block copolymer layer once formed by increasing a glass point transition (Tg) of the block copolymer, $R^6$ is preferably an alkyl group (an alkyl group preferably having 1 to 12 carbon atoms, more preferably having 1 to 8 carbon atoms, even more preferably having 1 to 4 carbon atoms) or a cycloalkyl group (a cycloalkyl group preferably having 3 to 12 carbon atoms, more preferably having 3 to 8 carbon atoms), more preferably an alkyl group having 1 to 4 carbon atoms, and even more preferably a methyl group.

In Formula (II), $R^7$ represents an alkyl group or a cycloalkyl group.

An alkyl group and a cycloalkyl group employed as $R^7$ may further include a substituent. Specific examples of the substituent include an alkoxy group (an alkoxy group preferably having 1 to 10 carbon atoms, more preferably an alkoxy group having 1 to 5 carbon atoms, or more preferably ethoxy or methoxy), a hydroxyl group a halogen atom (such as a fluorine atom and a chlorine atom), a nitro group, an acyl group (an acyl group preferably having 2 to 10 carbon atoms, more preferably having 2 to 5 carbon atoms, and more preferably having 2 or 3 carbon atoms), an acyloxy group (an acyloxy group preferably having 2 to 10 carbon atoms, more preferably having 2 to 5 carbon atoms, and more preferably having 2 or 3 carbon atoms), an acylamino group (an acylamino group preferably having 2 to 10 carbon atoms, more preferably having 2 to 5 carbon atoms, and more preferably having 2 or 3 carbon atoms), a sulfonylamino

group, a dialkylamino group (a dialkylamino group preferably having 2 to 20 carbon atoms, more preferably a dialkylamino group having 2 to 10 carbon atoms, and more preferably diethylamino or dimethylamino), an alkylthio group (an alkylthio group preferably having 1 to 10 carbon atoms, more preferably an alkylthio group having 1 to 5 carbon atoms, and more preferably ethylthio or methylthio), an arylthio group (an arylthio group preferably having 6 to 20 carbon atoms, more preferably an arylthio group having 6 to 15 carbon atoms, and more preferably phenylthio or naphthylthio), an aralkylthio group (an aralkylthio group preferably having 7 to 20 carbon atoms or more preferably having 7 to 15 carbon atoms), a thienylcarbonyloxy group, a thienylmethylcarbonyloxy group, a heterocyclic residue such as a pyrrolidone residue, an epoxy group, an oxetane group, and a POSS group. Among these substituents, a fluorine atom or a POSS group is preferable.

In the form in which $R^7$ has a substituent, all of the forms in which a portion of the plurality of $R^7$'s in the repeating unit have the substituent and the form in which all of the plurality of $R^7$'s have in the substituent are included. The plurality of $R^7$'s may have different substituents. In a case where $R^7$ has a substituent, this substituent is preferably a halogen atom or a group including an oxygen atom or a sulfur atom (for example, alkoxy or alkylthio group).

In a case where $R^7$ is an alkyl group, the number of carbon atoms is preferably 1 to 12, more preferably 1 to 8, even more preferably 1 to 4, and even more preferably methyl, ethyl, or propyl.

$R^7$ is preferably an alkyl group substituted with halogen and particularly preferably an alkyl group substituted with fluorine, and in this case, preferably a group represented by Formula (II-2).

$R^7$ is also preferably an alkyl group substituted with a POSS group.

In a case where $R^7$ is a cycloalkyl group, the number of carbon atoms thereof is preferably 3 to 12 and more preferably 3 to 8.

The block including the repeating unit represented by Formula (II) is preferably a block including the repeating unit represented by any one of Formula (II-1), (II-2), or (II-3).

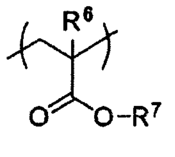
(II-1)

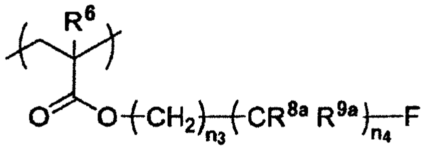
(II-2)

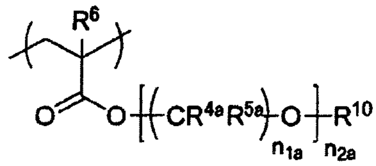
(II-3)

In Formulae (II-1), (II-2), and (II-3), $R^6$ is the same as $R^6$ in Formula (II), and the preferable form is also the same.

In Formula (II-1), $R^7$ represents a non-substituted alkyl group having 1 to 12 carbon atoms, a non-substituted cycloalkyl group having 3 to 12 carbon atoms, or an alkyl group having 1 to 12 carbon atoms substituted with a POSS group.

In a case where $R^7$ is a non-substituted alkyl group, the number of carbon atoms thereof is preferably 1 to 8 and more preferably 1 to 4. $R^7$ is even more preferably methyl or ethyl.

In a case where $R^7$ is an alkyl group having 1 to 12 carbon atoms substituted with a POSS group, the number of carbon atoms thereof is preferably 1 to 8 and more preferably 1 to 4. The number of carbon atoms of the POSS group is not included in the number of carbon atoms of the alkyl group.

In a case where $R^7$ is a non-substituted cycloalkyl group, the number of carbon atoms thereof is preferably 4 to 10 and more preferably 5 to 8. $R^7$ is even more preferably cyclohexyl.

In Formula (II-2), $R^{8a}$ and $R^{9a}$ represent a hydrogen atom or a fluorine atom. Here, at least one of $R^{8a}$ or $R^{9a}$ represents a fluorine atom. It is more preferable that both of $R^{8a}$ and $R^{9a}$ are fluorine atoms.

In Formula (II-2), $n_3$ represents 1 or 2 and preferably represents 1. $n_4$ represents an integer of 1 to 8. $n_4$ is more preferably an integer of 1 to 6, even more preferably an integer of 1 to 4, and still even more preferably 1 or 2.

In Formula (II-3), $R^{4a}$ and $R^{5a}$ represent a hydrogen atom or a methyl group. In view of enhancing phase separation properties of the block including the repeating unit represented by Formula (I) and the block including the repeating unit represented by Formula (II-3), $R^{4a}$ and $R^{5a}$ are preferably hydrogen atoms.

In Formula (II-3), $R^{10}$ represents a hydrogen atom, an alkyl group, a cycloalkyl group, or an aryl group.

$n_{1a}$ represents an integer of 2 to 4. $n_{2a}$ represents an integer of 1 to 6.

In Formula (II-3), an alkyl group and a cycloalkyl group employed as $R^{10}$ may have a substituent. Preferable examples of the substituent include an alkoxy group (an alkoxy group preferably having 1 to 10 carbon atoms, more preferably an alkoxy group having 1 to 5 carbon atoms, or more preferably ethoxy or methoxy), a hydroxyl group a halogen atom (such as a fluorine atom and a chlorine atom), a nitro group, an acyl group (an acyl group preferably having 2 to 10 carbon atoms, more preferably having 2 to 5 carbon atoms, and more preferably having 2 or 3 carbon atoms), an acyloxy group (an acyloxy group preferably having 2 to 10 carbon atoms, more preferably having 2 to 5 carbon atoms, and more preferably having 2 or 3 carbon atoms), an acylamino group (an acylamino group preferably having 2 to 10 carbon atoms, more preferably having 2 to 5 carbon atoms, and more preferably having 2 or 3 carbon

atoms), a sulfonylamino group, a dialkylamino group (dialkylamino preferably having 2 to 20 carbon atoms, more preferably dialkylamino having 2 to 10 carbon atoms, and more preferably diethylamino or dimethylamino), an alkylthio group (an alkylthio group preferably having 1 to 10 carbon atoms, more preferably an alkylthio group having 1 to 5 carbon atoms, and more preferably ethylthio or methylthio), an arylthio group (an arylthio group preferably having 6 to 20 carbon atoms, more preferably an arylthio group having 6 to 15 carbon atoms, and more preferably phenylthio or naphthylthio), an aralkylthio group (an aralkylthio group preferably having 7 to 20 carbon atoms or more preferably having 7 to 15 carbon atoms), a thienylcarbonyloxy group, a thienylmethylcarbonyloxy group, a heterocyclic residue such as a pyrrolidone residue, an epoxy group, and an oxetane group.

In the form in which $R^{10}$ has a substituent, all of the forms in which a portion of the plurality of $R^{10}$'s in the repeating unit have the substituent and the form in which all of the plurality of $R^{10}$'s have in the substituent are included. The plurality of $R^{10}$'s may have different substituents.

In a case where $R^{10}$ is an alkyl group, the number of carbon atoms is preferably 1 to 12, more preferably 1 to 8, and even more preferably 1 to 4. In a case where $R^{10}$ is an alkyl group, $R^{10}$ is even more preferably methyl or ethyl.

In a case where $R^{10}$ is a cycloalkyl group, the number of carbon atoms thereof is preferably 3 to 12 and even more preferably 3 to 8. In a case where $R^{10}$ is a cycloalkyl group, $R^{10}$ is even more preferably cyclohexyl.

In Formula (III), $R^{12}$ and $R^{13}$ each independently represent an alkyl group or an aryl group.

In a case where $R^{12}$ and $R^{13}$ are alkyl groups, the number of carbon atoms is preferably 1 to 12, more preferably 1 to 8, and even more preferably 1 to 4. The alkyl group may have a linear shape or may have a branched structure.

In a case where $R^{12}$ and $R^{13}$ are aryl groups, the number of carbon atoms is preferably 6 to 12 and more preferably 6 to 9.

The block copolymer used in the present invention has the block including the repeating unit represented by Formula (I) and the block including the repeating unit represented by Formula (II), the block copolymer used in the present invention may have an independent repeating unit that is not represented by Formula (I) or (II), but a structure obtained by bonding the block including the repeating unit represented by Formula (I) the block including the repeating unit represented by Formula (II) is preferable.

In the same manner, the block copolymer used in the present invention has the block including the repeating unit represented by Formula (I) and the block including the repeating unit represented by Formula (III), the block copolymer used in the present invention may have an independent repeating unit that is not represented by Formula (I) or (III), but a structure obtained by bonding the block including the repeating unit represented by Formula (I) the block including the repeating unit represented by Formula (III) is preferable.

A ratio of the number-average molecular weight of the block including the repeating unit represented by Formula (I) and the block including the repeating unit represented by Formula (II) is preferably Formula (I):Formula (II)=25:75 to 75:25, more preferably 40:60 to 60:40, and even more preferably 45:55 to 55:45.

A ratio of the number-average molecular weight of the block including the repeating unit represented by Formula (I) and the block including the repeating unit represented by Formula (III) is preferably Formula (I):Formula (III)=20:80 to 98:2, more preferably 40:60 to 90:10, and even more preferably 50:50 to 85:15.

In a case where the ratio of the number-average molecular weights of the respective blocks is in the above range, it is possible to more securely and more efficiently form a lamellar phase separation structure which is a preferable phase separation form.

Hereinafter, specific examples of the preferable repeating unit represented by Formula (I) are provided, but the present invention is not limited thereto.

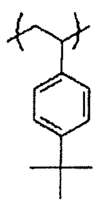 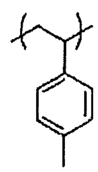 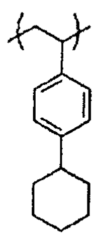 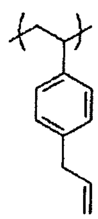 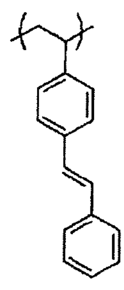 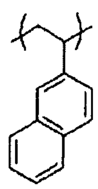 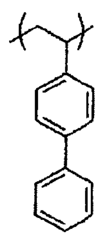

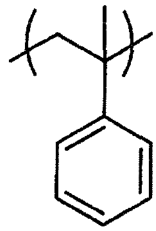

Hereinafter, specific examples of the preferable repeating unit represented by Formula (II) are provided, but the present invention is not limited thereto. Among the examples below, Me represents a methyl group, Et represents an ethyl group, and iBu represents an isobutyl group.

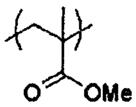
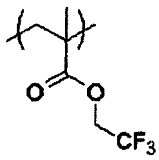
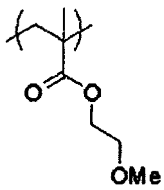
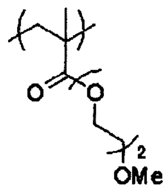
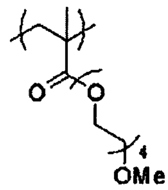
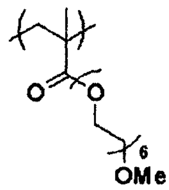

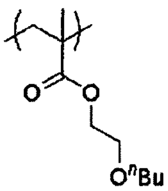
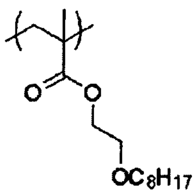
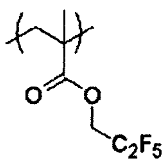
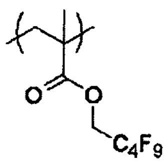
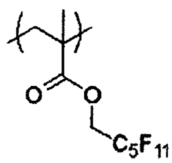
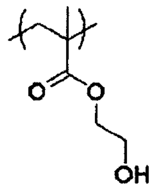

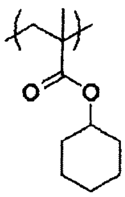
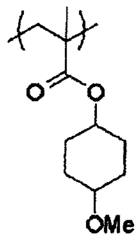
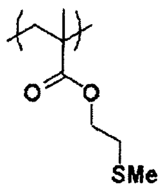

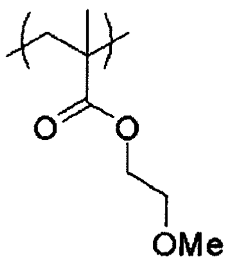
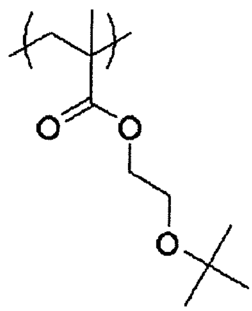
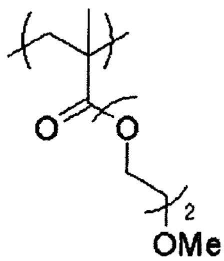
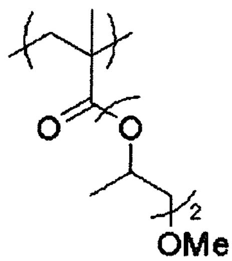

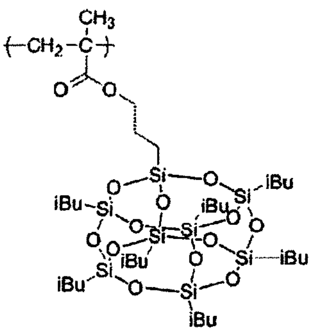
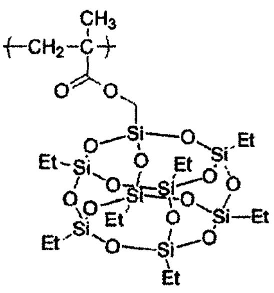
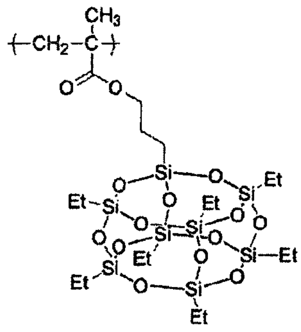

Hereinafter, specific examples of the preferable repeating unit represented by Formula (III) are provided, but the present invention is not limited thereto.

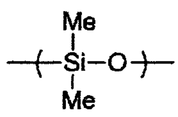
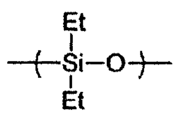
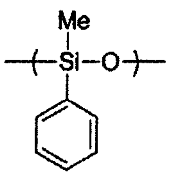
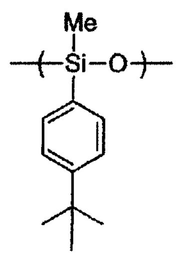
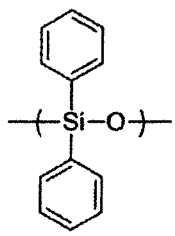

In a case where the block copolymer has the block including the repeating unit represented by Formula (I) and the block including the repeating unit represented by Formula (II), an absolute value of a difference between an SP value (an SP value of the block including the repeating unit represented by Formula (I)) of the repeating unit represented by Formula (I) and an SP value (an SP value of the block including the repeating unit represented by Formula (II)) of the repeating unit represented by Formula (II) is preferably 0.5 to 4.0 $MPa^{1/2}$.

In the same manner, in a case where the block copolymer has the block including the repeating unit represented by Formula (I) and the block including the repeating unit represented by Formula (III), an absolute value of a difference between the SP value (an SP value of the block including the repeating unit represented by Formula (I)) of the repeating unit represented by Formula (I) and an SP value (an SP value of the block including the repeating unit represented by Formula (III)) of the repeating unit represented by Formula (III) is preferably 0.5 to 4.0 $MPa^{1/2}$.

In a case where the difference between solubility parameters (SP values) of the respective repeating units is caused in the range above, the phase separation of the block copolymer can be performed at a high quality and high efficiency.

Particularly, in view of forming a lamellar phase separation layer in the block polymer having lower molecular weight, that is, forming the lamellar phase separation layer at a narrower pitch (a size of the pitch is proportional to 2/3 power of degree of polymerization), an absolute value of a a difference between the SP value of the repeating unit represented by Formula (I) and the SP value of the repeating unit represented by Formula (II) is preferably 0.5 to 3.5 $MPa^{1/2}$ and more preferably 0.5 to 3.0 $MPa^{1/2}$.

An absolute value of a a difference between the SP value of the repeating unit represented by Formula (I) and the SP value of the repeating unit represented by Formula (III) is preferably 0.5 to 3.5 $MPa^{1/2}$ and more preferably 0.5 to 3.0 $MPa^{1/2}$.

Specific examples of the combination of the repeating unit of the block copolymer obtained by bonding the block including the repeating unit represented by Formula (I) and the block including the repeating unit represented by Formula (II) are provided below, but the present invention is not limited to these examples. In the examples below, the ratio (a, b) of the repeating units is a mass ratio. Me represents a methyl group, nBu represents a normal butyl group, and iBu represents an isobutyl group. ΔSP represents an absolute value of a difference between SP values between blocks in the respective repeating units.

BP−1

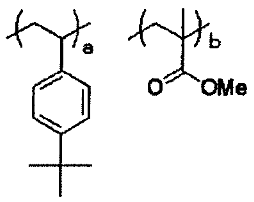

⊿SP=1. 3

(BP-1A): a=47wt%, b=53wt%, Mn=19700, Mw/Mn=1.05
(BP-1B): a=66wt%, b=34wt%, Mn=15400, Mw/Mn=1.06

BP−2

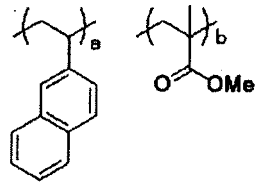

⊿SP=1. 5

(BP-2A): a=52wt%, b=48wt%, Mn=17200, Mw/Mn=1.15
(BP-2B): a=70wt%, b=30wt%, Mn=17900, Mw/Mn=1.17

BP−3

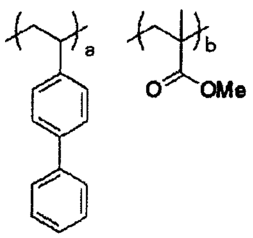

⊿SP=1. 8

(BP-3A): a=52wt%, b=48wt%, Mn=17900, Mw/Mn=1.08
(BP-3B): a=69wt%, b=31wt%, Mn=18500, Mw/Mn=1.09

BP−5

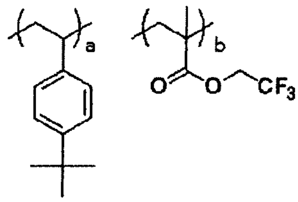

⊿SP=1. 3

(BP-5A): a=51wt%, b=49wt%, Mn=17600, Mw/Mn=1.11
(BP-5A'): a=50wt%, b=50wt%, Mn=16300, Mw/Mn=1.07
(BP-5B): a=68wt%, b=32wt%, Mn=15600, Mw/Mn=1.12
(BP-5B'): a=69wt%, b=31wt%, Mn=17200, Mw/Mn=1.09
(BP-5C): a=51wt%, b=49wt%, Mn=30200, Mw/Mn=1.06
(BP-5D): a=53wt%, b=47wt%, Mn=22200, Mw/Mn=1.08
(BP-5E): a=72wt%, b=28wt%, Mn=28800, Mw/Mn=1.05
(BP-5F): a=70wt%, b=30wt%, Mn=24400, Mw/Mn=1.06

BP−6

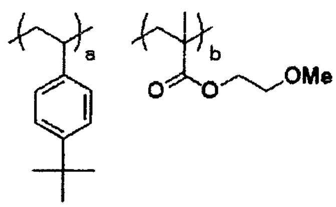

⊿SP=2. 2

(BP-6A): a=48wt%, b=52wt%, Mn=18000, Mw/Mn=1.08
(BP-6B): a=75wt%, b=25wt%, Mn=18300, Mw/Mn=1.08
(BP-6C): a=49wt%, b=51wt%, Mn=28900, Mw/Mn=1.05
(BP-6D): a=51wt%, b=49wt%, Mn=23700, Mw/Mn=1.07
(BP-6E): a=73wt%, b=27wt%, Mn=25100, Mw/Mn=1.05
(BP-6F): a=70wt%, b=30wt%, Mn=22600, Mw/Mn=1.06

BP−7

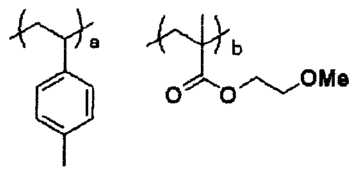

⊿SP=1. 0

(BP-7A): a=52wt%, b=48wt%, Mn=18500, Mw/Mn=1.08
(BP-7B): a=72wt%, b=28wt%, Mn=16800, Mw/Mn=1.10

BP−8

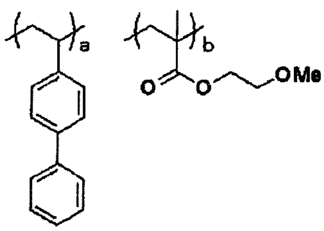

⊿SP=0. 9

(BP-8A): a=52wt%, b=48wt%, Mn=16400, Mw/Mn=1.06
(BP-8B): a=73wt%, b=27wt%, Mn=17700, Mw/Mn=1.09

BP−9

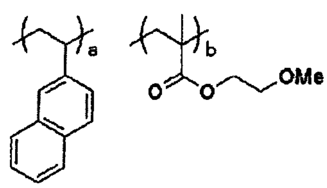

⊿SP=0. 6

(BP-9A): a=50wt%, b=50wt%, Mn=17900, Mw/Mn=1.10
(BP-9B): a=70wt%, b=30wt%, Mn=18900, Mw/Mn=1.13

BP−10

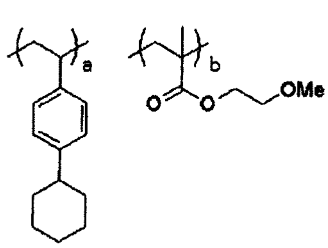

⊿SP=1. 5

(BP-10A): a=51wt%, b=49wt%, Mn=18800, Mw/Mn=1.10
(BP-10B): a=69wt%, b=31wt%, Mn=19800, Mw/Mn=1.11

BP−11

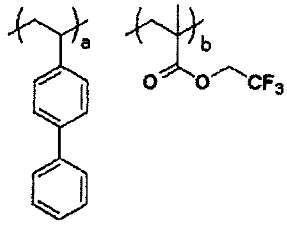

⊿SP=1. 8

(BP-11A): a=46wt%, b=54wt%, Mn=17800, Mw/Mn=1.07
(BP-11B): a=70wt%, b=30wt%, Mn=19100, Mw/Mn=1.06

BP−12

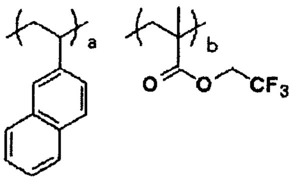

⊿SP=1. 5

(BP-12A): a=47wt%, b=53wt%, Mn=19100, Mw/Mn=1.13
(BP-12B): a=67wt%, b=33wt%, Mn=18600, Mw/Mn=1.12

BP−13

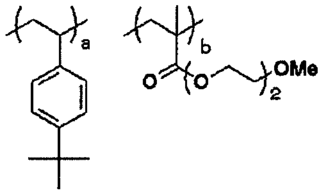

⊿SP=2. 3

(BP-13A): a=53wt%, b=47wt%, Mn=19500, Mw/Mn=1.07
(BP-13B): a=71wt%, b=29wt%, Mn=18000, Mw/Mn=1.10

BP−14

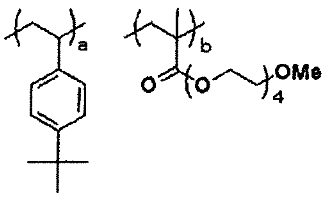

⊿SP=2. 6

(BP-14A): a=49wt%, b=51wt%, Mn=17400, Mw/Mn=1.09
(BP-14B): a=67wt%, b=33wt%, Mn=17100, Mw/Mn=1.13

BP−15

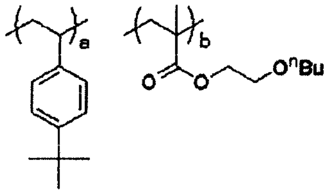

⊿SP=0. 6

(BP-15A): a=52wt%, b=48wt%, Mn=18700, Mw/Mn=1.11
(BP-15B): a=73wt%, b=27wt%, Mn=19300, Mw/Mn=1.10

BP−16

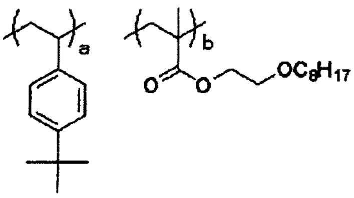

⊿SP=0. 5

(BP-16A): a=47wt%, b=53wt%, Mn=19300, Mw/Mn=1.10
(BP-16B): a=66wt%, b=34wt%, Mn=18900, Mw/Mn=1.09

BP−17

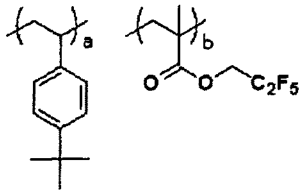

⊿SP=0. 5

(BP-17A): a=50wt%, b=50wt%, Mn=17200, Mw/Mn=1.08
(BP-17B): a=70wt%, b=30wt%, Mn=16500, Mw/Mn=1.07

BP-18

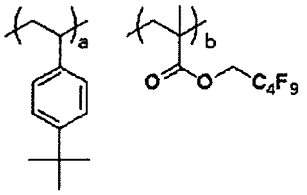

ΔSP=1. 1

(BP-18A): a=48wt%, b=52wt%, Mn=19000, Mw/Mn=1.10
(BP-18B): a=71wt%, b=29wt%, Mn=17000, Mw/Mn=1.08

BP-19

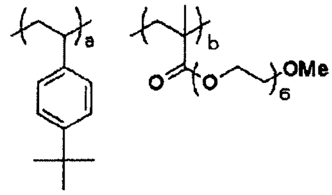

ΔSP=3. 1

(BP-19A): a=50wt%, b=50wt%, Mn=17700, Mw/Mn=1.09
(BP-19B): a=70wt%, b=30wt%, Mn=17900, Mw/Mn=1.08

BP-20

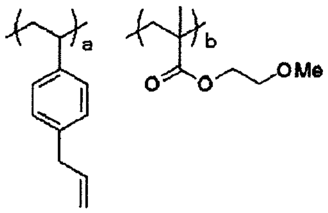

ΔSP=1. 5

(BP-20A): a=48wt%, b=52wt%, Mn=16900, Mw/Mn=1.14
(BP-20B): a=71wt%, b=29wt%, Mn=17500, Mw/Mn=1.12

BP-21

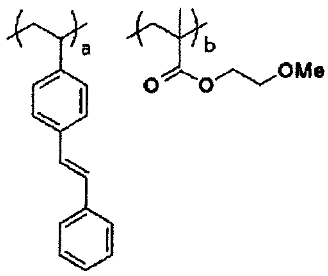

ΔSP=0. 8

(BP-21A): a=51wt%, b=49wt%, Mn=18800, Mw/Mn=1.07
(BP-21B): a=67wt%, b=33wt%, Mn=17400, Mw/Mn=1.08

BP-22

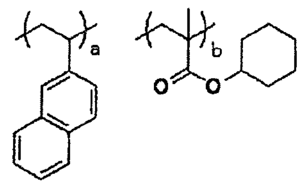

ΔSP=3. 2

(BP-22A): a=50wt%, b=50wt%, Mn=19200, Mw/Mn=1.14
(BP-22B): a=73wt%, b=27wt%, Mn=18000, Mw/Mn=1.16

BP-23

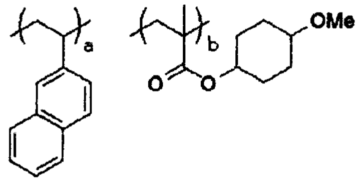

ΔSP=2. 7

(BP-23A): a=46wt%, b=54wt%, Mn=17000, Mw/Mn=1.14
(BP-23B): a=72wt%, b=28wt%, Mn=18300, Mw/Mn=1.13

BP-24

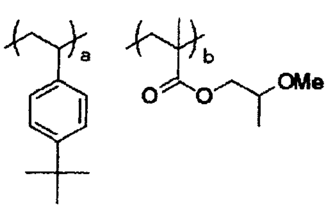

ΔSP=1. 5

(BP-24A): a=49wt%, b=51wt%, Mn=17700, Mw/Mn=1.08
(BP-24B): a=70wt%, b=30wt%, Mn=18300, Mw/Mn=1.06

BP-25

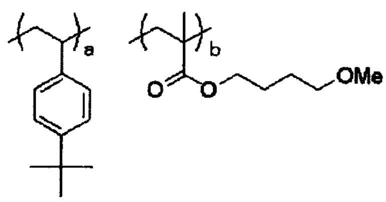

ΔSP=1. 6

(BP-25A): a=50wt%, b=50wt%, Mn=16500, Mw/Mn=1.09
(BP-25B): a=66wt%, b=34wt%, Mn=17100, Mw/Mn=1.08

BP-26

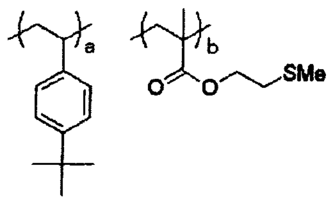

⊿SP=2. 4

(BP-26A): a=48wt%, b=52wt%, Mn=17700, Mw/Mn=1.11
(BP-26B): a=71wt%, b=29wt%, Mn=18800, Mw/Mn=1.09

BP-4

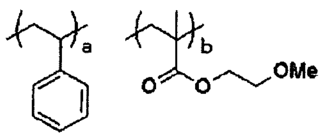

⊿SP=0. 6

(BP-4A): a=45wt%, b=55wt%, Mn=18000 Mw/Mn=1.07
(BP-4B): a=72wt%, b=28wt%, Mn=19700, Mw/Mn=1.16

BP-27

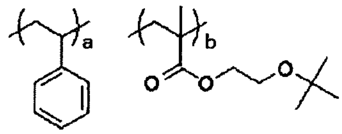

⊿SP=0. 7

(BP-27A): a=47wt%, b=53wt%, Mn=19300, Mw/Mn=1.07
(BP-27B): a=66wt%, b=34wt%, Mn=16700, Mw/Mn=1.07

BP-28

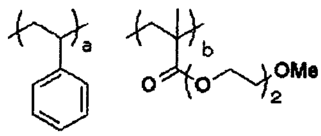

⊿SP=0. 7

(BP-28A): a=52wt%, b=48wt%, Mn=18000, Mw/Mn=1.08
(BP-28B): a=71wt%, b=29wt%, Mn=19100, Mw/Mn=1.09

BP-29

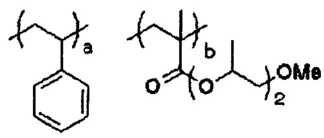

⊿SP=1. 5

(BP-29A): a=50wt%, b=50wt%, Mn=17100, Mw/Mn=1.06
(BP-29B): a=68wt%, b=32wt%, Mn=18900, Mw/Mn=1.07

ABP-1

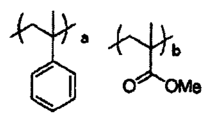

(ABP-1A): a=70wt%, b=30wt%, Mn=48000, Mw/Mn=1.07
(ABP-1B): a=50wt%, b=50wt%, Mn=45000, Mw/Mn=1.07

ABP-2

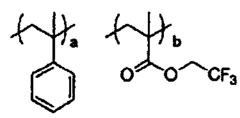

(ABP-2A): a=70wt%, b=30wt%, Mn=17000, Mw/Mn=1.07
(ABP-2B): a=50wt%, b=50wt%, Mn=18000, Mw/Mn=1.06

ABP-3

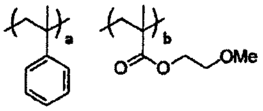

(ABP-3A): a=70wt%, b=30wt%, Mn=19500, Mw/Mn=1.08
(ABP-3B): a=50wt%, b=50wt%, Mn=18500, Mw/Mn=1.07

ABP-4

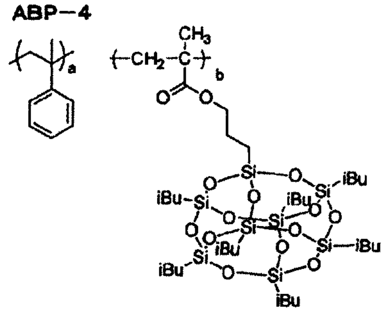

(ABP-4A): a=70wt%, b=30wt%, Mn=29000 Mw/Mn=1.20
(ABP-4B): a=50wt%, b=50wt%, Mn=28000, Mw/Mn=1.18

Specific examples of the combination of the repeating unit of the block copolymer obtained by bonding the block including the repeating unit represented by Formula (I) and the block including the repeating unit represented by Formula (III) are provided below, but the present invention is not limited to these examples.

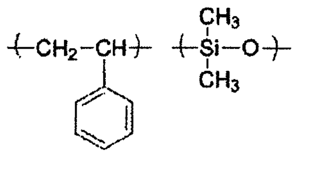 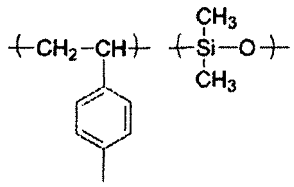 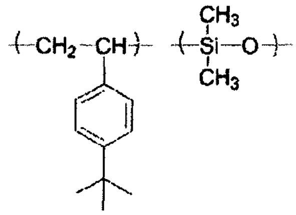

Subsequently, an example of the method of forming the layer obtained by microphase separation of the block copolymer is described below.

In the OTFT of the present invention, the layer obtained by microphase separation of the block copolymer is formed by applying a solution containing the block copolymer, forming a film, performing a heat treatment or the like to this film, and self-assembling the block copolymer.

A solvent of the solution containing the block copolymer is preferably an organic solvent, and examples thereof include lactones such as γ-butyrolactone; ketones such as acetone, methyl ethyl ketone, cyclohexanone, methyl-n-pentyl ketone, methyl isopentyl ketone, and 2-heptanone; polyhydric alcohols such as ethylene glycol, diethylene glycol, propylene glycol, and dipropylene glycol; a compound having an ester bond such as ethylene glycol monoacetate, diethylene glycol monoacetate, propylene glycol monoacetate, and dipropylene glycol monoacetate or the polyhydric alcohols or derivatives of polyhydric alcohols such as monoalkyl ether such as monomethyl ether, monoethyl ether, monopropyl ether, or monobutyl ether of the compound having an ester bond or the compound having an ether bond such as monophenyl ether [among these, propylene glycol monomethyl ether acetate (PGMEA) and propylene glycol monomethyl ether (PGME) are preferable]; cyclic ethers such as dioxane; esters such as methyl lactate, ethyl lactate (EL), methyl acetate, ethyl acetate, butyl acetate, methyl pyruvate, ethyl pyruvate, methyl methoxypropionate, and ethyl ethoxypropionate; and an aromatic organic solvent such as anisole, ethyl benzyl ether, cresyl methyl ether, diphenyl ether, dibenzyl ether, phenetol, butyl phenyl ether, ethyl benzene, diethyl benzene, pentyl benzene, isopropyl benzene, toluene, xylene, cymene, and mesitylene. Two or more of the above organic solvents may be used in combination.

In the solution containing the block copolymer, the concentration of the block copolymer is generally 1.0 to 10 mass%, preferably 1.5 to 6.0 mass%, and even more preferably 1.5 to 5.5 mass%.

Typically, the solution containing the block copolymer is applied by using a spinner, a coater, or the like. Accordingly, the layer containing the block copolymer can be formed. It is possible to microphase-separate the block copolymer by heating this layer containing the block copolymer. It is preferable that the heating is performed at the temperature of the glass transition temperature or higher. It is preferable that the heating is performed at the thermolysis temperature of the block copolymer or lower. The heating temperature is preferably 50°C to 250°C, more preferably 60°C to 200°C, and even more preferably 100°C to 180°C. The heating time is preferably 1 second to 10 hours and more preferably 1 minute to 2 hours.

According to this microphase separation, it is preferable that the block copolymer is subjected to the lamellar phase separation. The lamellar phase separation can be performed by causing the composition of the block unit in the block copolymer to be in the above preferable range.

In a case where the organic semiconductor layer contains the specific organic semiconductor compound and the block copolymer, it is possible to self-assemble the block copolymer included in the organic semiconductor layer by applying the mixed solution containing the specific organic semiconductor compound and the block copolymer, forming a film, and performing the heat treatment on this film (organic semiconductor layer) and the like. In this case, the mixed solution preferably contains the above solvent.

Hereinafter, the configuration and the materials of the OTFT of the present invention are further described.

<Substrate>

The substrate may be a substrate that can support the OTFT and a display panel manufactured thereon. The substrate has insulating properties on the surface and the substrate is not particularly limited, as long as the substrate has a sheet shape and the surface thereof is flat.

As the material of the substrate, an inorganic material may be used. Examples of the substrate including the inorganic material include various glass substrates such as quartz glass or soda-lime glass, various glass substrates having an insulating film formed on the surface thereof, a quartz substrate having an insulating film formed on the surface thereof, a silicon substrate having an insulating film formed on the surface thereof, a sapphire substrate, a metal substrate or a metal foil formed of various alloys such as stainless steel, aluminum, and nickel or various metals, and paper.

In a case where the substrate is formed of a conductive or semiconductive material such as a stainless sheet, an aluminum foil, a copper foil, or a silicon wafer, an insulating polymer material, metal oxide, or the like is generally applied or laminated on the surface and used.

As the material of the substrate, an organic material may be used. Examples thereof include a flexible plastic substrate (also referred to as a plastic film or a plastic sheet) including an organic polymer exemplified by polymethyl methacrylate (PMMA), polyvinyl alcohol (PVA), polyvinyl phenol (PVP), polyethersulfone (PES), polyimide, polyamide, polyacetal, polycarbonate (PC), polyethylene terephthalate (PET), polyethylene naphthalate (PEN), polyethylether ketone, polyolefin, and polycycloolefin. Examples thereof also include a substrate formed of mica.

In a case where a flexible plastic substrate or the like is used, it is possible to combine or integrate the OTFT, for example, with a display device or an electronic device having a curved shape.

Since the organic material forming the substrate is hardly softened in a case where other layers are laminated and heated, the glass transition point is preferably high and the glass transition point is preferably 40°C or higher. Since dimensions are hardly changed by the heat treatment in a case of manufacturing and the stability of the transistor performance is excellent, the coefficient of linear expansion is preferably small. A material having a linear expansion coefficient of $25\times10^{-5}$ cm/cm•°C or less is preferable, and a material having a linear expansion coefficient of $10\times10^{-5}$ cm/cm•°C or less is more preferable.

The organic material forming the substrate is preferably a material having resistance to the solvent used in a case of manufacturing the OTFT and preferably is a material having excellent adhesiveness to the gate insulating layer and the electrode.

It is preferable to use a plastic substrate including an organic polymer having high gas barrier properties.

It is also preferable to provide a dense silicon oxide film or the like on at least one side of the substrate or vapor-deposit or laminate an inorganic material.

In addition to the above, examples of the substrate include a conductive substrate (a substrate formed of metal such as gold or aluminum, a substrate formed of highly oriented graphite, a stainless steel substrate).

A buffer layer for improving adhesiveness and flatness, a functional film such as a barrier film for improving the gas barrier properties, and a surface treatment layer such as an easy adhesion layer on the surface may be formed on the substrate, and the substrate may be subjected to a surface treatment such as a corona treatment, a plasma treatment, or an ultraviolet (UV)/ozone treatment.

The thickness of the substrate is preferably 10 mm or less, more preferably 2 mm or less, and even more preferably 1 mm or less. Meanwhile, the thickness is preferably 0.01 mm or greater and more preferably 0.05 mm or greater. Particularly, in a case of the plastic substrate, the thickness is preferably about 0.05 to 0.1 mm. In a case of the substrate including an inorganic material, the thickness is preferably about 0.1 to 10 mm.

<Gate electrode>

As the gate electrode, an electrode well-known in the related art can be used as the gate electrode of the OTFT. The conductive material (also referred to as an electrode material) forming the gate electrode is not particularly limited. Examples thereof include metal such as platinum, gold, silver, aluminum, chromium, nickel, copper, molybdenum, titanium, magnesium, calcium, barium, sodium, palladium, iron, and manganese; conductive metal oxide such as $InO_2$, $SnO_2$, indium-tin oxide (ITO, tin-doped indium oxide), fluorine doped tin oxide (FTO, F-doped Tin Oxide), aluminum doped zinc oxide (AZO, A1 doped ZnO), and gallium doped zinc oxide (GZO, Ga doped ZnO); a conductive polymer such as polyaniline, polypyrrole, polythiophene, polyacetylene, poly(3,4-ethylenedioxythiophene)/polystyrenesulfonic acid (PEDOT/PSS); an acid such as hydrochloric acid, sulfuric acid, and sulfonic acid; the conductive polymer to which a dopant such as a lewis acid such as $PF_6$, AsFs, and $FeCl_3$, a halogen atom such as iodine, a metal atom such as sodium and potassium are added, and a conductive composite material in which carbon black, graphite powder, or metal fine particles are dispersed. These materials may be used singly or two or more kinds thereof may be used together in an arbitrary combination and ratio.

The gate electrode may be a single layer formed of the conductive material, and two or more layers may be laminated.

The method of forming the gate electrode is not limited. Examples thereof include a method of patterning a film formed by a physical vapor deposition method (PVD) such as a vacuum deposition method, a chemical vapor deposition method (CVD method), a sputtering method, a printing method (coating method), a transfer method, a sol gel method, a plating method, or the like, to a desired shape, if necessary.

In the coating method, a solution, a paste, or a dispersion liquid of the above material can be prepared and applied, and an electrode can be formed directly or by forming a film by drying, baking, photocuring, or aging.

Ink jet printing, screen printing, offset printing, letterpress printing, intaglio printing, planographic printing, thermal transfer printing, micro contact printing method, and the like are preferable, since patterning can be performed as desired, the process is simple, the cost is reduced, and the speed is high.

Even in a case where a spin coating method, a die coating method, a micro gravure coating method, or a dip coating method is employed, patterning can be performed in combination with the following photolithography method or the like.

Examples of the photolithography method include a method combining patterning of a photoresist, etching such as wet etching with an etchant or dry etching with reactive plasma, and a lift-off method, or the like.
Examples of another patterning method include a method of irradiating the above material with an energy beam such as a laser or an electron beam, polishing the material, or changing the conductivity of the material.
Examples of another method include a method of transferring a composition for a gate electrode printed on a support other than the substrate to a base material layer such as a substrate.
The thickness of the gate electrode is arbitrary, but is preferably 1 nm or greater and more preferably 10 nm or greater. The thickness is preferably 500 nm or less and more preferably 200 nm or less.

<Gate insulating layer>

In addition to the above form in which the gate insulating layer is formed with block copolymer layer, the gate insulating layer has the following forms.
The gate insulating layer is not particularly limited, as long as the gate insulating layer is a layer having insulating properties, and may be a single layer or multiple layers.
The gate insulating layer is preferably formed of insulating materials. Examples of the insulating materials include an organic polymer and inorganic oxide.
The organic polymer, the inorganic oxide, and the like are not particularly limited, as long as the organic polymer, the inorganic oxide, and the like have insulating properties. It is preferable to form a thin film, for example, a thin film having a thickness of 1 μm or less.
The organic polymer and the inorganic oxide may be used singly, two or more kinds thereof may be used in combination, or an organic polymer and inorganic oxide may be used in combination.
The organic polymer is not particularly limited. Examples thereof include poly(meth)acrylate represented by polyvinyl phenol, polystyrene (PS), and polymethyl methacrylate, a cyclic fluoroalkyl polymer represented by polyvinyl alcohol, polyvinyl chloride (PVC), polyvinylidene fluoride (PVDF), polytetrafluoroethylene (PTFE), and CYTOP (manufactured by Asahi Glass Co., Ltd.), polyorganosiloxane represented by polycycloolefin, polyester, polyethersulfone, polyether ketone, polyimide, an epoxy resin, and polydimethylsiloxane (PDMS), polysilsesquioxane, and butadiene rubber. In addition to the above, examples thereof include a thermosetting resin such as a phenol resin, a novolak resin, a cinnamate resin, an acrylic resin, and a polyparaxylylene resin.
The organic polymer may be used in combination with a compound having a reactive substituent such as an alkoxysilyl group, a vinyl group, an acryloyloxy group, an epoxy group, and a methylol group.
In a case where the gate insulating layer is formed of an organic polymer, for the purpose of increasing solvent resistance and insulation resistance of the gate insulating layer, and the like, it is preferable that an organic polymer is crosslinked and cured. The crosslinking is preferably performed by using light, heat, or both, so as to generate acid or radical.
In a case where crosslinking is performed with a radical, as a radical generating agent that generates radicals by light or heat, for example, thermal polymerization initiators (HI) and photopolymerization initiators (H2) disclosed in [0182] to [0186] of JP2013-214649A, photoradical generating agents disclosed in [0046] to [0051] of JP2011-186069A, photoradical polymerization initiators disclosed in [0042] to [0056] of JP2010-285518A can be suitably used, and the contents thereof are preferably incorporated in the present specification.
The "compound (G) having number-average molecular weight (Mn) of 140 to 5,000, having crosslinking functional groups, and not having a fluorine atom" disclosed in [0167] to [0177] of JP2013-214649A is preferably used, and the contents thereof are preferably incorporated to the present specification.
In a case where crosslinking is performed with acid, as a photoacid generater that generates acid by light, for example, photocationic polymerization initiators disclosed in [0033] and [0034] of JP2010-285518A, acid generators disclosed in [0120] to [0136] of JP2012-163946A can be used, particularly, sulfonium salt and iodonium salt can be preferably used, and the contents thereof are preferably incorporated in the present specification.
As a thermal acid generator (catalyst) that generates acid by heat, for example, thermal cation polymerization initiators and particularly onium salts disclosed in [0035] to [0038] of JP2010-285518A, catalysts disclosed in [0034] and [0035] of JP2005-354012A, particularly, sulfonic acids and sulfonic acid amine salts preferably can be used, and the contents thereof are preferably incorporated to the present specification.
Crosslinking agents, particularly difunctional or higher epoxy compounds and oxetane compounds disclosed in [0032] and [0033] of JP2005-354012A, crosslinking agents, particularly compounds, each of which has two or more crosslinking groups and in which at least one of these crosslinkable groups is a methylol group or a NH group, disclosed in [0046] to [0062] of JP2006-303465A, and compounds, each of which has two or more of hydroxymethyl groups or alkoxymethyl groups in a molecule, disclosed in [0137] to [0145] of JP2012-163946A, are preferably used, and the contents thereof are preferably incorporated in the present specification.
Examples of the method forming a gate insulating layer with an organic polymer include a step of coating and

curing the organic polymer. The coating method is not particularly limited, and examples thereof include the above printing methods. Among these, a wet coating method such as a micro gravure coating method, a dip coating method, a screen coating printing, a die coating method, or a spin coating method is preferable.

The inorganic oxide is not particularly limited, and examples thereof include oxide such as silicon oxide, silicon nitride ($SiN_Y$), hafnium oxide, titanium oxide, tantalum oxide, aluminum oxide, niobium oxide, zirconium oxide, copper oxide, and nickel oxide, perovskite such as $SrTiO_3$, $CaTiO_3$, $BaTiO_3$, $MgTiO_3$, and $SrNb_2O_6$, and composite oxide or mixture of these. Here, examples of silicon oxide include boron phosphorus silicon glass (BPSG), phosphorus silicon glass (PSG), borosilicate glass (BSG), arsenic silicate glass (AsSG), lead silicate glass (PbSG), silicon oxynitride (SiON), spin-on-glass (SOG), low dielectric constant $SiO_2$-based materials (for example, polyaryl ether, cycloperfluorocarbon polymer and benzocyclobutene, cyclic fluororesin, polytetrafluoroethylene, fluoroaryl ether, fluorinated polyimide, amorphous carbon, and organic SOG), in addition to silicon oxide (SiOx).

As the method of forming a gate insulating layer with inorganic oxide, for example, a vacuum film forming method such as a vacuum deposition method, a sputtering method, ion plating, or a chemical vapor deposition (CVD) method can be used, and it is possible to perform assistance from plasma, an ion gun, a radical gun, and the like, by using arbitrary gas at the time of forming a film.

A film may be performed by causing a precursor corresponding to each of the metal oxide, specifically, metal halides such as chlorides or bromides, metal alkoxide, or metal hydroxide, to react with an acid such as hydrochloric acid, sulfuric acid, or nitric acid or a base such as sodium hydroxide or potassium hydroxide in alcohol or water so as to perform hydrolysis. In a case where such a solution-based process is used, a wet-coating method can be used.

In addition to the above method, the gate insulating layer can be prepared by combining any one of a lift-off method, a sol-gel method, an electrodeposition method, and shadow mask method, with a patterning method, if necessary.

The gate insulating layer may be subjected to a surface treatment such as a corona treatment, a plasma treatment, and an ultraviolet (UV)/ozone treatment. However, in this case, it is preferable that surface roughness does not become coarse due to the treatment. The arithmetic average roughness Ra or the root mean square roughness $R_{MS}$ of the gate insulating layer surface is preferably 0.5 nm or less.

In a case where the mixed solution (organic semiconductor composition) containing the specific organic semiconductor compound and the block copolymer is applied to the gate insulating layer, it is preferable that the surface energy of the gate insulating layer is preferably 50 to 75 $mNm^{-1}$, more preferably 60 to 75 $mNm^{-1}$, even more preferably 65 to 75 $mNm^{-1}$, and particularly preferably 70 to 75 $mNm^{-1}$. This is because the carrier mobility is improved accordingly. It is assumed that this is because of the following reasons.

In a case where the mixed solution is applied to the gate insulating layer, it is considered that, while a domain of the specific organic semiconductor compound and a domain of the block copolymer are formed, a speed in a case of forming the domain and a degree of phase separation are influenced by the gate insulating layer which is the base material. At this point, in a case where the surface energy of the gate insulating layer is in the above range, it is considered that the speed in a case of forming the domain and the degree of phase separation work in the direction of improving the carrier mobility.

As the method of adjusting surface energy of the gate insulating layer, an ultraviolet (UV)/ozone treatment is effective, and it is possible to hydrophilize a gate insulating layer surface by appropriately selecting the treatment time. According to the present invention, the surface energy of the gate insulating film can be measured by the above method of measuring the surface energy.

<Organic semiconductor layer>

The organic semiconductor layer is a layer containing the specific organic semiconductor compound and is a layer that can accumulate the carrier. As described above, the specific organic semiconductor compound is an organic semiconductor compound which has a molecular weight of 2,000 or greater and has a repeating unit represented by Formula (1).

The organic semiconductor layer included in the OTFT of the present invention contains at least the specific organic semiconductor compound. However, in a case where the OTFT of the present invention does not have the block copolymer layer, the OTFT necessarily contains the block copolymer, together with the specific organic semiconductor compound.

$$-\!\!\left[D\text{-}A\right]\!\!-\qquad(1)$$

In Formula (1), A represents an electron acceptor unit including a partial structure having at least one of a sp2 nitrogen atom, a carbonyl group, or a thiocarbonyl group in a ring structure.

D represents an electron donor unit including a divalent aromatic heterocyclic group having at least one of a

N atom, an O atom, a S atom, or a Se atom in a ring structure or a divalent aromatic hydrocarbon group consisting of a fused ring structure having two or more rings, as a partial structure.

(Electron acceptor unit ("A" of Formula (1)))

In Formula (1), A represents an electron acceptor unit including a partial structure having at least one of a sp2 nitrogen atom, a carbonyl group, or a thiocarbonyl group in a ring structure.

A preferably has at least one structure selected from the group consisting of structures represented by Formulae (A-1) to (A-12) as a partial structure, and A more preferably has a structure represented by at least one selected from the group consisting of Formulae (A-1) to (A-12).

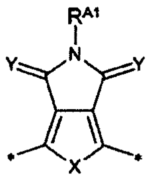
(A-1)

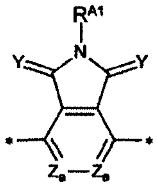
(A-2)

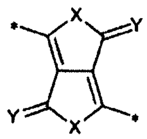
(A-3)

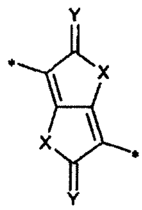
(A-4)

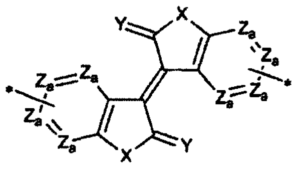
(A-5)

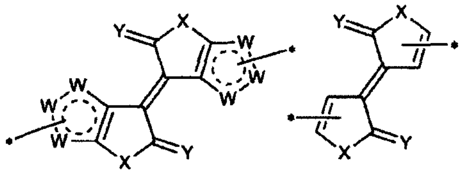
(A-6) (A-7)

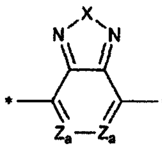
(A-8)

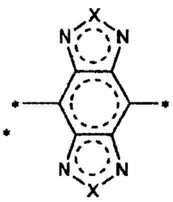
(A-9)

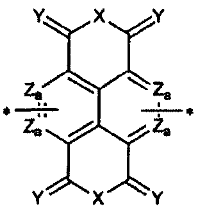
(A-10)

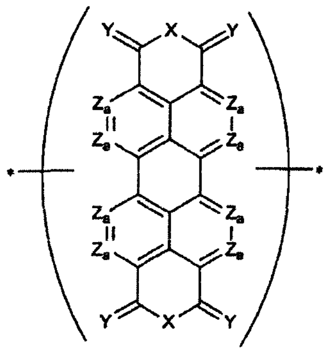
(A-11)

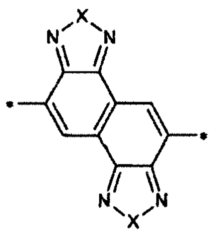
(A-12)

In Formulae (A-1) to (A-12), X's each independently represent an O atom, a S atom, a Se atom, or $NR^{A1}$. Y's each independently represent an O atom or a S atom. $Z_a$'s each independently represent $CR^{A2}$ or a N atom. W's each independently represent $C(R^{A2})_2$, $NR^{A1}$, a N atom, $CR^{A2}$, an O atom, a S atom, or a Se atom. $R^{A1}$'s each independently represent a bonding site to an alkyl group that may include at least one of -O-, -S-, or $-NR^{A3}-$, a monovalent group represented by Formula (1-1), or another structure. $R^{A2}$'s each independently represent a bonding site to an alkyl group that may include at least one of a hydrogen atom, a halogen atom, -O-, -S-, or $-NR^{A3}-$, a monovalent group represented by Formula (1-1), or another structure. $R^{A3}$'s each independently represent a hydrogen atom or a substituent. *'s each independently represent a bonding site to another structure.

In Formulae (A-5) and (A-10), in each of the two ring structures including Za, one of Za's is $CR^{A2}$, and $R^{A2}$ represents a bonding site to another structure. This bonding site to another structure corresponds to * in the formula. Specifically, a bond (hereinafter, simply referred to as a "bond") in which * that represents a bonding site to another structure is positioned at a terminal stretching from any one of $Z_a$'s in each formula, and $Z_a$ to which this bond stretches is $CR^{A2}$ and corresponds to a form in which $R^{A2}$ represents a bonding site to another structure.

In Formula (A-11), two Za's are $CR^{A2}$, and $R^{A2}$ represents a bonding site to another structure. This bonding

site to another structure corresponds to * in the formula.

In Formula (A-6), in each of the two ring structures including W's, one of W's represents at least one of the three following forms.

Form 1: W represents $CR^{A1}$, and $R^{A2}$ represents a bonding site to another structure.

Form 2: W represents $NR^{A1}$, and $R^{A1}$ represents a bonding site to another structure.

Form 3: W represents $C(R^{A2})_2$ and any one of $R^{A1}$'s represents a bonding site to another structure.

$$*\text{-}L_a\text{-}Ar\{L_b)_1 \qquad (1\text{-}1)$$

In Formula (1-1), Ar represents an aromatic heterocyclic group or an aromatic hydrocarbon group having 5 to 18 carbon atoms. $L_a$ represents an alkylene group having 1 to 20 carbon atoms that may include at least one of -O-, -S-, or $-NR^{1S}-$. $L_b$ represents an alkyl group having 1 to 100 carbon atoms that may include at least one of -O-, -S-, or $-NR^{2S}-$. $R^{1S}$ and $R^{2S}$ each independently represent a hydrogen atom or a substituent. 1 represents an integer of 1 to 5. In a case where 1 is 2 or greater, a plurality of $L_b$'s may be identical to or different from each other. * represents a bonding site to another structure.

In Formulae (A-1) to (A-12), X's each independently represent an O atom, a S atom, a Se atom, or $NR^{A1}$, and a S atom or $NR^{A1}$ is preferable.

Y's each independently represent an O atom or a S atom, and an O atom is preferable.

Za's each independently represent $CR^{A2}$ or a N atom, and $CR^{A2}$ is preferable.

W's each independently represent $C(R^{A2})_2$, $NR^{A1}$, a N atom, $CR^{A2}$, an O atom, a S atom, or a Se atom, and $C(R^{A1})_2$, $CR^{A2}$, or a S atom is preferable.

$R^{A1}$'s each independently represent an alkyl group that may contain at least one of -O-, -S-, or $-NR^{A3}-$, a monovalent group represented by Formula (1-1), or a bonding site to another structure, and an alkyl group that may contain at least one of -O-, -S-, or $-NR^{A3}-$ and a monovalent group represented by Formula (1-1) are preferable.

In a case where $R^{A1}$ represents an alkyl group that may contain at least one of -O-, -S-, or $-NR^{A3}-$, an alkyl group having 2 to 30 carbon atoms is preferable, and an alkyl group having 8 to 25 carbon atoms is more preferable. The alkyl group may have a linear shape or a branched shape.

A bonding site to another structure in $R^{A1}$ is a bonding site to another structure represented by * in Formulae (A-1) to (A-12).

$R^{A2}$ each independently represent an alkyl group that may contain at least one of -O-, -S-, or $-NR^{A3}-$, a hydrogen atom, a halogen atom, a monovalent group represented by Formula (1-1), or a bonding site to another structure, and a hydrogen atom or a bonding site to another structure is preferable.

In a case where $R^{A2}$ represents an alkyl group that may contain at least one of -O-, -S-, or $-NR^{A3}-$, an alkyl group having 2 to 30 carbon atoms is preferable, and an alkyl group having 8 to 25 carbon atoms is more preferable. The alkyl group may have a linear shape or a branched shape.

In a case where $R^{A2}$ represents a halogen atom, a F atom, a Cl atom, a Br atom, or an I atom is preferable, and a F atom is more preferable.

A bonding site to another structure in $R^{A2}$ is a bonding site to another structure represented by * in Formulae (A-1) to (A-12).

$R^{A3}$'s each independently represent a hydrogen atom or a substituent. The substituent in $R^{A3}$ has the same meaning as the substituents in $R^{1S}$ and $R^{2S}$ described below.

In Formula (1-1), Ar represents an aromatic heterocyclic group or an aromatic hydrocarbon group having 5 to 18 carbon atoms.

Examples of the aromatic hydrocarbon group having 5 to 18 carbon atoms in Ar include a benzene ring group, a biphenyl group, a naphthalene ring group, and a group obtained by removing two or more hydrogen atoms from aromatic hydrocarbon (for example, a fluorene ring) in which three rings are fused. Among these, in view of the excellent carrier mobility, a benzene ring group, a biphenyl group, or a naphthalene ring group is preferable, and a benzene ring group is preferable.

The aromatic heterocyclic group in Ar may be a single ring or may have a fused ring structure of two or more rings. However, in view of the excellent carrier mobility, the aromatic heterocyclic group is preferably a single ring. The aromatic heterocyclic group in Ar is preferably a 5-membered to 7-membered ring. The hetero atom included in the aromatic heterocyclic group is preferably a N atom, an O atom, a S atom, or a Se atom and more preferably a S atom.

$L_a$ represents an alkylene group having 1 to 20 carbon atoms that may include at least one of -O-, -S-, or $-NR^{1S}-$. Here, the expression that the alkylene group includes -O-, for example, means the case where -O- is introduced in the middle of the carbon-carbon bond of the alkylene group and the case where -O- is introduced at one terminal or both terminals of the alkylene group. The same meaning also applies in a case where the alkylene group includes -S- or $-N^{1S}-$.

An alkylene group that is represented by $L_a$ may have any one of a linear shape, a branched shape, or a cyclic

shape, but is preferably a linear or branched alkylene group.

The number of carbon atoms in the alkylene group represented by $L_a$ is 1 to 20. However, in view of the excellent carrier mobility, the number of carbon atoms is preferably 1 to 15 and more preferably 1 to 10.

In the case where the alkylene group represented by $L_a$ has a branched shape, the number of carbon atoms in the branched portion is included in the number of carbon atoms of the alkylene group represented by $L_a$. However, in a case where $L_a$ contains -NR$^{1S}$- and this R$^{1S}$ includes a carbon atom, the number of carbon atoms in R$^{1S}$ is not included in the number of carbon atoms in the alkylene group represented by $L_a$.

$L_b$ represents an alkyl group having 1 to 100 carbon atoms that may include at least one of -O-, -S-, or -NR$^{2S}$-. Here, the expression that the alkyl group includes -O- means the case where -O- is introduced in the middle of the carbon-carbon bond of the alkyl group and the case where -O- is introduced to one terminal (that is, a portion connected to "Ar" above) of the alkyl group. The same meaning also applies in a case where the alkyl group includes -S- or -N$^{2S}$-.

An alkyl group that is represented by $L_b$ may have any one of a linear shape, a branched shape, or a cyclic shape. However, in view of further excellent carrier mobility and temporal stability under high temperature and high humidity, a linear or branched alkyl group is preferably, and a branched alkyl group is more preferable. The alkyl group represented by $L_b$ may be a halogenated alkyl group having a halogen atom (preferably a F atom, a Cl atom, a Br atom, or an I atom, and more preferably a F atom) as a substituent.

The number of carbon atoms in the alkyl group represented by $L_b$ is 1 to 100 and preferably 9 to 100.

Since carrier mobility becomes excellent, the number of carbon atoms of at least one $L_b$ in -$(L_b)_1$ in Formula (1-1) is preferably 9 to 100, more preferably 20 to 100, and even more preferably 20 to 40.

In the case where the alkyl group represented by $L_b$ has a branched shape, the number of carbon atoms in the branched portion is included in the number of carbon atoms of the alkyl group represented by $L_b$. However, in a case where $L_b$ contains -NR$^{2S}$- and this R$^{2S}$ includes a carbon atom, the number of carbon atoms in R$^{2S}$ is not included in the number of carbon atoms in the alkylene group represented by $L_b$.

R$^{1S}$ and R$^{2S}$ each independently represent a hydrogen atom or a substituent. The substituent represents an alkyl group (preferably a linear or branched alkyl group having 1 to 10 carbon atoms), a halogen atom (preferably a F atom, a Cl atom, a Br atom, or an I atom) or an aryl group (preferably an aryl group having 6 to 20 carbon atoms). Among these, R$^{1S}$ to R$^{2S}$ each independently and preferably represent a hydrogen atom or an alkyl group, and are more preferably an alkyl group.

1 represents an integer of 1 to 5 and is preferably 1 or 2. In a case where 1 is 2 or greater, a plurality of $L_b$'s may be identical to or different from each other.

**[0259]** * represents a bonding site to another structure.

With respect to the specific organic semiconductor compound, A in Formula (1) preferably has at least one structure selected from the group consisting of structures represented by Formulae (A-1) to (A-12) as a partial structure, more preferably has at least one structure selected from the group consisting of structures represented by Formulae (A-1), (A-3), (A-4), (A-5), (A-6), (A-8), (A-10), and (A-12), and (A-12), as a partial structure, even more preferably has at least one structure selected from the group consisting of structures represented by Formulae (A-1), (A-3), (A-5), (A-6), (A-8), and (A-12), as a partial structure, particularly preferably has at least one structure selected from the group consisting of structures represented by Formulae (A-3) and (A-6), as a partial structure, and most preferably has at least one structure selected from the group consisting of structures represented by Formula (A-3), as a partial structure.

The specific organic semiconductor compound is preferably a form in which A in Formula (1) has a structure represented by each formula to a form in which A in Formula (1) has a structure represented by each formula, as a partial structure.

An example of a structure represented by Formulae (A-1) to (A-12) is provided below, but the present invention is not limited thereto. In the following structural formulae, R$^{A1}$ has the same meaning as R$^{A1}$ in Formulae (A-1) to (A-12), preferable forms thereof are also the same.

**[0263]** * represents a bonding site to another structure.

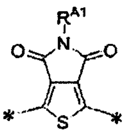 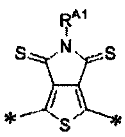 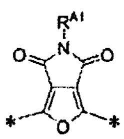 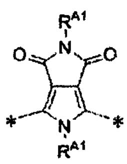 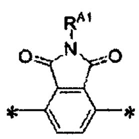 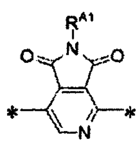 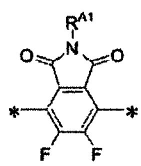

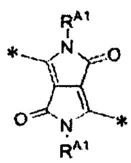 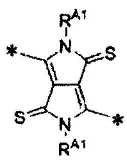 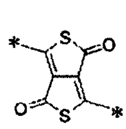 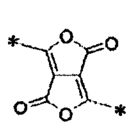 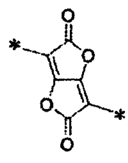 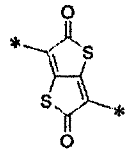 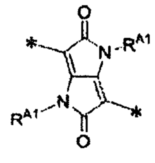

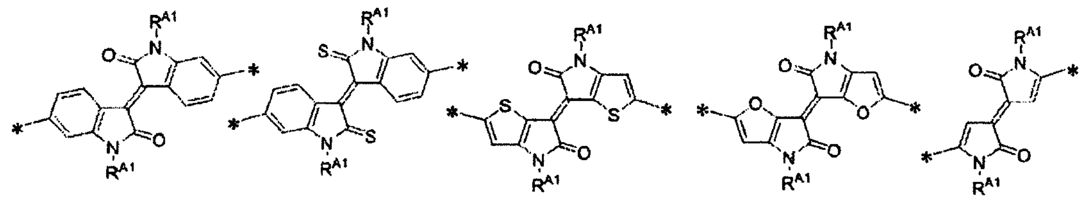

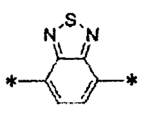 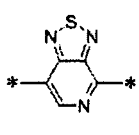 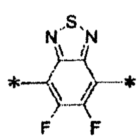 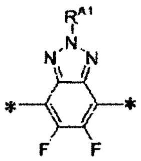 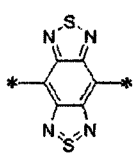 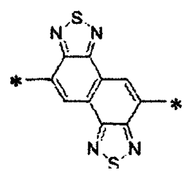

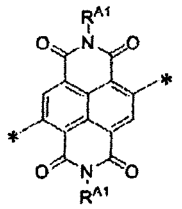 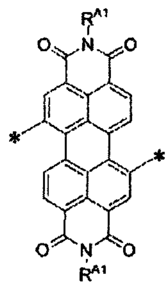

(Electron donor unit ("D" of Formula (1)))

D represents an electron donor unit including a divalent aromatic heterocyclic group having at least one of a N atom, an O atom, a S atom, or a Se atom in a ring structure or a divalent aromatic hydrocarbon group consisting of a fused ring structure having two or more rings, as a partial structure.

The divalent aromatic heterocyclic group having at least one of a N atom, an O atom, a S atom, or a Se atom in a ring structure is preferably a divalent aromatic heterocyclic group having at least one S atom in a ring structure.

The divalent aromatic heterocyclic group may have a single ring or a fused ring structure having two or more rings, and preferably has a structure obtained by combining two or more divalent aromatic heterocyclic groups having single rings or a structure obtained by combining a divalent aromatic heterocyclic group having two or more single rings and a divalent aromatic heterocyclic group having one or more fused ring structures having two or more rings.

The divalent aromatic heterocyclic group may further have a substituent, and preferred examples of the substituents include an alkyl group that may include at least one of -O-, -S-, or -NR$^{D3}$- (for example, an alkyl group having 1 to 30 carbon atoms or an alkoxy group having 1 to 30 carbon atoms is preferable, and an alkyl group having 1 to 20 carbon atoms is more preferable), an alkenyl group (preferably having 2 to 30 carbon atoms), an alkynyl group (preferably having 2 to 30 carbon atoms), an aromatic hydrocarbon group (preferably having 6 to 30 carbon atoms), an aromatic heterocyclic group (preferably a 5-membered to 7-membered ring, and preferably an O atom, a N atom, a S atom, or a Se atom as a hetero atom), a halogen atom (a F atom, a Cl atom, a Br atom, or an I atom is preferable, a F atom or a Cl atom is more preferable, and a F atom is particularly preferable), and a monovalent group represented by Formula (1-1).

R$^{D3}$ has the same meaning as R$^{D3}$ in Formula (D-1), and preferable forms thereof are also the same.

Examples of the divalent aromatic heterocyclic group are provided below, but the present invention is not limited thereto. In the structural formula, the hydrogen atom may be substituted with an alkyl group that may include at least one of -O-, -S-, or -NR$^{D3}$-, an alkenyl group, an alkynyl group, an aromatic hydrocarbon group, an aromatic heterocyclic group, a halogen atom, or a group represented by Formula (1-1), R$^{D1}$ has the same meaning as R$^{D1}$ in Formula (D-1)

described below, the preferable form thereof is also the same, and * represents a bonding site to another structure. An alkyl group that may contain at least one of -O-, -S-, or -$NR^{D3}$- is preferably an alkyl group having 1 to 30 carbon atoms and more preferably an alkyl group having 1 to 20 carbon atoms. $R^{D3}$ has the same meaning as $R^{D3}$ in Formula (D-1), and preferable forms thereof are also the same.

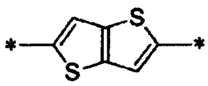
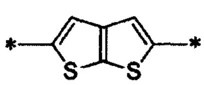
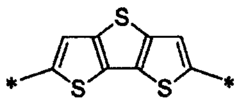
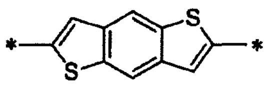

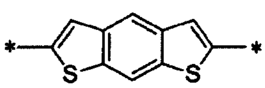
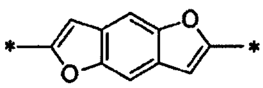
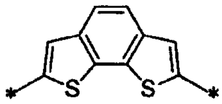
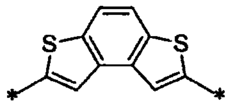

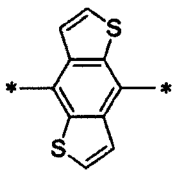
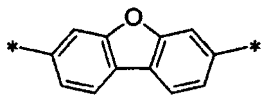
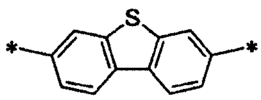

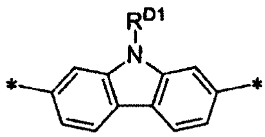
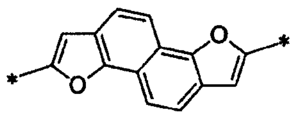
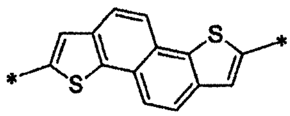

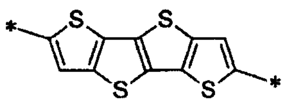
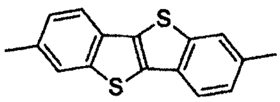
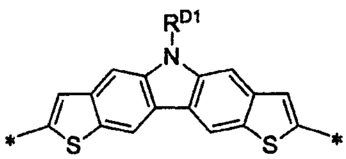

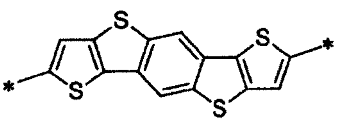
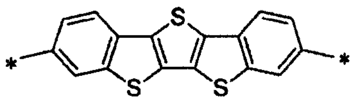
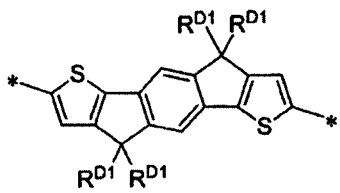

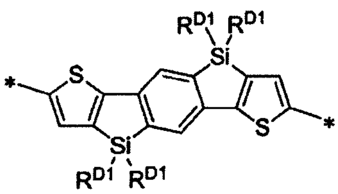
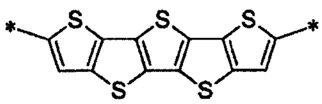
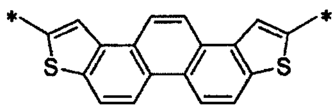

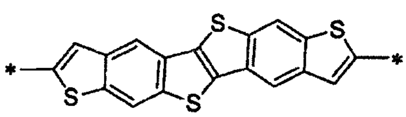
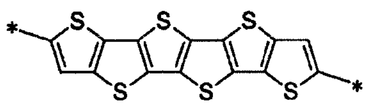

The aromatic hydrocarbon group consisting of a fused ring structure having two or more rings is preferably an aromatic hydrocarbon group having 10 to 20 carbon atoms, more preferably a fluorene group, a naphthylene group, or a group obtained by removing two hydrogen atoms from the aromatic hydrocarbon in which three or four rings are fused, and even more preferably a fluorene group, a naphthylene group, or a group obtained by removing two hydrogen atoms from an anthracene ring, a phenanthrene ring, a chrysene ring, or a pyrene ring.

The aromatic hydrocarbon group may further have a substituent, and preferable examples of the substituent

include an alkyl group that may contain at least one of -O-, -S-, or -$NR^{D3}$-, a halogen atom, or a monovalent group represented by Formula (1-1). Preferable examples of the alkyl group that may contain at least one of -O-, -S-, or -$NR^{D3}$- and the halogen atom are the same as those described for the divalent aromatic heterocyclic group. $R^{D3}$ has the same meaning as $R^{D3}$ in Formula (D-1), and preferable forms thereof are also the same.

In Formula (1), D has preferably a structure represented by Formula (D-1).

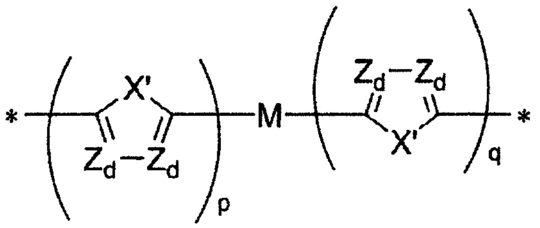

(D-1)

In Formula (D-1), X"s each independently represent an O atom, a S atom, a Se atom, or $NR^{D1}$. $R^{D1}$'s each independently represent a monovalent organic group that may be a monovalent group represented by Formula (1-1). $Z_a$'s each independently represent a N atom or $CR^{D2}$. $R^{D2}$'s each independently represent a hydrogen atom or a monovalent organic group that may be a monovalent group represented by Formula (1-1). M represents a single bond, a divalent aromatic heterocyclic group, a divalent aromatic hydrocarbon group, an alkenylene group, an alkynylene group, or a divalent group obtained by combining these, M may be substituted with an alkyl group that may include at least one of -O-, -S-, or -$NR^{D3}$- or a monovalent group represented by Formula (1-1), $R^{D3}$'s each independently represent a hydrogen atom or a substituent, and p and q each independently represent an integer of 0 to 4, and *'s each independently represent a bonding site to another structure.

In Formula (D-1), each repeating unit and M described above are bonded to each other at the bonding axis in a rotatable manner.

In Formula (D-1), X"s each independently represent an O atom, a S atom, a Se atom, or $NR^{D1}$, preferably an O atom, a Se atom, or a S atom, and more preferably a S atom.

$Z_d$'s each independently represent a N atom or $CR^{D2}$ and more preferably represents $CR^{D2}$.

$R^{D1}$'s each independently represent a monovalent organic group, preferably represents an alkyl group which may contain at least one of -O-, -S-, or -$NR^{D3}$- (for example, an alkyl group having 1 to 30 carbon atoms or an alkoxy group having 1 to 30 carbon atoms is preferable, and an alkyl group having 1 to 20 carbon atoms is more preferable), an alkynyl group (preferably having 1 to 30 carbon atoms), an alkenyl group (preferably having 2 to 30 carbon atoms), an aromatic hydrocarbon group (preferably having 6 to 30 carbon atoms), an aromatic heterocyclic group (preferably 5- to 7-membered ring, O atom, N atom, S atom, Se atom is preferable as the hetero atom), a halogen atom (preferably a F atom, a Cl atom, a Br atom, or an I atom, more preferably a F atom or a Cl atom, and even more preferably a F atom), and a monovalent group represented by Formula (1-1), more preferably represents an alkyl group, a halogen atom, and a monovalent group represented by Formula (1-1).

$R^{D2}$'s each independently represent a hydrogen atom or a monovalent organic group, preferably represents a hydrogen atom, an alkyl group which may contain at least one of -O-, -S-, or -$NR^{D3}$- (for example, an alkyl group having 1 to 30 carbon atoms or an alkoxy group having 1 to 30 carbon atoms is preferable, and an alkyl group having 1 to 20 carbon atoms is more preferable), an alkynyl group (preferably having 2 to 30 carbon atoms), an alkenyl group (preferably having 2 to 30 carbon atoms), an aromatic hydrocarbon group (preferably having 6 to 30 carbon atoms), an aromatic heterocyclic group (preferably 5- to 7-membered ring, O atom, N atom, S atom, Se atom is preferable as the hetero atom), a halogen atom (preferably a F atom, a Cl atom, a Br atom, or an I atom, more preferably a F atom or a Cl atom, and even more preferably a F atom), and a monovalent group represented by Formula (1-1), more preferably represents a hydrogen atom, an alkyl group, a halogen atom, or a monovalent group represented by Formula (1-1).

M represents a single bond, a divalent aromatic heterocyclic group, a divalent aromatic hydrocarbon group, an alkenylene group, an alkynylene group, or a divalent group obtained by combining these. M may be substituted with an alkyl group that may include at least one of -O-, -S-, or -$NR^{D3}$- or a monovalent group represented by Formula (1-1).

The divalent aromatic heterocyclic group in M may have a single ring or may have a fused ring structure having two or more rings. Examples of the divalent aromatic heterocyclic group preferably used in the present invention are the same as those of the above divalent aromatic heterocyclic group having a fused ring structure having two or more rings.

The divalent aromatic hydrocarbon group in M is preferably an aromatic hydrocarbon group having 6 to 20 carbon atoms, more preferably a phenylene group, a biphenylene group, a fluorene group, a naphthylene group, or a group obtained by removing two hydrogen atoms from aromatic hydrocarbon in which three or four rings are fused, and even more preferably a fluorene group, a naphthylene group, an anthracene ring, a phenanthrene ring, a chrysene ring, or a group obtained by removing two or more hydrogen atoms from a pyrene ring.

The divalent aromatic heterocyclic group or the divalent aromatic hydrocarbon group in M may further have a substituent, and preferable examples of the substituents include an alkyl group that may include at least one of -O-, -S-, or -$NR^{D3}$- (for example, an alkyl group having 1 to 30 carbon atoms or an alkoxy group having 1 to 30 carbon atoms is preferable, and an alkyl group having 1 to 20 carbon atoms is more preferable), a halogen atom (preferably a F atom, a Cl atom, a Br atom, or an I atom, more preferably a F atom or a Cl atom, and even more preferably a F atom), and a monovalent group represented by Formula (1-1).

An alkenylene group in M is preferably an alkenylene group having 2 to 10 carbon atoms, more preferably an alkenylene group having 2 to 4 carbon atoms, and even more preferably an ethenylene group.

An alkynylene group in M is preferably an alkynylene group having 2 to 10 carbon atoms, more preferably an alkynylene group having 2 to 4 carbon atoms, and even more preferably an ethynylene group.

$R^{D3}$'s each independently represent a hydrogen atom or a substituent. The substituent in $R^{D3}$ has the same meaning as the substituents in $R^{1S}$ and $R^{2S}$ described below.

p and q each independently represent an integer of 0 to 4, preferably an integer of 1 to 3, and more preferably an integer of 1 to 2. It is preferable that p and q have the same value. It is preferable that p+q is 2 to 4.

Here, in a case where p+q is 0, M preferably includes a divalent aromatic heterocyclic group having at least one of a N atom, an O atom, a S atom, or a Se atom in a ring structure or a divalent aromatic hydrocarbon group including a fused ring structure having two or more rings, as a partial structure.

Examples of the structure represented by D are provided below, but the present invention is not limited to the following examples. In the structural formula, the hydrogen atom may be substituted with an alkyl group that may include at least one of -O-, -S-, or -$NR^{D3}$- or the group represented by Formula (1-1), $R^{D1}$ has the same meaning as $R^{D1}$ in Formula (D-1) described above, the preferable form thereof is also the same, and * represents a bonding site to another structure. The alkyl group that may contain at least one of -O-, -S-, or -$NR^{D3}$-, is preferably an alkyl group having 1 to 30 carbon atoms or an alkoxy group having 1 to 30 carbon atoms and more preferably an alkyl group having 8 to 30 carbon atoms. $R^{D3}$ has the same meaning as $R^{D3}$ in Formula (D-1), and preferable forms thereof are also the same.

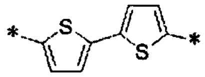 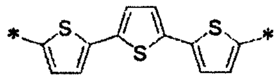 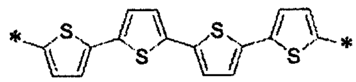

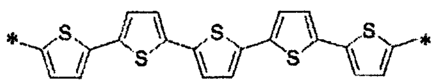 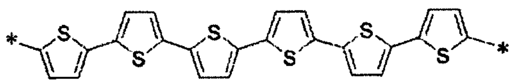

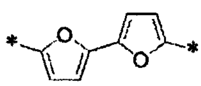 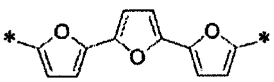 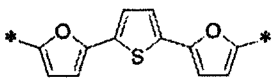 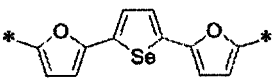

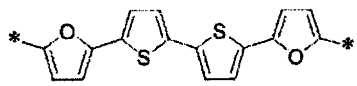 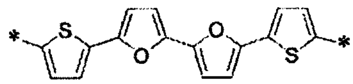

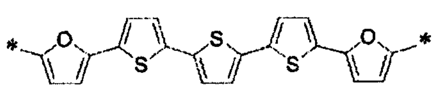 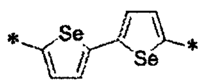 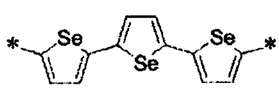

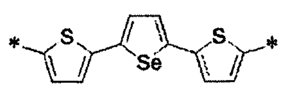 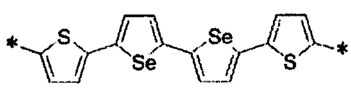 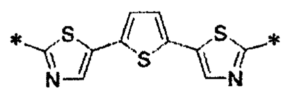

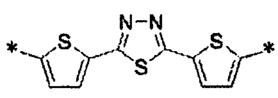 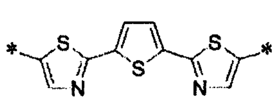 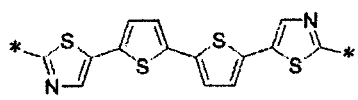

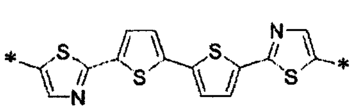 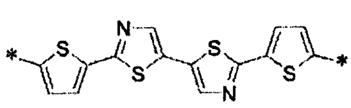 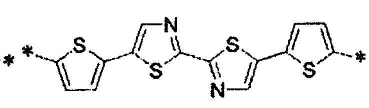

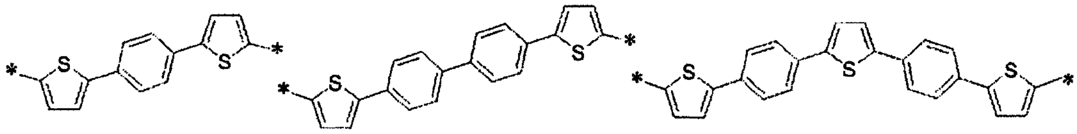

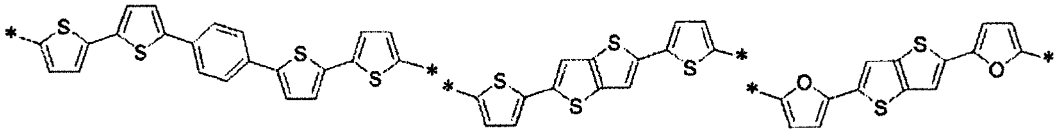

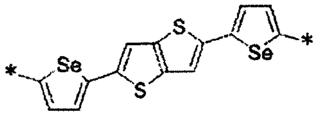

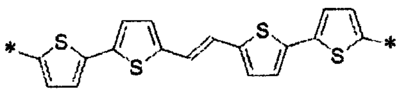

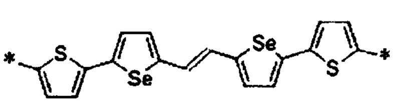

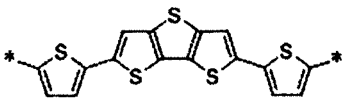

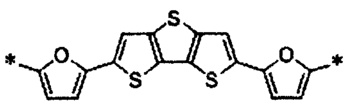

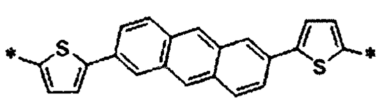

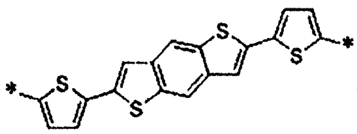

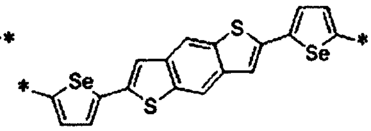

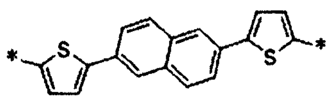

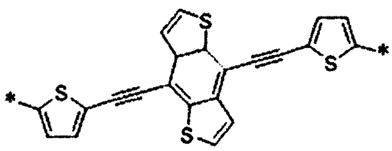

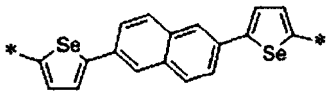

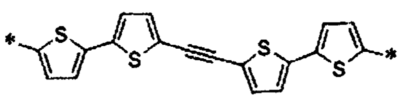

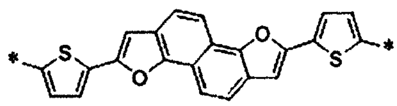

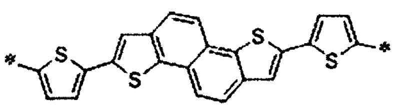

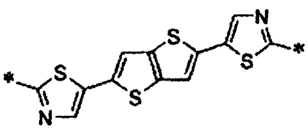

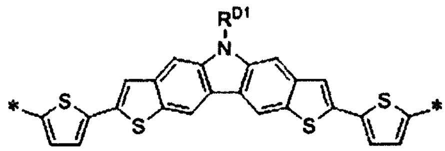
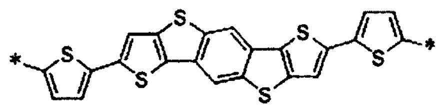
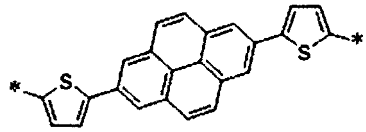
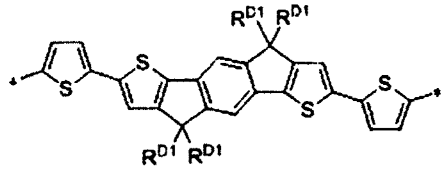
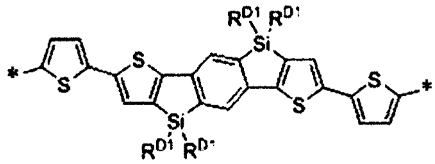
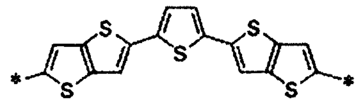
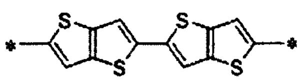
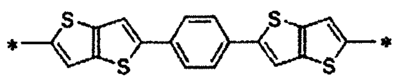
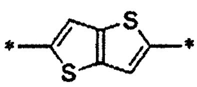
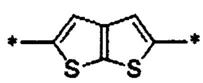
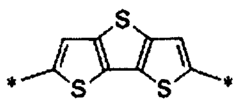
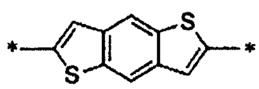
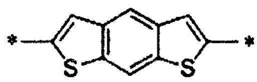
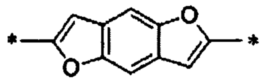
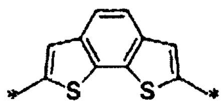
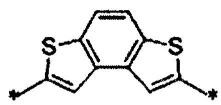
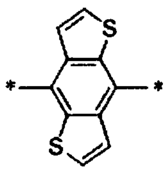
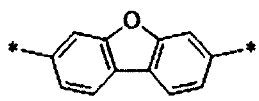
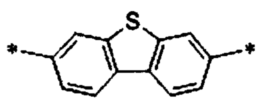
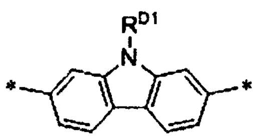
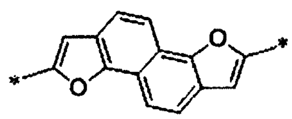
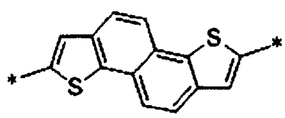
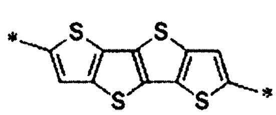
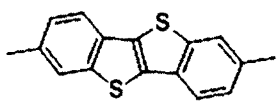
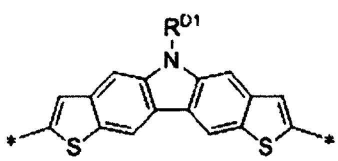

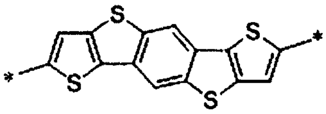
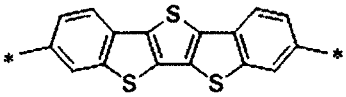
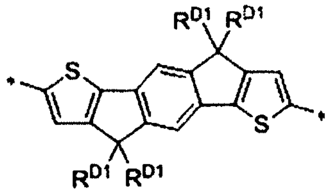
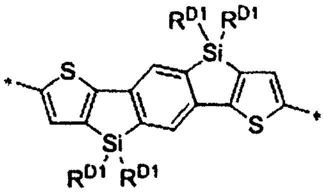
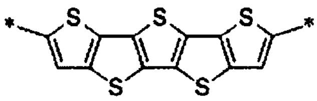
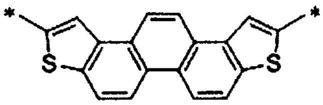
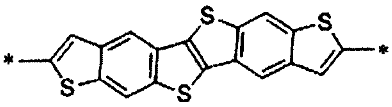
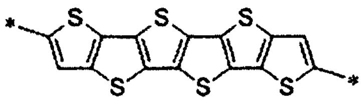

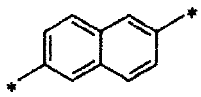
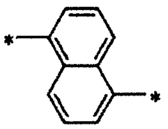
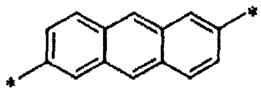
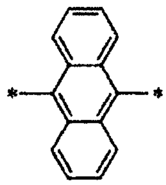

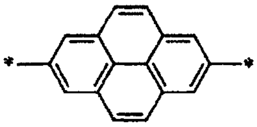
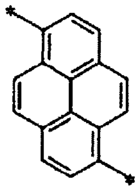

(Repeating unit represented by Formulae (2) to (5))

The repeating unit represented by Formula (1) is preferably a repeating unit represented by any one of Formulae (2) to (5), more preferably a repeating unit represented by Formula (2), (3), or (4), even more preferably a repeating unit represented by any one of Formula (2) or (3), and particularly preferably a repeating unit represented by Formula (3).

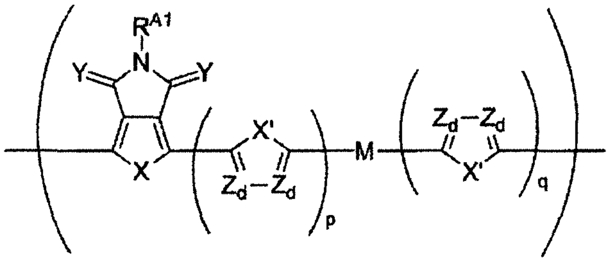
(2)

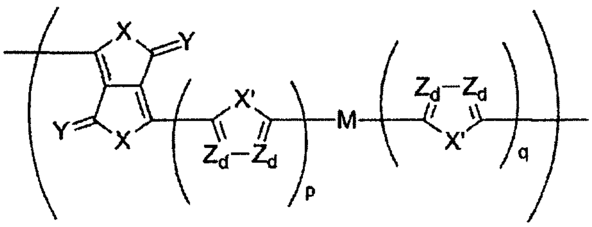
(3)

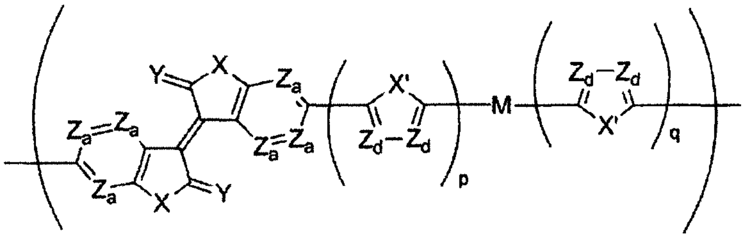 (4)

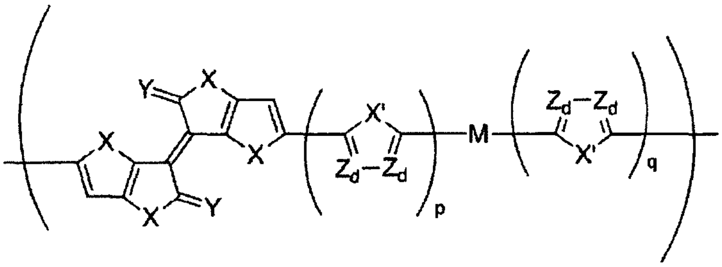 (5)

In Formulae (2) to (5), X's each independently represent an O atom, a S atom, a Se atom, or $NR^{A1}$.

$R^{A1}$'s each independently represent a bonding site to an alkyl group that may include at least one of -O-, -S-, or $-NR^{A3}-$, a monovalent group represented by Formula (1-1), or another structure.

Y's each independently represent an O atom or a S atom.

$Z_a$'s each independently represent $CR^{A2}$ or a N atom. $R^{A2}$'s each independently represent a bonding site to an alkyl group that may include at least one of a hydrogen atom, a halogen atom, -O-, -S-, or $-NR^{A3}-$, or another structure. $R^{A3}$'s each independently represent a hydrogen atom or a substituent. X"s each independently represent an O atom, a S atom, a Se atom, or $NR^{D1}$. $R^{D1}$'s each independently represent a monovalent organic group that may be a monovalent group represented by Formula (1-1). $Z_d$'s each independently represent a N atom or $CR^{D2}$. $R^{D2}$'s each independently represent a hydrogen atom or a monovalent organic group that may be a monovalent group represented by Formula (1-1). M represents a single bond, a divalent aromatic heterocyclic group, a divalent aromatic hydrocarbon group, an alkenylene group, an alkynylene group, or a divalent group obtained by combining these. M may be substituted with an alkyl group that may include at least one of -O-, -S-, or $-NR^{D3}-$ or a monovalent group represented by Formula (1-1). $R^{D3}$'s each independently represent a hydrogen atom or a substituent. p and q each independently represent an integer of 0 to 4.

X, Y, $Z_a$, $R^{A1}$, $R^{A2}$, and $R^{A3}$ in Formulae (2) to (5) are the same as X, Y, $Z_a$, $R^{A1}$, $R^{A2}$, and $R^{A3}$ in Formulae (A-1) to (A-12), and preferably forms thereof are also the same.

X', $Z_d$, $R^{D1}$, $R^{D2}$, $R^{D3}$, M, p, and q in Formulae (2) to (5) are the same as X', $Z_d$, $R^{D1}$, $R^{D2}$, $R^{D3}$, M, p, and q in Formula (D-1), and preferably forms thereof are also the same.

(Preferable forms of specific organic semiconductor compound)

In the specific organic semiconductor compound, the content of the repeating unit represented by Formula (1) is preferably 60 to 100 mass%, more preferably 80 to 100 mass%, and even more preferably 90 to 100 mass% with respect to the total mass of the specific organic semiconductor compound. It is particularly preferable that the constitutional repeating unit is substantially formed only with the repeating unit represented by Formula (1). The expression "the repeating unit is substantially formed only with the repeating unit represented by Formula (1)" means that the content of the repeating unit represented by Formula (1) is 95 mass% or greater, preferably 97 mass% or greater, and more preferably 99 mass% or greater.

In a case where the content of the repeating unit represented by Formula (1) is in the range above, an organic semiconductor layer having excellent carrier mobility can be obtained.

The specific organic semiconductor compound may include a repeating unit represented by Formula (1) singly or two or more kinds thereof may be included.

The specific organic semiconductor compound is a compound having two or more repeating units represented by Formula (1) and may be an oligomer in which the number "n" of repeating units is 2 to 9 or may be a polymer in which the number "n" of constitutional repeating units is 10 or greater. Among these, a polymer in which the number "n" of repeating units is 10 or greater is preferable, in view of carrier mobility and obtainable physical properties of the organic semiconductor layer.

In view of carrier mobility, the molecular weight of the compound having a repeating unit represented by Formula

(1) is 2,000 or greater, preferably 5,000 or greater, more preferably 10,000 or greater, even more preferably 20,000 or greater, and particularly preferably 30,000 or greater. In view of solubility, the molecular weight is preferably 1,000,000 or less, more preferably 300,000 or less, even more preferably 150,000 or less, and particularly preferably 100,000 or less.

According to the present invention, in a case where the specific organic semiconductor compound has a molecular weight distribution, the molecular weight of this compound means a weight-average molecular weight.

According to the present invention, the weight-average molecular weight and the number-average molecular weight of the specific organic semiconductor compound can be measured by gel permeation chromatography (GPC) method, and can be obtained in terms of standard polystyrene. Specifically, for example, GPC is performed by using HLC-8121GPC (manufactured by Tosoh Corporation), using two items of TSKgel GMHHR-H (20) HT (manufactured by Tosoh Corporation, 7.8 mmID×30 cm) as columns, and using 1,2,4-trichlorobenzene as an eluant. GPC is performed by using an infrared (IR) detector under the conditions in which the sample concentration is 0.02 mass%, the flow rate is 1.0 ml/min, the sample injection amount is 300 μl, and the measurement temperature is 160°C. The calibration curve is manufactured from 12 samples of "standard sample TSK standard, polystyrene": "F-128", "F-80", "F-40", "F-20", "F-10", "F-4", "F-2", "F-1", "A-5000", "A-2500", "A-1000", and "A-500" manufactured by Tosoh Corporation.

Although only one kind of specific organic semiconductor compound may be contained or two or more kinds of specific organic semiconductor compounds may be contained in the organic semiconductor layer.

The structure of the terminal of the specific organic semiconductor compound is not particularly limited, and depends on the existence of other constitutional units, kinds of base substances used in the synthesis, and kinds of a quench agent (reaction terminator) used in the synthesis. Here, examples thereof include a hydrogen atom, a hydroxyl group, a halogen atom, an ethylenically unsaturated group, an alkyl group, an aromatic heterocyclic group (preferably a thiophene ring), and an aromatic hydrocarbon group (preferably a benzene ring).

A method of synthesizing a specific organic semiconductor compound is not particularly limited, and may be synthesized with reference to well-known methods. For example, with reference to JP2010-527327A, JP2007-516315A, JP2014-515043A, JP2014-507488A, JP2011-501451A, JP2010-18790A, WO2012/174561A, JP2011-514399A, and JP2011-514913A, synthesis may be performed by synthesizing a precursor of an electron acceptor unit and a precursor of an electron donor unit and performing cross-coupling reactions such as Suzuki coupling and Stille coupling of each precursor.

Hereinafter, preferable specific examples of the preferable repeating unit represented by Formula (1) are provided, but the present invention is not limited to the examples below.

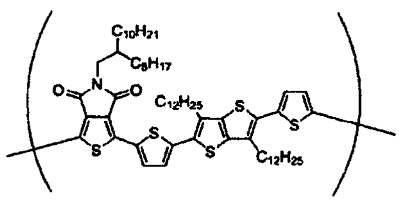

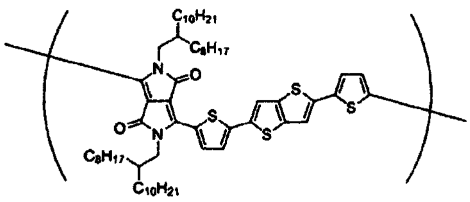

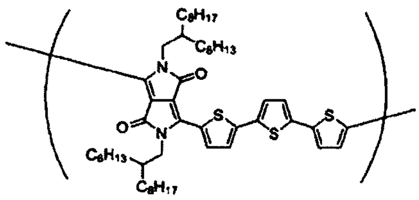

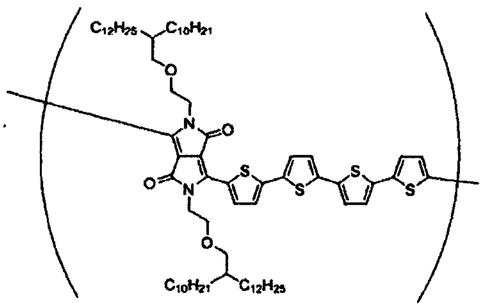

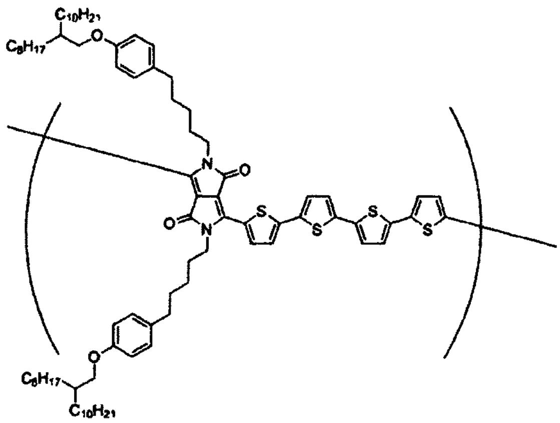

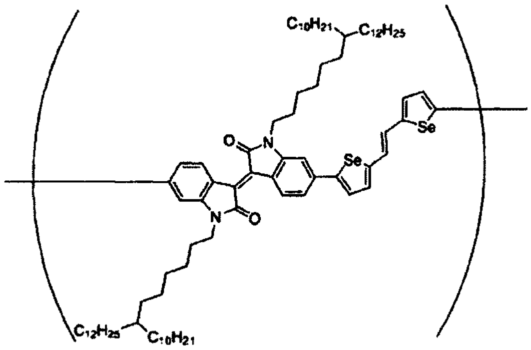

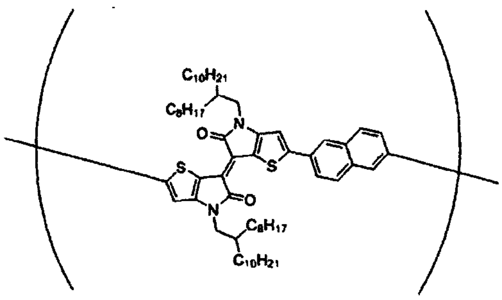

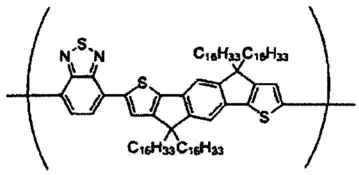

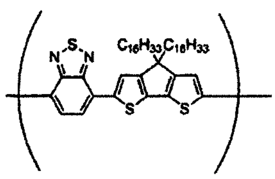

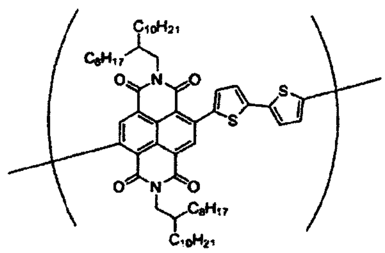

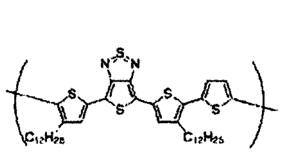

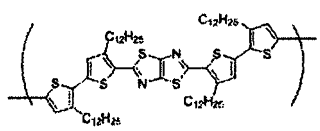

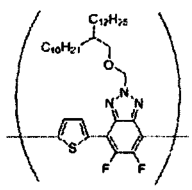

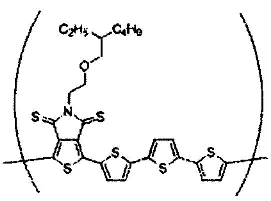

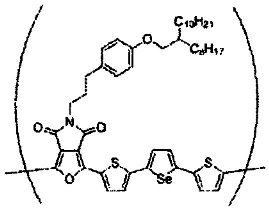

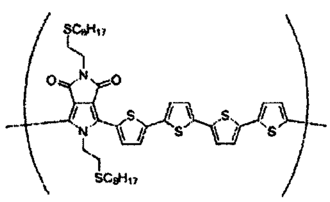

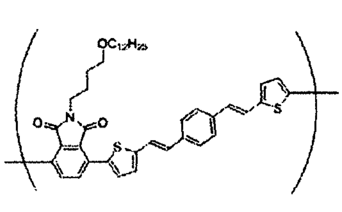

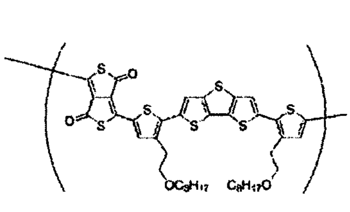

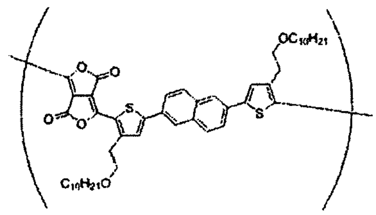

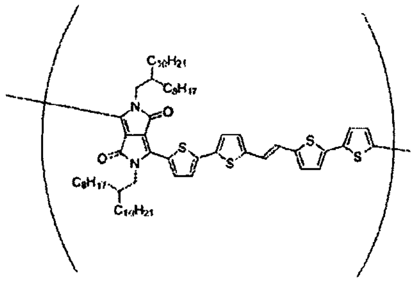

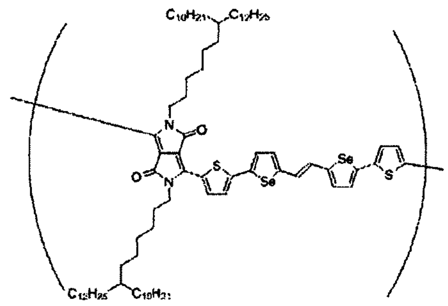

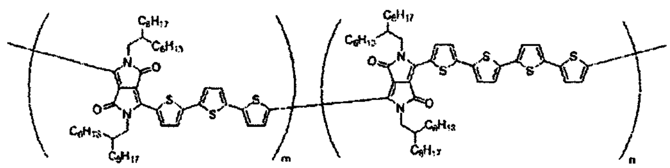

m/n=0.2/0.8
random copolymer

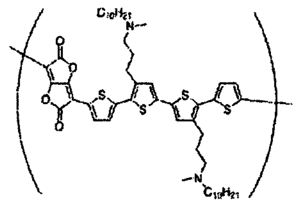

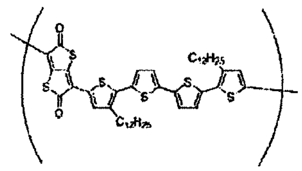

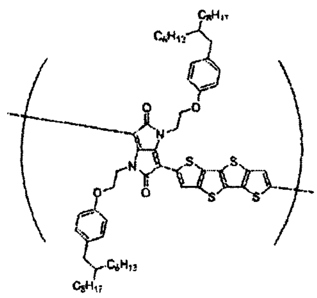

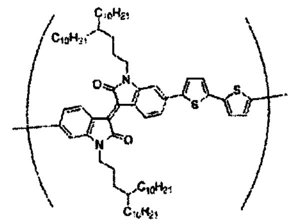

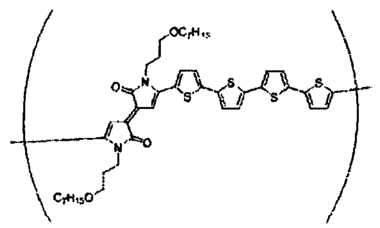

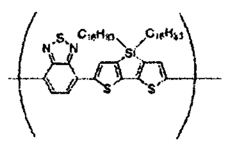

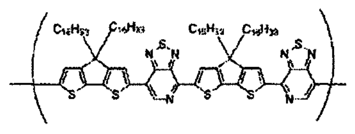

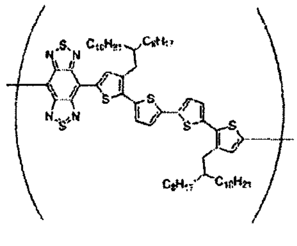

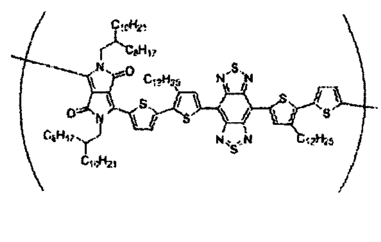

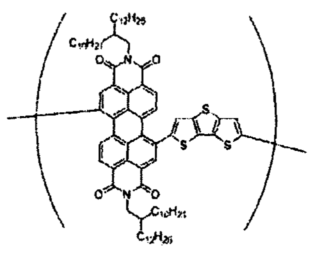

<Source electrode and drain electrode>

In the OTFT of the present invention, the source electrode is an electrode to which a current flows from the outside through wiring. The drain electrode is an electrode which sends a current to the outside through wiring and is generally provided to be in contact with the organic semiconductor layer.
As the material of the source electrode and the drain electrode, a conductive material that is used for the organic thin film transistor in the related art, and examples thereof include the conductive material described in the gate electrode.
The source electrode and the drain electrode each can be formed by the same method as the method of forming the gate electrode.
As the photolithography method, a lift-off method or an etching method can be employed.
Particularly, since the gate insulating layer has excellent resistance to an etchant or a peeling solution, the source electrode and the drain electrode can be suitably formed by an etching method. The etching method is a method of forming a film with a conductive material and removing unnecessary portions by etching. In a case where patterning is performed by an etching method, a resist residue and a removed conductive material obtained by peeling of the conductive material remaining on the base material in a case of resist removal can be prevented from re-adhering to the substrate, and a shape of the electrode edge portion is excellent. In this point of view, a lift-off method is preferable.
The lift-off method is a method of applying a resist to a portion of the base material, forming a film with a conductive material on the base material, eluting or peeling off the resist or the like with a solvent so as to remove the conductive material on the resist, and thus form a film of the conductive material only in a portion to which the resist is not applied.
The thickness of the source electrode and the drain electrode is arbitrary, but is preferably 1 nm or greater and more preferably 10 nm or greater. The thickness is preferably 500 nm or less and more preferably 300 nm or less.
An interval (channel length) between the source electrode and the drain electrode is arbitrary, but is preferably 100 μm or less and more preferably 50 μm or less. The channel width is preferably 5,000 μm or less and more preferably 1,000μm or less.

<Overcoat layer>

The OTFT of the present invention may have an overcoat layer. The overcoat layer is generally a layer formed as a protective layer on the surface of the OTFT. The overcoat layer may have a single layer structure or a multilayer structure.
The overcoat layer may be an organic overcoat layer or may be an inorganic overcoat layer.
The material for forming the organic overcoat layer is not particularly limited, but examples thereof include polystyrene, an acrylic resin, polyvinyl alcohol, polyolefin, polyimide, polyurethane, polyacetylene, an organic polymer such as an epoxy resin, and derivatives obtained by introducing a crosslinking group, a water repellent group, or the like into these organic polymers. These organic polymers or derivatives thereof can be used in combination with a crosslinking component, a fluorine compound, a silicon compound, or the like.
The material for forming the inorganic overcoat layer is not particularly limited, but examples thereof include metal oxide such as silicon oxide and aluminum oxide and metal nitride such as silicon nitride.
These materials may be used singly or two or more kinds thereof may be used together in an arbitrary combination and ratio.
The method of forming the overcoat layer is not limited, and the overcoat layer can be formed by various well-known methods.
For example, the organic overcoat layer can be formed, for example, by a method of applying a solution including a material to be the overcoat layer to a layer to be a base material thereof and drying the solution, and a method of applying a solution including a material to be the overcoat layer, drying the solution, and performing patterning by exposure and development. The patterning of the overcoat layer can be directly formed by a printing method or an ink jet method. After the patterning of the overcoat layer, the overcoat layer may be crosslinked by exposure or heating.
The inorganic overcoat layer can be formed by a dry method such as a sputtering method and an evaporation method and a wet method such as a sol-gel method.

<Other layers>

The OTFT of the present invention may be provided with a layer or a member, in addition to the above.
Examples of the other layers or members include a bank. The bank is used for the purpose of blocking the discharged liquid at a predetermined position in a case where a semiconductor layer, an overcoat layer, or the like is formed by an ink jet method or the like. Therefore, the bank usually has liquid repellency. Examples of the method of forming the bank include a method of performing a liquid repellent treatment such as a fluorine plasma method after

patterning by a photolithography method or the like and a method of curing a photosensitive composition containing a liquid repellent component such as a fluorine compound.

In a case where the gate insulating layer is an organic layer in the organic thin film transistor of the present invention, the latter method of curing the photosensitive composition containing the liquid repellent component is preferable because it is less likely that the gate insulating layer is affected by the liquid repellent treatment. A technique of causing the base material to have the liquid repellency contrast and to have a function of the bank without using the bank may be used.

<Manufacturing method>

The method (hereinafter, referred to as the method of the present invention) of manufacturing the organic thin film transistor is not particularly limited, but preferably has a form (hereinafter, referred to as a "first manufacturing method") including a step of applying a mixed solution containing the specific organic semiconductor compound and the block copolymer or a form (hereinafter, referred to as a "second manufacturing method") of including a step of applying a coating solution including the specific organic semiconductor compound and a step of applying a coating solution including the block copolymer.

In the first manufacturing method, for example, the block copolymer can be self-assembled by forming a film by applying the mixed solution containing the specific organic semiconductor compound and the block copolymer on the substrate 6 or the gate insulating layer 2, and preferably performing the heat treatment to this film.

The specific organic semiconductor compound and the block copolymer can be phase-separated or unevenly distributed by this film formation, and the uneven distribution of the specific organic semiconductor compound can be promoted by further self-assemblage of the block copolymer.

The organic semiconductor layer (organic semiconductor film) including the specific organic semiconductor compound and the block copolymer can be obtained by using the mixed solution (organic semiconductor composition) containing the specific organic semiconductor compound and the block copolymer.

In this manner, in a case where the specific organic semiconductor compound and the block copolymer are caused to exist together in the organic semiconductor layer, the carrier mobility of the organic thin film transistor can be effectively increased. The reason is not clear, but it is considered that one reason is that, in a case where the organic semiconductor compound and the block copolymer exist together, compared with a case where the organic semiconductor compound singly exists, array regularity of the organic semiconductor compound is enhanced. It is presumed that, carrier diffusion generated due to fluctuation of the structure in the main chain of the organic semiconductor compound is suppressed according to this increase of the array regularity, or popping of carriers between chains of the organic semiconductor compound is improved.

The reason of improving array regularity is presumed as follows. That is, in a state of the mixed solution (organic semiconductor composition) in which the specific organic semiconductor compound and the block copolymer exist together, both exist in state in which both are suitably compatible with each other, such that, in a case where both are dried and the state is changed to a film state, the phase separation is promoted, and a domain of the specific organic semiconductor compound and a domain of the block copolymer are separately formed. It is considered that the speed in a case of forming these domains and the degree of phase separation are related to the control of the array regularity, and it is considered that the combination of the specific organic semiconductor compound and the block copolymer is suitable and thus the mobility is improved.

The second manufacturing method can be performed, for example, as follows. The coating solution including the block copolymer is applied to the substrate 1 or the gate insulating layer 2, and a heat treatment is preferably performed on the film (block copolymer layer), so as to form a block copolymer layer obtained by self-assemblage of the block copolymer. Subsequently, the coating solution including the specific organic semiconductor compound is applied to the block copolymer layer, so as to form the organic semiconductor layer 1 on the block copolymer layer.

In this manner, it is considered that the surface of the gate insulating layer becomes hydrophobic or the unevenness on the surface becomes homogeneous by the block copolymer layer, and it is presumed that the alignment properties (edge-on alignment properties) of the specific organic semiconductor compound included in the organic semiconductor layer 1 are improved, and thus carrier mobility is improved.

The mixed solution and the respective coating solutions may contain other components in addition to the specific organic semiconductor compound and the block copolymer. Examples thereof include the resin including the copolymer, a self-assembled compound such as a silane coupling agent, and a surfactant, in addition to the block copolymer.

The mixed solution and the respective coating solutions preferably contain a solvent. This solvent is not particularly limited, as long as the specific organic semiconductor compound and the block copolymer can be dissolved or dispersed in the solvent. Examples thereof include an organic solvent, water, and a mixed solvent thereof.

Specific examples of the organic solvent are as described above, and the description thereof is omitted.

All of the total solid content concentrations of the mixed solution and the respective coating solutions are

preferably 0.01 to 20 mass%, more preferably 0.1 to 10 mass%, and even more preferably 0.2 to 5 mass%.

The content of the block copolymer in the coating solution (or the mixed solution) is preferably 1 to 80 mass%, more preferably 5 to 60 mass%, and even more preferably 10 to 50 mass% with respect to the total solid content of the coating solution (or the mixed solution).

The content of the specific organic semiconductor compound in the coating solution (or the mixed solution) is preferably 20 to 99 mass%, more preferably 40 to 95 mass%, and even more preferably 50 to 90 mass% with respect to the total solid content of the coating solution (or the mixed solution).

The method of applying the mixed solution and the coating solution is not particularly limited, and the above method can be employed. Among these, a printing method is preferable, and a flexo printing method or a spin coating method is more preferable.

The coating condition is not particularly limited. The coating may be performed near the room temperature, and the coating may be performed in a heated state in order to add solubility of the respective components to the coating solvent. The heating temperature is preferably 15°C to 150°C, more preferably 15°C to 100°C, even more preferably 15°C to 50°C, and particularly preferably near room temperature (20°C to 30°C).

In the spin coating method, it is preferable to set the rotation speed to 100 to 3,000 rpm.

In the method according to the present invention, the applied coating solution and the applied mixed solution are preferably dried. The drying condition may be a condition of volatilizing or removing the solvent, and examples thereof include methods such as room temperature standing, heat drying, blast drying, and drying under reduced pressure.

According to the method of the present invention, it is preferable that the phase separation is performed by self-assemblage of the block copolymer, by heating the organic semiconductor layer containing the block copolymer and the specific organic semiconductor compound or the block copolymer layer containing the block copolymer. It is preferable that the heating is performed at the temperature of the glass transition temperature of the block copolymer or higher. It is preferable that the heating annealing is performed at the thermolysis temperature of the block copolymer or lower. The heating temperature is preferably 50°C to 250°C, more preferably 60°C to 200°C, and even more preferably 80°C to 160°C. The heating time is preferably 1 second to 10 hours and more preferably 1 minute to 2 hours.

In the present invention, in addition to heating annealing, solvent annealing or the like which is exposed to solvent vapor or the like can be employed.

It is preferable that this block copolymer is subjected to the lamellar phase separation in the thickness direction of the organic semiconductor layer. The lamellar phase separation can be performed by causing the composition of the block unit in the block copolymer to be in the above preferable range.

In a case where the block copolymer is phase-separated, in the organic semiconductor layer containing the block copolymer and the specific organic semiconductor compound, the specific organic semiconductor compound is unevenly distributed, by a phase formed by each block of the block copolymer, and thus, the separation (unevenly distribution) between the block copolymer and the specific organic semiconductor compound is promoted.

The gate electrode, the gate insulating layer, the source electrode, and the drain electrode can be formed or provided by the above method.

<Application of OTFT>

The OTFT of the present invention is preferably mounted on the display panel and used. Examples of the display panel include a liquid crystal panel, an organic EL panel, and an electronic paper panel.

Examples

Hereinafter, the present invention is specifically described with reference to examples. However, the present invention is not limited thereto.

<Block copolymer>

As block copolymers for forming block copolymer layers, P-1 to P-8 were prepared as below.

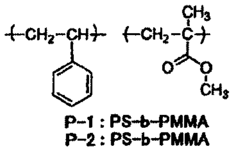

P-1 : PS-b-PMMA
P-2 : PS-b-PMMA

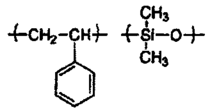

P-3: PS-b-PDMS

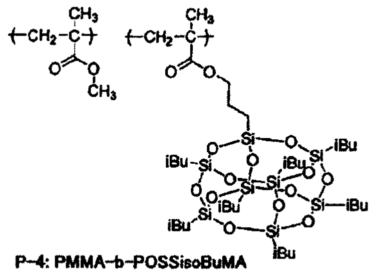

P-4: PMMA-b-POSSisoBuMA

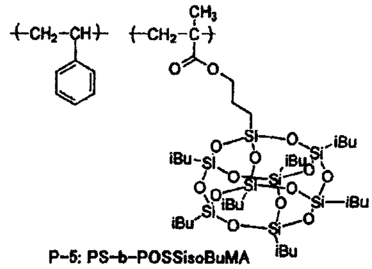

P-5: PS-b-POSSisoBuMA

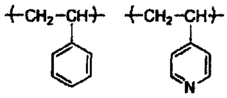

P-6: PS-b-P4VP

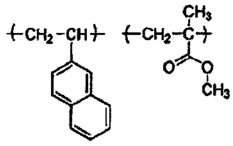

P-7: PVNp-b-PMMA

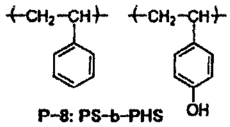

P-8: PS-b-PHS

P-1: PS-b-PMMA manufactured by Polymer Source Inc. (Catalog No. P4961)
Mn 25,000 of polystyrene (PS)
Mn 26,000 of polymethyl methacrylate (PMMA)
Dispersion degree of 1.06
P-2: PS-b-PMMA manufactured by Polymer Source Inc. (Catalog No. P4418)
Mn 18,500 of PS
Mn 18,000 of PMMA
Dispersion degree of 1.06
P-3: PS-b-PDMS manufactured by Polymer Source Inc. (Catalog No. P8709)
Mn 22,000 of PS
Mn 21,000 of polydimethyl siloxane (PDMS)
Dispersion degree of 1.08
P-4: PMMA-b-POSS isoBuMA
manufactured by Polymer Source Inc. (Catalog No. P9793)
Mn 22,000 of PMMA
Mn 22,500 of POSS isoBuMA
Dispersion degree of 1.10
P-5: PS-b-POSS isoBuMA
manufactured by Polymer Source Inc. (Catalog No. P14022)
Mn 6,000 of PS
Mn 23,000 of POSS isoBuMA
Dispersion degree of 1.6
P-6: PS-b-P4VP
manufactured by Polymer Source Inc. (Catalog No. P9892)
Mn 195,000 of PS
Mn 204,000 of poly(4-vinylpyridine) (P4VP)
Dispersion degree of 1.09
P-7: PVNp-b-PMMA
manufactured by Polymer Source Inc. (Catalog No. P3400)
Mn 61,000 of polyvinyl naphthalene (PVNp)
Mn 68,000 of PMMA
Dispersion degree of 1.15
P-8: PS-b-PHS
manufactured by Polymer Source Inc. (Catalog No. P8616)
Mn 9,000 of PS
Mn 6,000 of polyhydroxystyrene (PHS)
Dispersion degree of 1.12

As the block copolymer for forming the block copolymer layer, BP-1, BP-4, BP-5, BP-6, and CBP-2 were synthesized in the general method.

BP-1

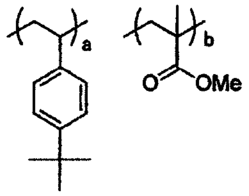

(BP-1 ): a=47wt%, b=53wt%, Mn=19700, Mw/Mn=1.05

BP-4

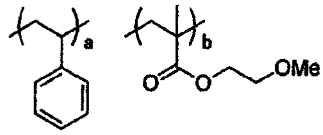

(BP-4 ): a=45wt%, b=55wt%, Mn=18000 Mw/Mn=1.07

BP-5

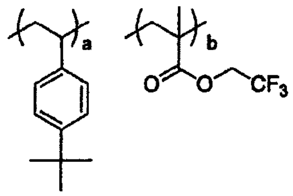

(BP-5 ): a=51wt%, b=49wt%, Mn=17600, Mw/Mn=1.11

BP-6

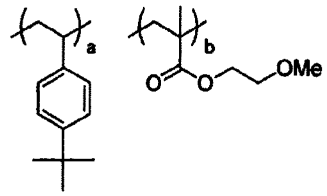

(BP-6 ): a=48wt%, b=52wt%, Mn=18000, Mw/Mn=1.08

CBP-2

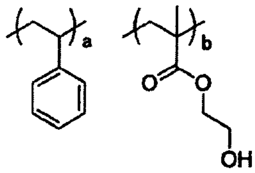

(CBP-2 ): a=47wt%, b=53wt%, Mn=18200, Mw/Mn=1.11

As block copolymers for forming block copolymer layers, block polymers BBP-1 and BBP-2 having the repeating units containing crosslinkable groups were synthesized by the general method. In BBP-1, a structural component in which the content in the copolymer was indicated as b1, and a structural component in which the content in the copolymer was indicated as b2 formed a random polymer by randomly connecting the both at a molar ratio of 10:1, and this random polymer formed one block. This is the same as in BBP-2.

BBP-1

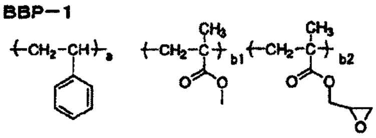

(BBP-1): a=49wt%, b1+b2=51wt%, b1:b2=10:1, Mn=40000, Mw/Mn=1.09

BBP-2

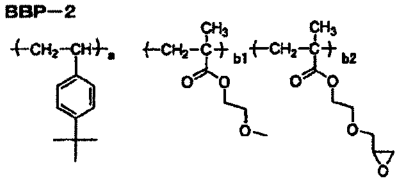

(BBP-1): a=49wt%, b1+b2=51wt%, b1:b2=10:1, Mn=17200, Mw/Mn=1.10

<Organic semiconductor compound>

Subsequently, the organic semiconductor compounds used in the respective examples are provided below (Compounds (1) to (10) and Comparative Compounds P3HT and TIPS-PEN).

Comparative Compound P3HT represents poly(3-hexylthiophene-2,5-diyl) manufactured by Sigma-Aldrich Japan K.K. Comparative Compound TIPS-PEN represents TIPS PENTACENE (6,13-bis(triisopropylsilylethynyl) pentacene) manufactured by Sigma-Aldrich Japan K.K.

Compounds (1) to (3) and (6) to (10) were synthesized in the method of synthesizing a well-known D-A-type π conjugated polymer.

The method of synthesizing Compounds (4) and (5) is provided below.

<Synthesis of Compound (4)>

Compound (4) was synthesized in the following scheme.

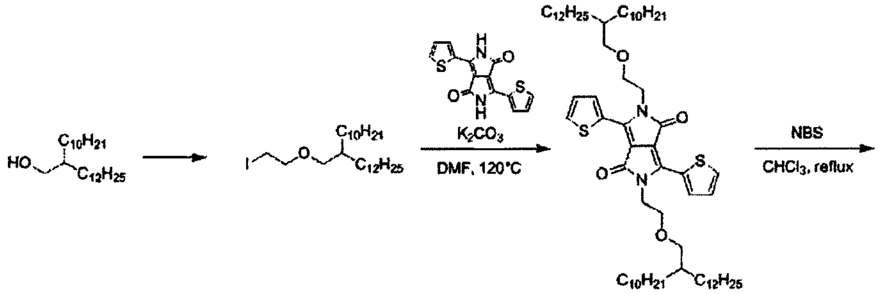


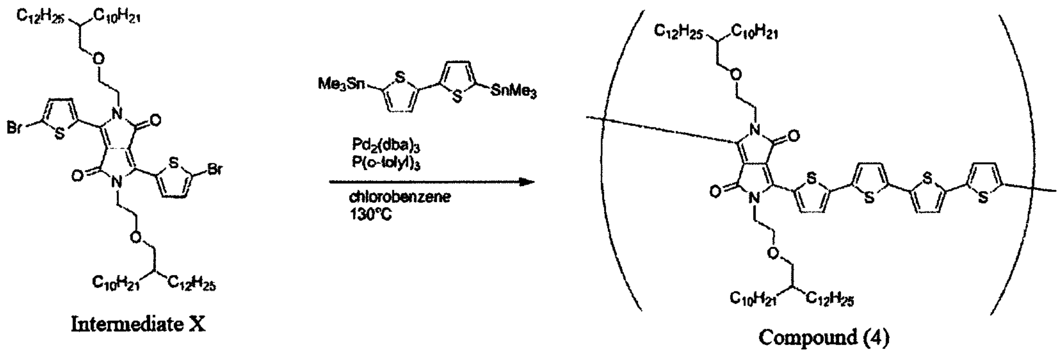


Intermediate X

Compound (4)

Intermediate X which is a monomer was synthesized with reference to Tetrahedron, 2010, 66, 3173 and Organic Electronics, 2011, 12, 993.

Synthesis Intermediate X (244 mg, 200 mmol), 5,5'-bis(trimethylstannyl)-2,2'-bithiophene (98.4 mg, 200 mmol), tri(o-tolyl) phosphine (9.8 mg, 32 mmol), tris(dibenzylideneacetone) dipalladium (3.7 mg, 4 mmol), and dehydrated chlorobenzene (17 mL) were mixed and stirred at 130°C for 24 hours under nitrogen atmosphere. After the reaction liquid was cooled to room temperature, the reaction liquid was poured to a methanol (240 mL)/concentrated hydrochloric acid (10 mL) mixed solution, and stirring was performed for two hours. After the precipitate was filtered and washed with methanol, soxhlet extraction was performed sequentially with methanol, acetone, and ethyl acetate, so as to remove soluble impurities. Subsequently, soxhlet extraction was performed with chloroform, and the obtained solution was subjected to vacuum concentration, methanol was added, the precipitated solid content was filtrated and washed with methanol, and vacuum drying was performed at 80°C for 12 hours, so as to obtain 201 mg of Compound (4) (yield: 82%).

The number-average molecular weight in terms of polystyrene was $2.4\times10^4$, and the weight-average molecular weight thereof was $7.5\times10^4$.

<Synthesis of Compound (5)>

Compound (5) was synthesized in the following scheme.

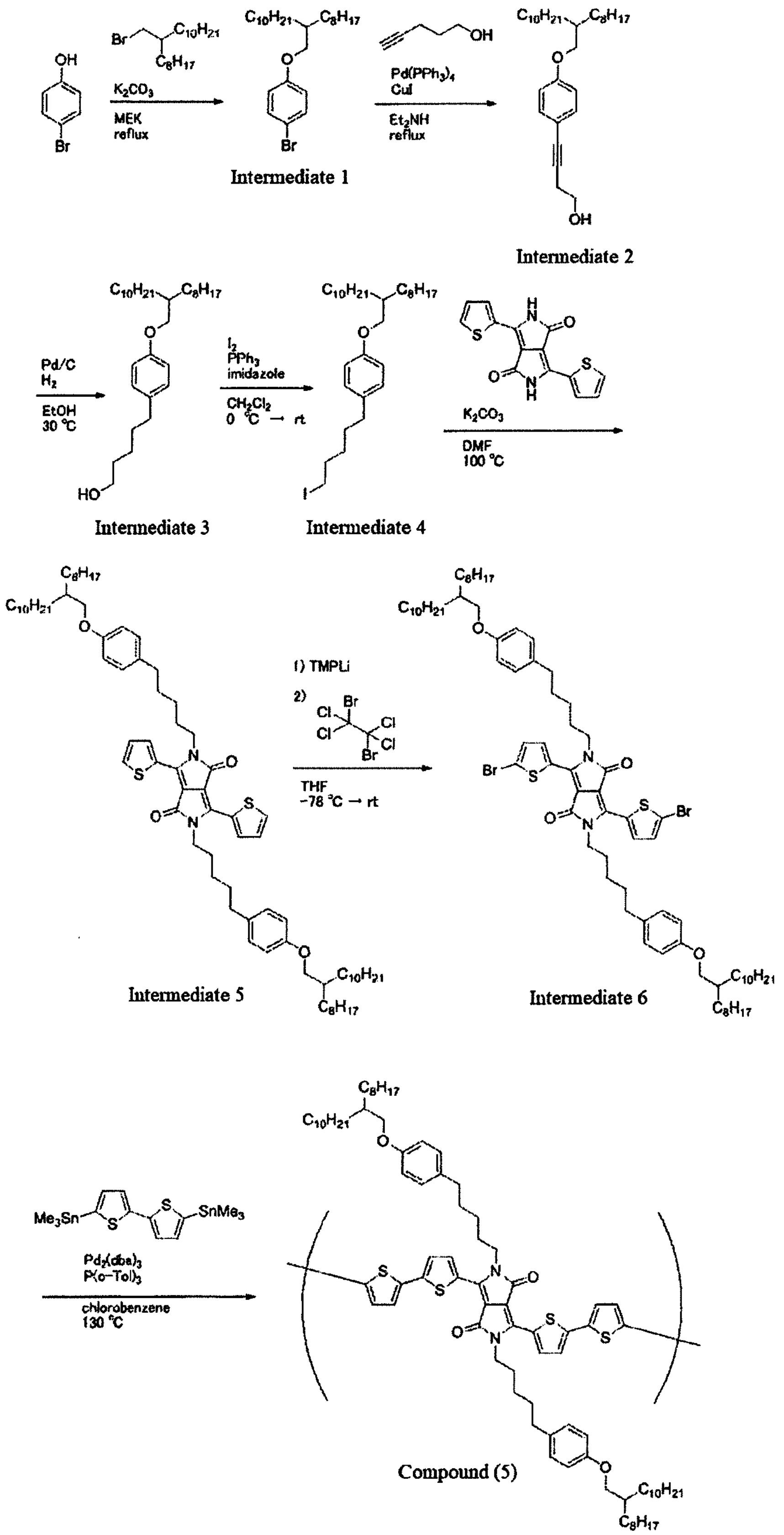


Intermediate 1

Intermediate 2

Intermediate 3

Intermediate 4

Intermediate 5

Intermediate 6

Compound (5)

(Synthesis of Intermediate 1)

4-Bromophenol (41.6 g, 240 mmol), 2-octyl-1-dodecyl bromide (174 g, 480 mmol), potassium carbonate (100

g, 720 mmol), and methyl ethyl ketone (480 mL) were mixed and were stirred at 100°C for 72 hours under the nitrogen atmosphere. The reaction solution was cooled to room temperature, filtration was performed through celite, and celite was washed with hexane. The filtrate was concentrated under reduced pressure, and the obtained crude product was purified by silica gel column chromatography (eluate: hexane) to obtain Intermediate 1 (80 g).

(Synthesis of Intermediate 2)

Intermediate 1 (30 g, 66 mmol), 4-pentyn-1-ol (18.3 mL, 198 mmol), copper iodide (630 mg, 3.3 mmol), diethylamine (90 mL), tetrakistriphenylphosphine palladium (1.9 g, 1.7 mmol) were mixed and stirred at 70°C for four hours under nitrogen atmosphere. Ethyl acetate (200 mL) was added to the reaction solution, and filtration was performed through celite, so as to remove insoluble matter. The filtrate was concentrated under reduced pressure, and the obtained crude product was purified by silica gel column chromatography (eluate: hexane/ethyl acetate=4:1 to 1:1) to obtain Intermediate 2 (17.5 g).

(Synthesis of Intermediate 3)

Intermediate 2 (5.0 g, 11 mmol), 10 wt% Pd/C (3.6 g), and ethanol (25 mL) were mixed in an autoclave container. Hydrogen was charged at 0.9 Mpa and stirring was performed at 30°C for four hours. The reaction vessel was returned to the atmosphere, the reaction solution was filtered through celite, and celite was washed with tetrahydrofuran. The filtrate was concentrated under reduced pressure, and the obtained crude product was purified by silica gel column chromatography (eluate:hexane/ethyl acetate=4:1 to 2:1) to obtain Intermediate 3 (4.2 g).

(Synthesis of Intermediate 4)

Intermediate 3 (8.5 g, 18 mmmol), imidazole (1.5 g, 22 mol), triphenylphosphine (5.8 g, 22 mol) and dichloromethane (54 mL) were mixed and were cooled to 0°C under a nitrogen atmosphere. Iodine (5.6 g, 22 mol) was added in small portions. The reaction solution was raised to room temperature, and stirring was performed for one hour. The reaction was stopped by adding an aqueous solution of sodium bisulfite, the solution was separated, and the aqueous layer was removed. The organic layer was dried on magnesium sulfate, filtration was performed, and vacuum concentration was performed. The obtained crude product was purified by silica gel column chromatography (eluate:hexane) to obtain Intermediate 4 (8.7 g).

(Synthesis of Intermediate 5)

3,6-di(2-thienyl)-2,5-dihydropyrrolo[3,4-c]pyrrole-1,4-dione (1.53 g, 5.1 mmol), potassium carbonate (2.1 g, 15.3 mmol), N,N-dimethylformamide (75 mL) were mixed and stirred at 100°C for one hour under a nitrogen atmosphere. Thereafter, Intermediate 4 (8.7 g, 15 mmol) was added, and the mixture was further stirred at 100°C for six hours. The reaction solution was cooled to room temperature, filtration was performed through celite, and celite was washed with ethyl acetate. The filtrate was concentrated under reduced pressure, and the obtained crude product was purified by silica gel column chromatography (eluant:hexane/ethyl acetate=19:1 to 9:1) to obtain Intermediate 5 (3.2 g).

(Synthesis of Intermediate 6)

Under a nitrogen atmosphere, 2,2,6,6-tetramethylpiperidine (2.4 mL, 14 mmol) and dehydrated tetrahydrofuran (13 mL) were mixed and cooled to -78°C. 2.6 M of a normal butyllithium hexane solution (5.2 mL, 13 mmol) was added dropwise, and the temperature was raised to 0°C to adjust a lithiation agent.

Under a nitrogen atmosphere, Intermediate 5 (800 mg, 0.67 mmol), and dehydrated THF (3.6 mL) were mixed and cooled to -78°C. The above-adjusted lithiation agent (4.1 mL, corresponding to 4.2 mmol) was added dropwise. After stirring was performed at -78°C for one hour, 1,2-dibromo-1,1,2,2-tetrachloroethane (439 mg, 1.3 mmol) was added. Thereafter, the temperature of the reaction solution was raised to room temperature, stirring was performed for one hour, water was added, and the reaction was stopped. After the reaction solution was extracted with hexane, the organic layer was washed with 1 M of hydrochloric acid and saturated saline. The organic layer was dried on magnesium sulfate, filtration was performed, and vacuum concentration was performed. The obtained crude product was purified by silica gel column chromatography (eluant: hexane/ethyl acetate=19:1 to 9:1) to obtain Intermediate 6 (390 mg).

(Synthesis of Compound (5))

Synthesis Intermediate 6 (130 mg, 97 μmol), 5,5'-bis(trimethylstannyl)-2,2'-bithiophene (48 mg, 97 μmol), tri(o-

tolyl) phosphine (2.4 mg, 7.7 μmol), tris(dibenzylideneacetone) dipalladium (1.8 mg, 1.9 μmol), and dehydrated chlorobenzene (3 mL) were mixed and stirred at 130°C for 24 hours under nitrogen atmosphere. The reaction solution was cooled to room temperature and was introduced to a mixed solution of methanol (40 mL)/concentrated hydrochloric acid (2 mL) and stirred for two hours, and the precipitate was filtrated and washed with methanol. The resulting crude product was sequentially subjected to soxhlet extraction with methanol, acetone, and hexane, and soluble impurities were removed. Subsequently, soxhlet extraction was performed with chlorobenzene, the obtained solution was subjected to vacuum concentration, methanol was added, the precipitated solid content was filtrated and washed with methanol, and vacuum drying was performed at 80°C for 12 hours, so as to obtain Compound (5) (130 mg).

The number-average molecular weight in terms of polystyrene was $2.0 \times 10^4$, and the weight-average molecular weight thereof was $5.0 \times 10^4$.

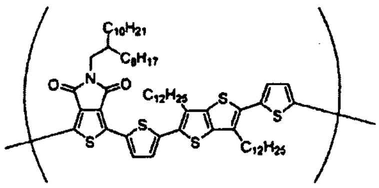

Compound (1)
Mw=32,000

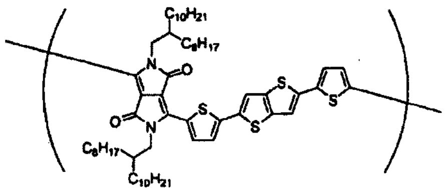

Compound (2)
Mw=89,000

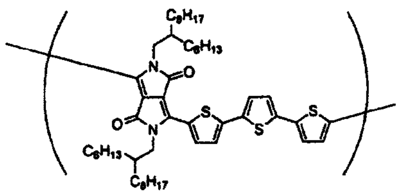

Compound (3)
Mw=78,000

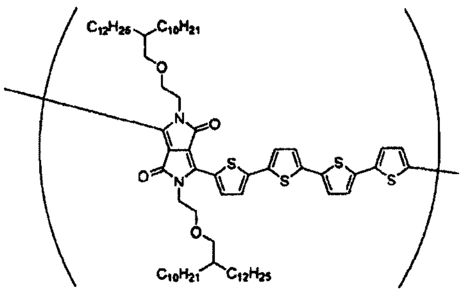

Compound (4)
Mw=75,000

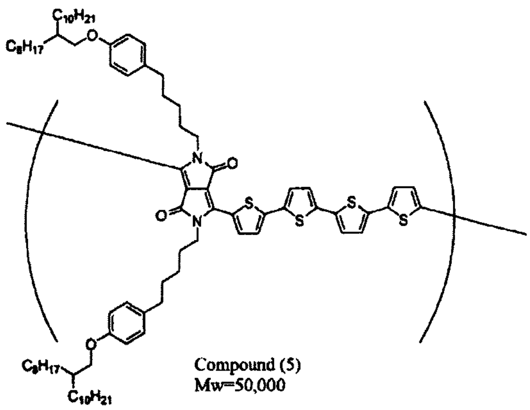

Compound (5)
Mw=50,000

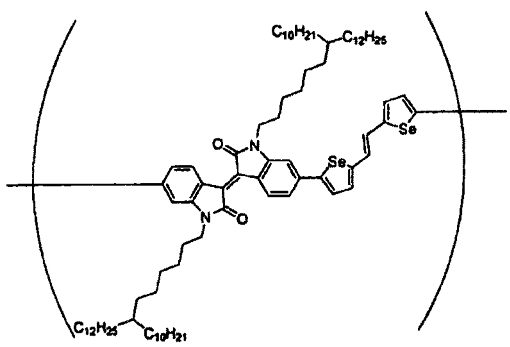

Compound (6)
Mw=98,000

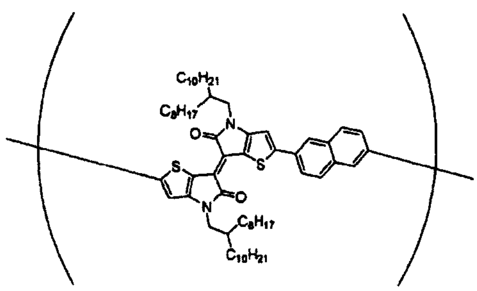

Compound (7)
Mw=70,000

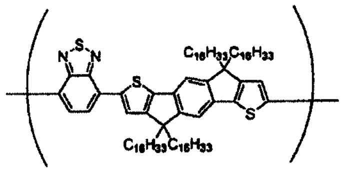

Compound (8)
Mw=71,000

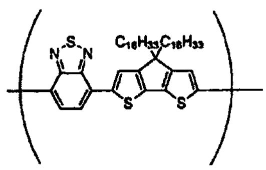

Compound (9)
Mw=28,000

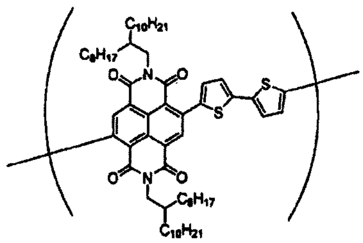

Compound (10)
Mw=88,000

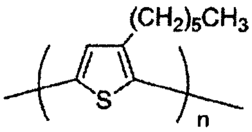

P3HT
Mw:45,000

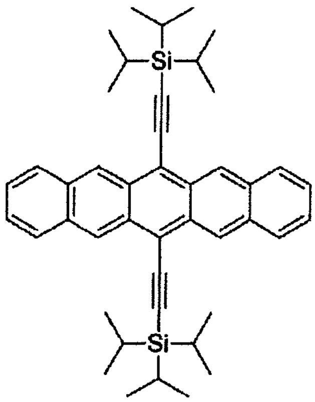

TIPS-PEN

[Manufacturing Example 1] Manufacturing of bottom gate-type OTFT-1

The bottom gate-bottom contact-type OTFT illustrated in Fig. 1A was manufactured. A doped silicon substrate (also functioning as the gate electrode 5) having a thickness of 1 mm was used as the substrate 6, and the gate insulating layer 2 was formed thereon.

The gate insulating layer 2 was formed as below.

6.3 g of poly(4-vinylphenol) (manufactured by Nippon Soda Co., Ltd., trade name: VP-8000, Mn 11,000, dispersion degree 1.1) and 2.7 g of 2,2-bis(3,5-dihydroxymethyl-4-hydroxyphenyl) propane, as a crosslinking agent, were completely dissolved in 91 g of mixed solvent of 1-butanol/ethanol = 1/1 at room temperature. This solution was filtered with a membrane filter formed of polytetrafluoroethylene (PTFE) with φ 0.2 μm. 0.18 g of diphenyliodonium hexafluorophosphate salt as an acid catalyst was added to the obtained solution, and applied to the substrate 6 and dried to form a film. Thereafter, the film was heated to 100°C to form a crosslinking structure, so as to form the gate insulating layer 2 having a thickness of 0.7 μm.

Then, as illustrated in Fig. 1A, electrodes formed of chromium/gold (gate width W=100 mm, gate length L=100 μm) disposed in a comb shape as the source electrode 3 and the drain electrode 4 were formed by vacuum evaporation by using a mask.

In order to form a block copolymer layer on the gate insulating layer 2, a solution (coating solution) obtained by dissolving 10 mg of the block copolymer presented in a first table in 1 g of propylene glycol monomethyl ether acetate (PGMEA) was prepared. This coating solution was applied to the gate insulating layer 2 by spin-coating and was dried, so as to form a film. This block copolymer layer was heated at 180°C under nitrogen stream. All of the thicknesses of the obtained block copolymer layers were in the range of 20 to 50 nm. In order to form films with BBP-1 and BBP-2, diphenyliodonium hexafluorophosphate salt as an acid catalyst was added to the coating solution at a concentration of 1 wt% based on the solid content, and crosslinking reaction was simultaneously performed during heating at 180°C.

Subsequently, a solution obtained by dissolving 4 mg of the organic semiconductor compound presented in the first table in 1 mL of chlorobenzene was applied by spin coating so as to cover the block copolymer layer, the source, and the drain electrode, a film was formed, and an annealing treatment was performed at 175°C for one hour under the nitrogen atmosphere, so as to manufacture the OTFT in the structure presented in Fig. 1A. The thickness of the organic semiconductor layer was 20 nm to 50 nm.

<Performance evaluation of OTFT>

With respect to the OTFT obtained in Manufacturing Example 1, the performance of the OTFT was examined by evaluating carrier mobility, an on/off ratio, and an absolute value of a threshold voltage in the method below.

(Evaluation of carrier mobility)

Carrier mobility μ was calculated by applying a voltage of -40 V between the source electrode and the drain electrode, changing a gate voltage in the range of 40 V to -40 V, and using an equation below indicating a drain current Id. The greater value indicates excellent carrier mobility.

$$Id=(w/2L)\mu Ci(Vg-Vth)^2$$

(In the equation, L represents a gate length, w represents a gate width, $C_i$ represents the capacitance per unit area of the insulating layer, $V_g$ represents a gate voltage, and $V_{th}$ represents a threshold voltage)

(Evaluation standard of on/off ratio)

In a case where the voltage applied between the source electrode and the drain electrode was fixed to -40 V and Vg was swept from 40 to -40 V, (a maximum value of |Id|)/(a minimum value of |Id|) was defined as an on/off ratio. Evaluation standards were as follows, A or B was preferable, and A was more preferable.

A: $1\times10^6$ or greater
B: $1\times10^5$ or greater and less than $1\times10^6$
C: Less than $1\times10^5$

(Evaluation of threshold voltage)

A voltage applied between the source electrode and the drain electrode was fixed to -40V, and Vg was changed in the range of 40 to -40V, so as to measure a threshold voltage Vth. As the absolute value of this value was closer to 0, the threshold voltage was excellent.

<Heat resistance test>

The OTFT obtained in Manufacturing Example 1 was heated at 200°C for one hour, under the nitrogen atmosphere, and carrier mobility, the on/off ratio, and the threshold voltage were evaluated by the above method.

(Carrier mobility (heat resistance))

A value of the carrier mobility after the heat resistance test with respect to a value of the carrier mobility before the heat resistance test [100×(carrier mobility after heat resistance test)/(carrier mobility before heat resistance test)](%) was obtained, and the evaluation of the carrier mobility in the heat resistance test was evaluated based on this value in the following standards. In the evaluation standard below, A or B was preferable, and A was more preferable.

A: 10% or greater
B: 1% or greater and less than 10%
C: Less than 1%

(On/off ratio (heat resistance))

A value of the on/off ratio after the heat resistance test with respect to a value of the on/off ratio before the heat resistance test [100×(on/off ratio after heat resistance test)/(on/off ratio before heat resistance test)](%) was obtained, and the evaluation of the on/off ratio in the heat resistance test was evaluated based on this value in the following standards. In the evaluation standard below, A was more preferable.

A: 10% or greater
B: Less than 10%

(Threshold voltage (heat resistance))

A difference between a value (absolute value) of the threshold voltage after the heat resistance test with respect to a value (absolute value) of the threshold voltage before the heat resistance test [(absolute value of threshold voltage after heat resistance test)-(absolute value of threshold voltage before heat resistance test)] was obtained, and the evaluation of the threshold voltage in the heat resistance test was evaluated based on this value in the following standards. In the evaluation standard below, A was more preferable.

A: Less than 5 V

B: 5V or greater

Results thereof are as presented in Table 1.

[Table 1]

| First table | Organic semiconductor compound | | | Block copolymer | | Initial characteristic result | | | Heat resistance test | | |
|---|---|---|---|---|---|---|---|---|---|---|---|
| | Type | Type of Acceptor (A) | Formulae (2) to (5) | Type | Formulae (I) to (III) | Mobility ($cm^2/Vs$) | on/off ratio | Absolute value of threshold voltage (V) | Mobility ($cm^2/Vs$) | on/off ratio | Absolute value of threshold voltage (V) |
| Example 1 | Compound (1) | A-1 | (2) | P-3 | Formula (I), Formula (III) | 0.13 | A | 13 | A | A | A |
| Example 2 | Compound (2) | A-3 | (3) | P-3 | Formula (I), Formula (III) | 0.46 | A | 16 | A | A | A |
| Example 3 | Compound (3) | A-3 | (3) | P-3 | Formula (I), Formula (III) | 0.23 | A | 11 | A | A | A |
| Example 4 | Compound (4) | A-3 | (3) | P-3 | Formula (I), Formula (III) | 0.33 | A | 8 | A | A | A |
| Example 5 | Compound (5) | A-3 | (3) | P-3 | Formula (I), Formula (III) | 0.32 | A | 9 | A | A | A |
| Example 6 | Compound (6) | A-5 | (4) | P-3 | Formula (I), Formula (III) | 0.18 | A | 15 | A | A | A |
| Example 7 | Compound (7) | A-6 | (5) | P-3 | Formula (I), Formula (III) | 0.25 | A | 17 | A | A | A |
| Example 8 | Compound (8) | A-8 | - | P-3 | Formula (I), Formula (III) | 0.23 | B | 10 | A | A | A |
| Example 9 | Compound (9) | A-8 | - | P-3 | Formula (I), Formula (III) | 0.15 | B | 15 | A | A | A |
| Example 10 | Compound (10) | A-10 | - | P-3 | Formula (I), Formula (III) | 0.08 | A | 10 | B | A | A |
| Example 11 | Compound (4) | A-3 | (3) | P-1 | Formula (I), Formula (II) | 0.21 | A | 10 | A | A | A |
| Example 12 | Compound (4) | A-3 | (3) | P-2 | Formula (1), Formula (II) | 0.23 | A | 8 | A | A | A |
| Example 13 | Compound (4) | A-3 | (3) | P-4 | Formula (1), Formula (II) | 0.12 | A | 11 | B | A | A |

(continued)

| First table | Organic semiconductor compound | | | Block copolymer | | Initial characteristic result | | | Heat resistance test | | |
|---|---|---|---|---|---|---|---|---|---|---|---|
| | Type | Type of Acceptor (A) | Formulae (2) to (5) | Type | Formulae (I) to (III) | Mobility ($cm^2/Vs$) | on/off ratio | Absolute value of threshold voltage (V) | Mobility ($cm^2/Vs$) | on/off ratio | Absolute value of threshold voltage (V) |
| Example 14 | Compound (4) | A-3 | (3) | P-5 | Formula (I), Formula (II) | 0.26 | A | 7 | A | A | A |
| Example 15 | Compound (4) | A-3 | (3) | P-6 | Formula (I) | 0.13 | A | 18 | A | A | A |
| Example 16 | Compound (4) | A-3 | (3) | P-7 | Formula (I), Formula (II) | 0.18 | A | 15 | A | A | A |
| Example 17 | Compound (4) | A-3 | (3) | P-8 | Formula (I), Formula (I) | 0.13 | A | 16 | A | A | A |
| Example 18 | Compound (4) | A-3 | (3) | BP-1 | Formula (I), Formula (II) | 0.25 | A | 8 | A | A | A |
| Example 19 | Compound (4) | A-3 | (3) | BP-4 | Formula (I), Formula (II) | 0.20 | A | 12 | A | A | A |
| Example 20 | Compound (4) | A-3 | (3) | BP-5 | Formula (I), Formula (II) | 0.30 | A | 7 | A | A | A |
| Example 21 | Compound (4) | A-3 | (3) | BP-6 | Formula (I), Formula (II) | 0.23 | A | 6 | A | A | A |
| Example 22 | Compound (4) | A-3 | (3) | CBP-2 | Formula (I) Formula (II) | 0.19 | A | 15 | A | A | A |
| Example 23 | Compound (4) | A-3 | (3) | BBP-1 | Formula (I), Formula (II), Formula (II) | 0.20 | A | 10 | A | A | A |
| Example 24 | Compound (4) | A-3 | (3) | BBP-2 | Formula (I), Formula (II), Formula (II) | 0.22 | A | 8 | A | A | A |
| Comparative Example 1 | P3HT | - | - | P-3 | Formula (I), Formula (III) | 0.001 | C | 10 | B | B | B |

(continued)

| First table | Organic semiconductor compound | | | Block copolymer | | Initial characteristic result | | | Heat resistance test | | |
|---|---|---|---|---|---|---|---|---|---|---|---|
| | Type | Type of Acceptor (A) | Formulae (2) to (5) | Type | Formulae (I) to (III) | Mobility ($cm^2/Vs$) | on/off ratio | Absolute value of threshold voltage (V) | Mobility ($cm^2/Vs$) | on/off ratio | Absolute value of threshold voltage (V) |
| Comparative Example 2 | TIPS-PEN | - | - | P-3 | Formula (I), Formula (III) | 0.10 | C | 11 | C | B | B |
| Comparative Example 3 | Compound (4) | A-3 | (3) | None | - | 0.05 | B | 25 | A | B | B |

<Evaluation results>

As presented in the first table, the OTFTs in the examples exhibit the high carrier mobility and the low threshold voltage, and heat resistance was excellent.

From the comparison with Examples 1 to 9, the OTFTs (Examples 8 and 9) manufactured by using the organic semiconductor compounds of which types did not correspond to Formulae (2) to (5) had a tendency that the initial on/off ratio was decreased.

From the comparison of Examples 1 to 7 and 10, the OTFT (Example 10) manufactured by using the organic semiconductor compound of which the type did not correspond to Formulae (2) to (5) had a tendency that initial carrier mobility and carrier mobility after the heat resistance test were decreased.

From the comparison of Examples 11 to 14, 16, and 18 to 24, the OTFT (Example 13) manufactured by using the block copolymer of which the type did not have a combination of Formulae (I) and (II) or a combination of Formulae (I) and (III) had a tendency that initial carrier mobility and carrier mobility after the heat resistance test were decreased.

From the comparison of Examples 11 to 12, and 14 to 24, the OTFTs (Examples 15 and 17) manufactured by using the block copolymers of which the types did not have a combination of Formulae (I) and (II) or a combination of Formulae (I) and (III) had a tendency that initial carrier mobility and absolute values of the threshold voltage were increased.

Meanwhile, the OTFTs of the comparative examples did not manufactured by using the block copolymer or the specific organic semiconductor compound, and it was exhibited that thus the desired performances were not able to be obtained.

[Manufacturing Example 2] Manufacturing of bottom gate-type OTFT-2

OTFTs in which base material layers were formed on gate insulating layers as the underlayer of the block copolymer layer were manufactured. Specifically, in the OTFT using P-2 as the block copolymer in Manufacturing Example 1, an OTFT in which a random polymer (random polymerized polymer) RP-1 layer using the same monomer component as P-2 as a structural component was formed as a base material layer of the block copolymer layer was manufactured. The coating solution obtained by dissolving 10 mg of RP-1 in 1 g of PGMEA was prepared, and the RP-1 layer was formed by spin coating.

In the same manner, in the OTFT using BBP-1 as the block copolymer in Manufacturing Example 1, an OTFT in which a random polymer (random polymerized polymer) BRP-1 layer using the same monomer component as BBP-1 as a structural component was formed as a base material layer of the block copolymer layer was manufactured. The coating solution obtained by dissolving 10 mg of BRP-1 in 1 g of PGMEA was prepared, and the BRP-1 layer was formed by spin coating.

In the same manner, in the OTFT using BP-6 as the block copolymer in Manufacturing Example 1, an OTFT in which a random polymer (random polymerized polymer) RP-2 layer using the same monomer component as BP-6 as a structural component was formed as a base material layer of the block copolymer layer was manufactured. The coating solution obtained by dissolving 10 mg of RP-2 in 1 g of PGMEA was prepared, and the RP-2 layer was formed by spin coating.

In the same manner, in the OTFT using BBP-2 as the block copolymer in Manufacturing Example 1, an OTFT in which a random polymer (random polymerized polymer) BRP-2 layer using the same monomer component as BBP-2 as a structural component was formed as a base material layer of the block copolymer layer was manufactured. The coating solution obtained by dissolving 10 mg of BRP-2 in 1 g of PGMEA was prepared, and the BRP-2 layer was formed by spin coating.

In the forming of the base material layers using BRP-1 and BRP-2, diphenyliodonium hexafluorophosphate salt as an acid catalyst was added at a concentration of 1 wt% based on the solid content in the coating solution, coating and film forming were performed, and then heating was performed at 100°C, so as to form a crosslinking structure.

All of the thicknesses of the base material layers were 20 nm.

RP-1

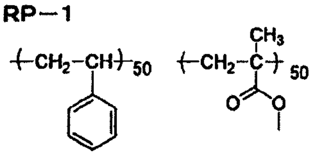

Random polymerization polymer, Mn=55,000, Mw/Mn=1.85

BRP-1

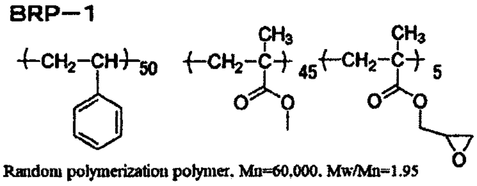

Random polymerization polymer, Mn=60,000, Mw/Mn=1.95

RP-2

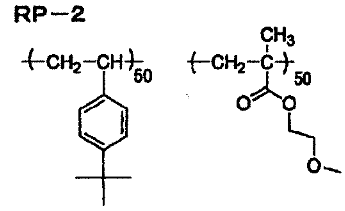

Random polymerization polymer. Mn=45,000, Mw/Mn=1.87

BRP-2

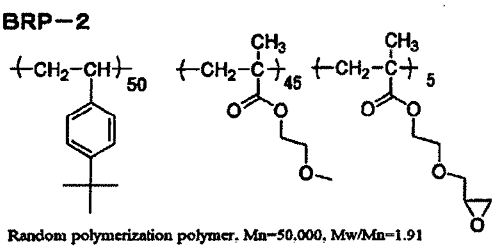

Random polymerization polymer. Mn=50,000, Mw/Mn=1.91

The numerical values applied to the repeating unit of the above random polymers (random polymerization polymer) indicate mass ratios of the repeating units.

With respect to the respective obtained OTFTs, carrier mobility, on/off ratios, and absolute values of threshold voltages of the OTFTs were evaluated in the same method as the evaluation of Manufacturing Example 1. As a result, in a case where the base material layer was formed, compared with Manufacturing Example 1, results of the on/off ratios, and the absolute values of the threshold voltages were the same, and carrier mobility was improved by about 1.2 times. In the same method as in Manufacturing Example 1, the heat resistance test was performed, a case where the base material layer was formed exhibited the same tendency as in Manufacturing Example 1, and the change due to the difference of inserting the base material layer was not recognized.

[Manufacturing Example 3] Manufacturing of bottom gate-type OTFT-3

OTFTs were manufactured by substituting the gate insulating layer in Manufacturing Example 1 with a layer including polyvinylphenol (manufactured by Nippon Soda Co., Ltd., VP-8000), with a layer including polysilsesquioxane (manufactured by Toagosei Co., Ltd., OX-SQ, HDXOX-SQ, NDX), with a layer including CYTOP (manufactured by Asahi Glass Co., Ltd., CTL-809M), and with a layer including $SiO_2$ (instead of an organic polymer that forms the gate insulating layer 2, 0.3 μm of a surface of a Si substrate was changed to $SiO_2$ by heat oxidation, to be used as the gate insulating layer 2).

With respect to the respective obtained OTFTs, carrier mobility, on/off ratios, and absolute values of threshold voltages of the OTFTs were evaluated in the same method as the evaluation of Manufacturing Example 1. As a result, a change caused by the difference of the gate insulating layer was not recognized. In the same method as in Manufacturing Example 1, the heat resistance test was performed, same tendency as in Manufacturing Example 1 was exhibited, and the change by the difference of the gate insulating layer was not recognized.

[Manufacturing Example 4] Manufacturing of bottom gate-type OTFT-4

In Manufacturing Example 1, with respect to the OTFT using P-2 as the block copolymer, an OTFT obtained by substituting the gate insulating layer with the layer formed of RP-1 was manufactured.

In Manufacturing Example 1, with respect to the OTFT using BBP-1 as the block copolymer, an OTFT obtained by substituting the gate insulating layer with the BRP-1 layer was manufactured.

In the same manner, in Manufacturing Example 1, with respect to the OTFT using BP-6 as the block copolymer, an OTFT obtained by substituting the gate insulating layer with the layer formed of RP-2 was manufactured.

In the same manner, in Manufacturing Example 1, with respect to the OTFT using BBP-2 as the block copolymer, an OTFT obtained by substituting the gate insulating layer with the BRP-2 layer was manufactured.

In the forming of the gate insulating layers using BRP-1 and BRP-2, diphenyliodonium hexafluorophosphate salt as an acid catalyst was added at a concentration of 1 wt% based on the solid content in the coating solution, coating and film forming were performed, and then heating was performed at 100°C, so as to form a crosslinking structure.

With respect to the respective obtained OTFTs, carrier mobility, on/off ratios, and absolute values of threshold voltages of the OTFTs were evaluated in the same method as the evaluation of Manufacturing Example 1. As a result, compared with Manufacturing Example 1, results of the on/off ratios and the absolute values of the threshold voltages were the same, and carrier mobility was improved by about 1.2 times. In the same method as in Manufacturing Example 1, the heat resistance test was performed, same tendency as in Manufacturing Example 1 was exhibited, and the change by the difference of the gate insulating layer was not recognized.

[Manufacturing Example 5] Manufacturing of bottom gate-type OTFT-5

In Manufacturing Example 1, OTFTs in which the gate insulating layers were formed of the block copolymer (that is, OTFTs in which organic semiconductor layers were formed on gate insulating layers formed of block copolymers)

were manufactured.

In the forming of the gate insulating layers using BBP-1 and BBP-2, diphenyliodonium hexafluorophosphate salt as an acid catalyst was added at a concentration of 1 wt% based on the solid content in the coating solution, coating and film forming were performed, and then heating was performed at 100°C, so as to form a crosslinking structure.

With respect to the respective obtained OTFTs, carrier mobility, on/off ratios, and absolute values of threshold voltages of the OTFTs were evaluated in the same method as the evaluation of Manufacturing Example 1. As a result, the results were as presented in the first table. In the same method as in Manufacturing Example 1, the heat resistance test was performed, same tendency as in Manufacturing Example 1 was exhibited, and the change by the difference of the gate insulating layer was not recognized.

[Manufacturing Example 6] Manufacturing of bottom gate-type OTFT-6

In the same manner as in Manufacturing Example 1, after the source electrode 3 and the drain electrode 4 were formed, a solution (coating solution) obtained by dissolving 4 mg of the block copolymer (P-3) and 4 mg of the organic semiconductor compound (Compound (4)) in 2 mL of chlorobenzene was prepared. This coating solution was applied to the gate insulating layer 2 by spin coating, a film was formed, an annealing treatment was performed at 175°C for one hour under the nitrogen atmosphere, so as to manufacture the OTFT. The thickness of the obtained organic semiconductor layer is in the range of 30 to 100 nm.

With respect to the organic semiconductor layer of the obtained OTFT, whether the block copolymer is unevenly distributed or phase-separated can be checked by performing element mapping measurement by time-of-flight secondary ion analysis (TOF-SIMS) together with the use of an etching ion beam. As a result, in the organic semiconductor layer, the block copolymer is unevenly distributed on the surface of the organic semiconductor layer in the same manner as in Fig. 2E.

With respect to the respective obtained OTFTs, carrier mobility, on/off ratios, and absolute values of threshold voltages of the OTFTs were evaluated in the same method as the evaluation of Manufacturing Example 1. As a result, the results were the same as in Example 4. The heat resistance test in the same method as in Manufacturing Example 1 was performed, and the same tendency as in Manufacturing Example 1 was exhibited.

[Manufacturing Example 7] Manufacturing of top gate-type OTFT

The top gate-bottom contact-type OTFT illustrated in Fig. 1C was manufactured. The glass substrate (manufactured by Nippon Electric Glass Co.,Ltd., OA10) was washed with water and was dried to be used as the substrate 6. The resist layer was provided on this glass substrate, and the source electrode 3 and the drain electrode 4 having a thickness of 100 nm were provided. The gate width W was 100 mm, and the gate length L was 100 $\mu$m. In order to remove the resist layer and form the block copolymer layer, a solution obtained by dissolving 10 mg of a block copolymer (P-3) in 1 g of PGMEA was prepared. This solution was applied to the substrate 6 by spin coating, so as to form a film. This block copolymer layer was heated at 180°C under nitrogen stream. The thickness of the obtained block copolymer layer (block copolymer layer) was in the range of 20 to 50 nm.

Subsequently, a solution obtained by dissolving 4 mg of the organic semiconductor compound (Compound (4)) in 1 mL of chlorobenzene was applied by spin coating so as to cover the block copolymer layer, the source, and the drain electrode, a film was formed, and an annealing treatment was performed at 175°C for one hour under the nitrogen atmosphere. The thickness of the organic semiconductor layer was 20 nm to 50 nm.

The gate insulating layer was formed including CYTOP (manufactured by Asahi Glass Co., Ltd., CTL-809M) so as to cover the organic semiconductor layer.

Subsequently, an Ag fine particle water dispersion was coated on the gate insulating layer by an ink jet method and was dried, to form a gate electrode having a thickness of 200 nm.

With respect to the obtained top gate-bottom contact-type OTFTs, carrier mobility, on/off ratios, and absolute values of threshold voltages of the OTFTs were evaluated in the same method as the evaluation of Manufacturing Example 1. As a result, the results were the same as in Example 4. The heat resistance test in the same method as in Manufacturing Example 1 was performed, and the same tendency as in Manufacturing Example 1 was exhibited.

[Manufacturing Example 8] Manufacturing of bottom gate-type OTFT-7

In the same manner as in Manufacturing Example 1, after the gate insulating layer 2 was formed, subsequently, an ultraviolet (UV)/ozone treatment (manufactured by Jelight Company Inc., UVO-CLEANER Model No. 42) was performed such that the surface energy became as presented in the second table below.

Thereafter, in the same manner as in Manufacturing Example 1, the source electrode 3 and the drain electrode 4 were formed.

Subsequently, a solution (coating solution) obtained by dissolving 2 mg of the block copolymer (P-3) and 4 mg of the organic semiconductor compound (Compound (4)) in 2 mL of chlorobenzene was prepared. This coating solution was applied to the gate insulating layer 2 by spin coating, a film was formed, an annealing treatment was performed at 175°C for one hour under the nitrogen atmosphere, so as to manufacture the OTFT. The thickness of the obtained organic semiconductor layer is in the range of 20 to 100 nm.

With respect to the obtained OTFTs, carrier mobility, on/off ratios, and absolute values of threshold voltages of the OTFTs were evaluated in the same method as the evaluation of Manufacturing Example 1, and evaluation results of the carrier mobility are presented in the second table. Results of the items other than the carrier mobility were the same as in Example 4. The heat resistance test was performed, and the result was the same as in Example 4.

[Table 2]

| Second table | Surface energy of gate insulating layer (mN/m) | Initial characteristic result |
|---|---|---|
| | | Mobility ($cm^2/Vs$) |
| Example 8-1 | 50 | 0.40 |
| Example 8-2 | 65 | 0.43 |
| Example 8-3 | 70 | 0.50 |
| Example 8-4 | 75 | 0.50 |

[Manufacturing Example 9] Manufacturing of bottom gate-type OTFT-8

In the same manner as in Manufacturing Example 1, a doped silicon substrate (also functioning as the gate electrode 5) having a thickness of 1 mm was used as the substrate 6, and the gate insulating layer 2 was formed thereon.

The gate insulating layer 2 was formed as below. Spin coating was performed with a composition for forming a gate insulating layer (a propylene glycol monomethyl ether acetate (PGMEA) solution (concentration of solid content: 2 mass%) in which (styrene-co-methyl methacrylate)/pentaerythritol tetraacrylate/1,2-octanedione, and 1-[4-(phenylthio)-, 2-(O-benzoyloxime)]=1 parts by mass/1 parts by mass/0.01 parts by mass (w/w)), baking was performed at 110°C for five minutes, exposure (365 nm and 100 $mJ/cm^2$) was performed, and post baking was performed at 200°C for 60 minutes, so as to form a gate insulating layer having a film thickness of 400 nm. Subsequently, ultraviolet (UV)/ozone treatment (manufactured by Jelight Co., Inc., UVO-CLEANER Model No.42) was performed so as to obtain surface energy of a third table. However, in Example 9-0, a UV/ozone treatment was not performed.

Thereafter, in the same manner as in Manufacturing Example 1, the source electrode 3 and the drain electrode 4 were formed.

Subsequently, a solution (coating solution) obtained by dissolving 2 mg of the block copolymer (P-3) and 4 mg of the organic semiconductor compound (Compound (4)) in 2 mL of chlorobenzene was prepared. This coating solution was applied to the gate insulating layer 2 by spin coating, a film was formed, an annealing treatment was performed at 175°C for one hour under the nitrogen atmosphere, so as to manufacture the OTFT. The thickness of the obtained organic semiconductor layer is in the range of 20 to 100 nm.

With respect to the obtained OTFTs, carrier mobility, on/off ratios, and absolute values of threshold voltages of the OTFTs were evaluated in the same method as the evaluation of Manufacturing Example 1, and evaluation results of the carrier mobility are presented in the third table. Results of the items other than the mobility were the same as in Example 4. The heat resistance test was performed, and the result was the same as in

Example 4.

[Table 3]

| Third table | Surface energy of gate insulating layer (mN/m) | Initial characteristic result |
|---|---|---|
| | | Mobility ($cm^2/Vs$) |
| Example 9-0 | 42 | 0.30 |
| Example 9-1 | 50 | 0.45 |
| Example 9-2 | 65 | 0.54 |

(continued)

| Third table | Surface energy of gate insulating layer (mN/m) | Initial characteristic result |
|---|---|---|
| | | Mobility ($cm^2/Vs$) |
| Example 9-3 | 70 | 0.60 |
| Example 9-4 | 75 | 0.60 |

From the evaluation results of the second and third tables, it was understood that the carrier mobility was prominently enhanced in a case where a mixed solution (organic semiconductor composition) containing the organic semiconductor compound and the block copolymer was applied to a gate insulating layer of which the surface energy is 50 to 75mNm.

Explanation of References

1: organic semiconductor layer

1A: area having large content of block copolymer

1B: area having large content of organic semiconductor

2: gate insulating layer

3: source electrode

4: drain electrode

5: gate electrode

6: substrate

## Claims

**1.** An organic thin film transistor comprising, on a substrate: a gate electrode; an organic semiconductor layer containing an organic semiconductor compound; a gate insulating layer provided between the gate electrode and the organic semiconductor layer; and a source electrode and a drain electrode which are provided to be in contact with the organic semiconductor layer and are connected to each other via the organic semiconductor layer,
wherein the organic semiconductor layer is in contact with a block copolymer layer containing a block copolymer or further contains the block copolymer, and
wherein the organic semiconductor compound has a molecular weight of 2,000 or greater and has a repeating unit represented by Formula (1),

$$\left[ D\text{-}A \right] \qquad (1)$$

in Formula (1), A represents an electron acceptor unit including a partial structure having at least one of an sp2 nitrogen atom, a carbonyl group, or a thiocarbonyl group in a ring structure, and
D represents an electron donor unit including a divalent aromatic heterocyclic group having at least one of an N atom, an O atom, a S atom, or a Se atom in a ring structure or a divalent aromatic hydrocarbon group formed of a fused ring structure of two or more rings, as a partial structure.

**2.** The organic thin film transistor according to claim 1, wherein the organic thin film transistor has a bottom gate structure, and the block copolymer layer is provided between the gate insulating layer and the organic semiconductor layer.

3. The organic thin film transistor according to claim 1, wherein the organic thin film transistor has a bottom gate structure, and the gate insulating layer includes the block copolymer layer.

4. The organic thin film transistor according to claim 2, wherein the organic thin film transistor has a bottom gate structure, and the gate insulating layer includes a random polymer having the same monomer component as the monomer component forming the block copolymer, as a structural component.

5. The organic thin film transistor according to claim 4, wherein the random polymer in the gate insulating layer has a crosslinking structure.

6. The organic thin film transistor according to claim 1, wherein the organic thin film transistor has a top gate structure, and the block copolymer layer is provided on the substrate.

7. The organic thin film transistor according to claim 1, 2, or 6, wherein a base material layer is provided on an opposite side to a side of the block copolymer layer on which the organic semiconductor layer is provided.

8. The organic thin film transistor according to claim 7, wherein the base material layer includes a random polymer having the same monomer component as the monomer component forming the block copolymer, as a structural component.

9. The organic thin film transistor according to claim 8, wherein the random polymer in the base material layer has a crosslinking structure.

10. The organic thin film transistor according to any one of claims 1 to 9, wherein the block copolymer is at least one block copolymer selected from a styrene-(meth)acrylic acid ester block copolymer, a styrene-(meth)acrylic acid block copolymer, a styrene-dialkylsiloxane block copolymer, a styrene-alkylarylsiloxane block copolymer, a styrene-diarylsiloxane block copolymer, a (meth)acrylic acid ester-cage silsesquioxane-substituted alkyl (meth)acrylate block copolymer, a styrene-vinyl pyridine block copolymer, a styrene-hydroxystyrene block copolymer, a styrene-ethylene oxide block copolymer, and a vinyl naphthalene-(meth)acrylic acid ester block copolymer.

11. The organic thin film transistor according to any one of claims 1 to 10, wherein a surface energy of the block polymer is 30 $mNm^{-1}$ or less.

12. The organic thin film transistor according to any one of claims 1 to 11, wherein the block copolymer has a block including a repeating unit represented by Formula (I) and a block including a repeating unit represented by Formula (II) or has a block including a repeating unit represented by Formula (I) and a block including a repeating unit represented by Formula (III),

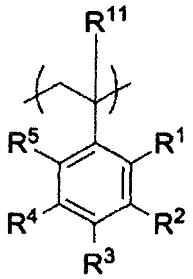

(I)

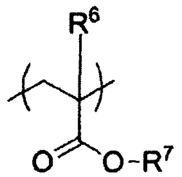

(II)

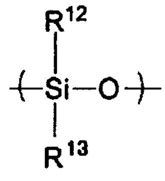

(III)

in Formula (I), $R^1$ to $R^5$ each independently represent a hydrogen atom, a hydroxyl group, an alkyl group, an alkenyl group, an alkynyl group, a cycloalkyl group, an aryl group, an aralkyl group, or a fluorine atom, $R^1$ and $R^2$ or $R^2$ and $R^3$ are connected to each other to form a ring, and $R^{11}$ represents a hydrogen atom or an alkyl group,
in Formula (II), $R^6$ represents a hydrogen atom, an alkyl group, or a cycloalkyl group, $R^7$ represents an alkyl group or a cycloalkyl group, and these substituents may be further substituted with a fluorine atom or a cage-type silsesquioxane group, and
in Formula (III), $R^{12}$ and $R^{13}$ each independently represent an alkyl group or an aryl group.

**13.** The organic thin film transistor according to claim 12, wherein an absolute value of a difference between a solubility parameter of the repeating unit represented by Formula (I) and a solubility parameter of the repeating unit represented by Formula (II) or an absolute value of a difference between a solubility parameter of the repeating unit represented by Formula (I) and a solubility parameter of the repeating unit represented by Formula (III) is 0.5 to 4.0 $MPa^{1/2}$.

**14.** The organic thin film transistor according to any one of claims 1 to 13, wherein the block copolymer includes a crosslinkable group-containing monomer component, and the block copolymer in the block copolymer layer forms a crosslinking structure.

**15.** The organic thin film transistor according to any one of claims 1 to 14, wherein A in Formula (1) has at least one structure selected from the group consisting of structures represented by Formulae (A-1) to (A-12), as a partial structure,

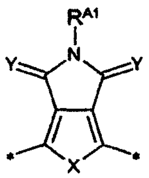
(A-1)

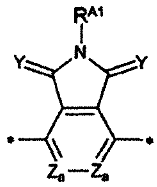
(A-2)

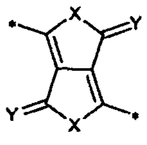
(A-3)

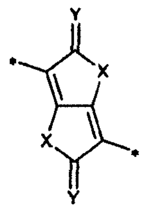
(A-4)

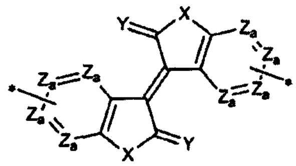
(A-5)

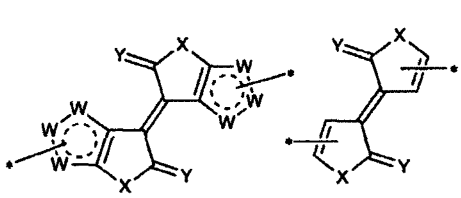
(A-6)

(A-7)

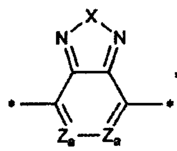
(A-8)

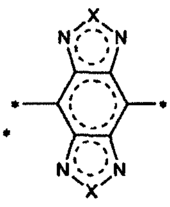
(A-9)

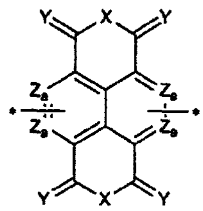
(A-10)

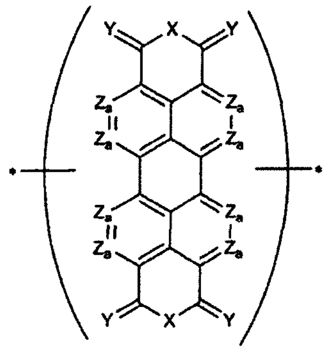
(A-11)

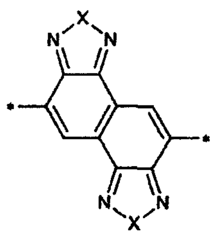
(A-12)

in Formulae (A-1) to (A-12), X's each independently represent an O atom, a S atom, a Se atom, or $NR^{A1}$,
Y's each independently represent an O atom or a S atom,
$Z_a$'s each independently represent $CR^{A2}$ or a N atom,
W's each independently represent $C(R^{A2})_2$, $NR^{A1}$, a N atom, $CR^{A2}$, an O atom, a S atom, or a Se atom,
$R^{A1}$'s each independently represent a bonding site to an alkyl group that may include at least one of -O-, -S-, or $-NR^{A3}-$, a monovalent group represented by Formula (1-1), or another structure,
$R^{A2}$'s each independently represent a bonding site to an alkyl group that may include at least one of a hydrogen atom, a halogen atom, -O-, -S-, or $-NR^{A3}-$, or another structure,
$R^{A3}$'s each independently represent a hydrogen atom or a substituent, and
*'s each independently represent a bonding site to another structure,

$$* -L_a-Ar(L_b)_l \qquad (1-1)$$

in Formula (1-1), Ar represents an aromatic heterocyclic group or an aromatic hydrocarbon group having 5 to 18 carbon atoms,

$L_a$ represents an alkylene group having 1 to 20 carbon atoms that may include at least one of -O-, -S-, or -$NR^{1S}$-,

$L_b$ represents an alkyl group having 1 to 100 carbon atoms that may include at least one of -O-, -S-, or -$NR^{2S}$-, $R^{1S}$ and $R^{2S}$ each independently represent a hydrogen atom or a substituent,

1 represents an integer of 1 to 5, and in a case where 1 is 2 or greater, a plurality of $L_b$'s may be identical to or different from each other, and

* represents a bonding site to another structure.

**16.** The organic thin film transistor according to any one of claims 1 to 15, wherein D in Formula (1) has a structure represented by Formula (D-1),

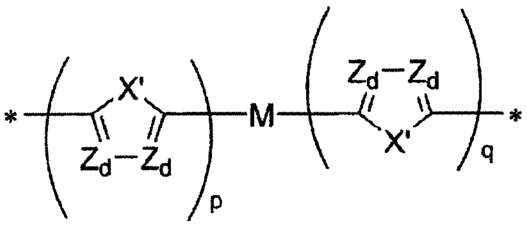 (D-1)

in Formula (D-1), X"s each independently represent an O atom, a S atom, a Se atom, or $NR^{D1}$, $R^{D1}$'s each independently represent a monovalent organic group that may be a monovalent group represented by Formula (1-1),

$Z_d$'s each independently represent a N atom or $CR^{D2}$, and $R^{D2}$'s each independently represent a hydrogen atom or a monovalent organic group that may be a monovalent group represented by Formula (1-1),

M represents a single bond, a divalent aromatic heterocyclic group, a divalent aromatic hydrocarbon group, an alkenylene group, an alkynylene group, or a divalent group obtained by combining these, M may be substituted with an alkyl group that may include at least one of -O-, -S-, or -$NR^{D3}$- or a monovalent group represented by Formula (1-1), and $R^{D3}$'s each independently represent a hydrogen atom or a substituent,

p and q each independently represent an integer of 0 to 4, and

*'s each independently represent a bonding site to another structure,

$$* \text{-La-Ar} \!\left(L_b\right)_l \qquad (1\text{-}1)$$

in Formula (1-1), Ar represents an aromatic heterocyclic group or an aromatic hydrocarbon group having 5 to 18 carbon atoms,

$L_a$ represents an alkylene group having 1 to 20 carbon atoms that may include at least one of -O-, -S-, or -$NR^{1S}$-,

$L_b$ represents an alkyl group having 1 to 100 carbon atoms that may include at least one of -O-, -S-, or -$NR^{2S}$-, $R^{1S}$ and $R^{2S}$ each independently represent a hydrogen atom or a substituent,

1 represents an integer of 1 to 5, in a case where 1 is 2 or greater, a plurality of $L_b$'s may be identical to or different from each other, and

* represents a bonding site to another structure.

**17.** The organic thin film transistor according to any one of claims 1 to 16, wherein the repeating unit represented by Formula (1) is a repeating unit represented by any one of Formulae (2) to (5),

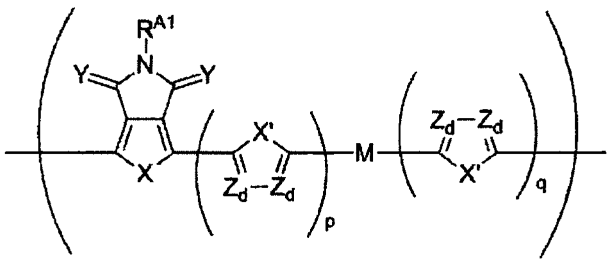

(2)

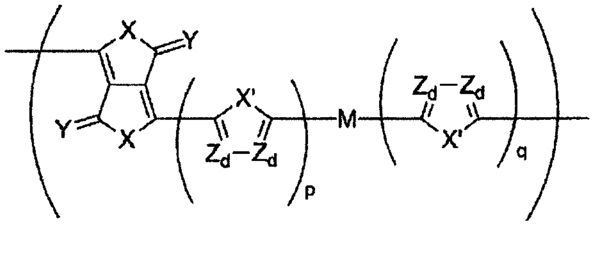

(3)

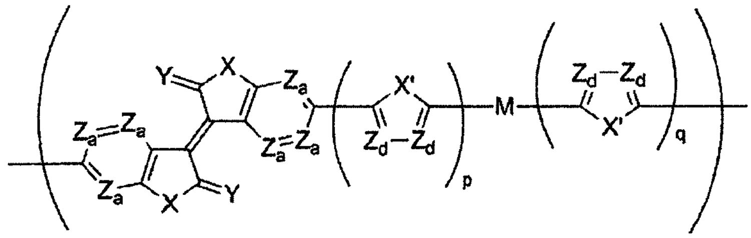

(4)

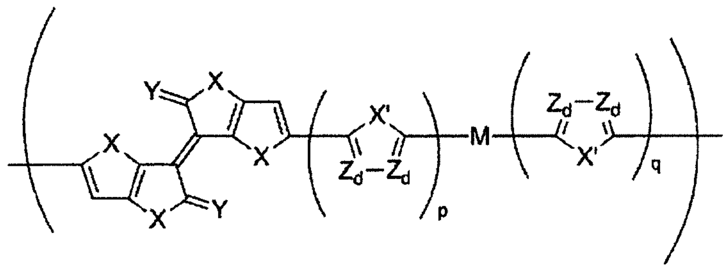

(5)

in Formulae (2) to (5), X's each independently represent an O atom, a S atom, a Se atom, or $NR^{A1}$,
$R^{A1}$'s each independently represent a bonding site to an alkyl group that may include at least one of -O-, -S-, or $-NR^{A3}-$, a monovalent group represented by Formula (1-1), or another structure,
Y's each independently represent an O atom or a S atom,
$Z_a$'s each independently represent $CR^{A2}$ or a N atom, $R^{A2}$'s each independently represent a bonding site to an alkyl group that may include at least one of a hydrogen atom, a halogen atom, -O-, -S-, or $-NR^{A3}-$, or another structure,
$R^{A3}$'s each independently represent a hydrogen atom or a substituent, and
X''s each independently represent an O atom, a S atom, a Se atom, or $NR^{D1}$, $R^{D1}$'s each independently represent a monovalent organic group that may be a monovalent group represented by Formula (1-1),
$Z_d$'s each independently represent a N atom or $CR^{D2}$, and $R^{D2}$'s each independently represent a hydrogen atom or a monovalent organic group that may be a monovalent group represented by Formula (1-1),
M represents a single bond, a divalent aromatic heterocyclic group, a divalent aromatic hydrocarbon group, an alkenylene group, an alkynylene group, or a divalent group obtained by combining these, M may be substituted with an alkyl group that may include at least one of -O-, -S-, or $-NR^{D3}-$ or a monovalent group represented by Formula (1-1), $R^{D3}$'s each independently represent a hydrogen atom or a substituent, and
p and q each independently represent an integer of 0 to 4,

$$* -L_a\text{-}Ar(L_b)_l \qquad (1\text{-}1)$$

in Formula (1-1), Ar represents an aromatic heterocyclic group or an aromatic hydrocarbon group having 5 to 18 carbon atoms,
$L_a$ represents an alkylene group having 1 to 20 carbon atoms that may include at least one of -O-, -S-, or $-NR^{1S}-$,
$L_b$ represents an alkyl group having 1 to 100 carbon atoms that may include at least one of -O-, -S-, or $-NR^{2S}-$,
$R^{1S}$ and $R^{2S}$ each independently represent a hydrogen atom or a substituent,
1 represents an integer of 1 to 5, in a case where 1 is 2 or greater, a plurality of $L_b$'s may be identical to or different from each other, and
* represents a bonding site to another structure.

**18.** A method of manufacturing the organic thin film transistor according to any one of claims 1 to 17, the method comprising:
a step of applying a mixed solution containing the organic semiconductor compound and the block copolymer.

**19.** The method of manufacturing the organic thin film transistor according to claim 18, wherein, in the step of applying the mixed solution, the mixed solution is applied to the gate insulating layer having a surface energy of 50 to 75 $mNm^{-1}$.

**20.** An organic semiconductor composition, comprising: an organic semiconductor compound which has a molecular weight of 2,000 or greater and which is represented by Formula (1); and a block copolymer,

$$\left\{ D\text{-}A \right\} \qquad (1)$$

in Formula (1), A represents an electron acceptor unit including a partial structure having at least one of a sp2 nitrogen atom, a carbonyl group, or a thiocarbonyl group in a ring structure, and
D represents an electron donor unit including a divalent aromatic heterocyclic group having at least one of a N atom, an O atom, a S atom, or a Se atom in a ring structure or a divalent aromatic hydrocarbon group consisting of a fused ring structure having two or more rings, as a partial structure.

**21.** An organic semiconductor film comprising: an organic semiconductor compound which has a molecular weight of 2,000 or greater and is represented by Formula (1); and a block copolymer,

$$\left\{ D\text{-}A \right\} \qquad (1)$$

in Formula (1), A represents an electron acceptor unit including a partial structure having at least one of a sp2 nitrogen atom, a carbonyl group, or a thiocarbonyl group in a ring structure, and
D represents an electron donor unit including a divalent aromatic heterocyclic group having at least one of a N atom, an O atom, a S atom, or a Se atom in a ring structure or a divalent aromatic hydrocarbon group consisting of a fused ring structure having two or more rings, as a partial structure.

**22.** A method of manufacturing the organic semiconductor film according to claim 21, the method comprising:
a step of applying a mixture containing the organic semiconductor compound and the block copolymer to a gate insulating layer having a surface energy of 50 to 75 $mNm^{-1}$, so as to obtain an organic semiconductor film.

FIG. 1A

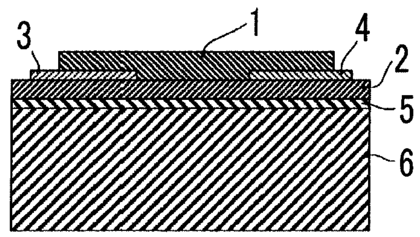


FIG. 1B

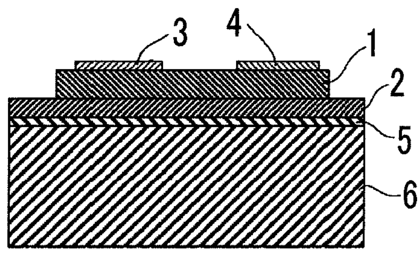


FIG. 1C

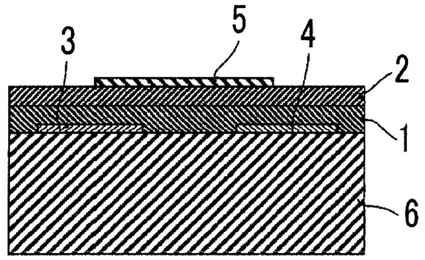


FIG. 1D

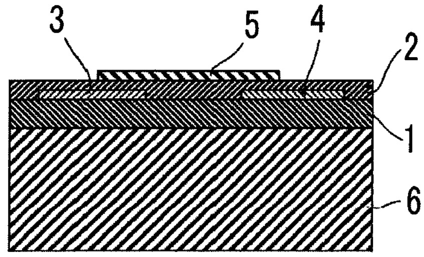

FIG. 2E

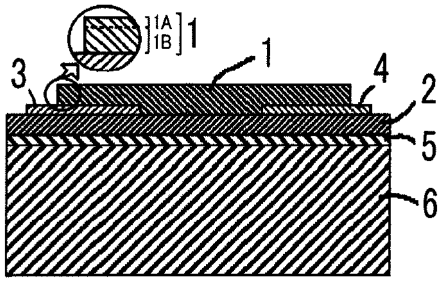


FIG. 2F

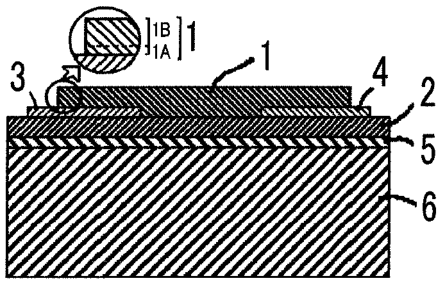

**INTERNATIONAL SEARCH REPORT**

International application No. PCT/JP2016/075700

A. CLASSIFICATION OF SUBJECT MATTER
*H01L51/30*(2006.01)i, *H01L21/336*(2006.01)i, *H01L29/786*(2006.01)i, *H01L51/05*(2006.01)i, *H01L51/40*(2006.01)i

According to International Patent Classification (IPC) or to both national classification and IPC

B. FIELDS SEARCHED

Minimum documentation searched (classification system followed by classification symbols)
H01L51/30, H01L21/336, H01L29/786, H01L51/05, H01L51/40

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2015-50231 A (Fujifilm Corp.), 16 March 2015 (16.03.2015), & WO 2015/029910 A1 | 1-22 |
| A | JP 2015-13989 A (Mitsubishi Chemical Corp.), 22 January 2015 (22.01.2015), (Family: none) | 1-22 |
| A | JP 2015-108072 A (Osaka University), 11 June 2015 (11.06.2015), (Family: none) | 1-22 |
| P,A | WO 2015/133376 A1 (Fujifilm Corp.), 11 September 2015 (11.09.2015), & JP 2015-167163 A & TW 201535816 A | 1-22 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 October 2016 (05.10.16) | 18 October 2016 (18.10.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014237733 A
- JP 2012036078 A
- JP 2009067999 A
- JP 2013214649 A
- JP 2011186069 A
- JP 2010285518 A
- JP 2012163946 A
- JP 2005354012 A
- JP 2006303465 A
- JP 2010527327 A
- JP 2007516315 A
- JP 2014515043 A
- JP 2014507488 A
- JP 2011501451 A
- JP 2010018790 A
- WO 2012174561 A
- JP 2011514399 A
- JP 2011514913 A


### Non-patent literature cited in the description


- *Int. J. Thermophys,* 2008, vol. 29, 568-585
- *Tetrahedron,* 2010, vol. 66, 3173
- *Organic Electronics,* 2011, vol. 12, 993